(19) Europäisches Patentamt
European Patent Office
Office européen des brevets

(11) **EP 4 518 620 A1**

(12) **EUROPEAN PATENT APPLICATION**
published in accordance with Art. 153(4) EPC

(43) Date of publication:
**05.03.2025 Bulletin 2025/10**

(21) Application number: 23796400.2

(22) Date of filing: **25.04.2023**

(51) International Patent Classification (IPC):
$H10K\ 30/60^{(2023.01)}$    $G06F\ 3/041^{(2006.01)}$
$G06F\ 3/042^{(2006.01)}$    $H01L\ 27/146^{(2006.01)}$
$H10K\ 30/30^{(2023.01)}$    $H10K\ 30/83^{(2023.01)}$
$H10K\ 39/30^{(2023.01)}$

(52) Cooperative Patent Classification (CPC):
G06F 3/041; G06F 3/042; H10F 39/12; H10K 30/30;
H10K 30/60; H10K 30/83; H10K 39/30;
Y02E 10/549

(86) International application number:
**PCT/JP2023/016350**

(87) International publication number:
**WO 2023/210660 (02.11.2023 Gazette 2023/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 25.04.2022 JP 2022071303

(71) Applicant: **Asahi Kasei Kabushiki Kaisha
Tokyo 1000006 (JP)**

(72) Inventors:
• **KAMIJO, Takeshi
Tokyo 100-0006 (JP)**
• **VAN BREEMEN, Albert
5656 AE Eindhoven (NL)**
• **PEETERS, Bart
5656 AE Eindhoven (NL)**
• **AKKERMAN, Hylke
5656 AE Eindhoven (NL)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

(54) **PHOTODETECTOR ELEMENT USING METAL GRID TRANSPARENT ELECTRODE AND TOUCHLESS USER INTERFACE DEVICE USING SAME**

(57)    To provide a photodetector element that can improve light detectivity while maintaining high transparence, and a touchless user interface device using the same.

A photodetector element according to the present disclosure is a photodetector element including: a metal grid transparent electrode for a first electrode; a transparent electrode for a second transparent electrode facing the metal grid transparent electrode; a subpixel between the metal grid transparent electrode and the transparent electrode, the subpixel consisting of at least one photoactive layer, in which: the metal grid transparent electrode includes a transparent substrate and a conductive pattern having at least one metal wire provided on the transparent substrate; the subpixel includes a sub-sensor area at least in part of the subpixel; and when projected from an upper surface, a region provided with the sub-sensor area overlaps a region provided with the metal wire at least in part.

EP 4 518 620 A1

**Fig. 1**

## Description

Technical Field

The present invention relates to a photodetector element using a metal grid transparent electrode that can achieve both high visible light transmittance and high external quantum efficiency, particularly in a near-infrared wavelength region, and a touchless user interface device using the same.

Background Art

Touch user interfaces detecting touches, such as touch panels, are widely put into practical use, such as smartphones, smart watches, laptop computers, ATMs, kiosks, and e-book terminals using e-paper. Touch user interfaces each include a transparent touch panel provided on a display body such as a display.

In recent years, from the viewpoint of further expansion of user experience, improvement of public hygiene awareness, and measures against static electricity, etc., touchless user interfaces have been attracting attention as an alternative to touch user interfaces, and active research and development is underway. As an example of realizing a touchless user interface, it has been proposed that, for example, input operation on the screen is performed by: using light from a light source such as a laser pointer or reflected light from pointing device such as a finger, as an optical input signal; and detecting the position of the optical input signal with a transparent sensor panel or sensor sheet that has a photodetector array formed of photodetectors arrayed one-dimensionally or two-dimensionally and installed on a display body such as a display.

Non Patent Literature 1 discloses an organic photodetector array in which organic photodetector elements are implemented for each unit pixel, which organic photodetector elements each formed of non-transparent organic photoactive layers that enable detecting light having a wavelength region of 500 nm to 600 nm and are patterned by photolithography into islands each having a size of 10 $\mu$m $\times$ 10 $\mu$m. The organic photoactive layers patterned into minute islands allow increase in the area rate of aperture sections with high visible light transmittance. This enables achieving both a high transmittance of 70% in the visible light region and detection of visible light.

Citation List

Non Patent Literature

Non Patent Literature 1: H. Akkerman et al., Integration of large area optical imagers for biometric recognition and touch in displays, J. Soc. Inf. Display., May 2021, P. 1-13
Non Patent Literature 2: Peter van de Weijer et al., High-performance thin-film encapsulation for organic light-emitting diodes, Org. Electron., May 2017, Vol. 44, P. 94-98
Non Patent Literature 3: P. E. Malinowski et al., Organic photo-lithography for displays with integrated fingerprint scanner, J. Soc. Inf. Display., 50(1), 1007-1010 (2019). https://doi.org/10.1002/sdtp.13097

Summary of Invention

Technical Problem

However, the effective sensor area of the organic photodetector element disclosed in Non Patent Literature 1 is as small as 100 $\mu$m$^2$. Therefore, the detection current I is also very small. Therefore, it is difficult to use a photodetector array formed of organic photodetector elements, as disclosed in Non Patent Literature 1, for a touchless user interface, from the viewpoint of the S/N ratio in an actual usage environment. In addition, the organic photodetector element disclosed in Non Patent Literature 1 uses a non-transparent metal solid film for the cathode. Therefore, if the effective sensor area is increased to improve the S/N ratio, the visible light transmittance is impaired.

Therefore, an object of the present invention is to provide a photodetector element that can improve light detectivity while maintaining high transparence, and a touchless user interface device using the same.

Solution to Problem

The following describes the present invention.

The present invention includes a photodetector element including: a metal grid transparent electrode for a first electrode; a transparent electrode for a second electrode, the transparent electrode facing the metal grid transparent electrode; and at least one subpixel between the metal grid transparent electrode and the transparent electrode, the subpixel consisting of a photoactive layer, wherein the metal grid transparent electrode includes a transparent substrate and a conductive pattern having at least one metal wire provided on the transparent substrate, the subpixel includes a sub-sensor area at least in part of the subpixel, and when projected from an upper surface, a region provided with the sub-sensor area overlaps a region provided with the metal wire at least in part.

The present invention includes the photodetector element, wherein $S_{sub-sensor}/S_{TCE-unit}$ is 1 or more, where $S_{TCE-unit}$ is an area of a repeated unit of the conductive pattern and $S_{sub-sensor}$ is an area of the sub-sensor area.

The present invention includes the photodetector element, wherein when being projected from an upper surface of the photodetector element, at least part of the sub-sensor area overlaps two or more of the metal wires extending in the same direction, the direction being at least one direction.

The present invention includes the photodetector element, wherein an insulating layer having an aperture section is provided between the metal grid transparent electrode and the transparent electrode, the subpixel is arranged so as to cover the aperture section when projected onto a surface from an upper surface in a laminating direction, and the sub-sensor area corresponds to a region where the subpixel and the aperture section overlap when projected onto a surface from an upper surface in a laminating direction.

The present invention includes the photodetector element, wherein when projected from an upper surface, shapes of regions provided with subpixels include at least one or more shapes selected from a group consisting of a square, a rectangle, a substantially square, and a substantially rectangle.

The present invention includes the photodetector element, the photodetector element further including a subpixel array, the subpixel array consisting of the subpixels provided apart from each other.

The present invention includes the photodetector element, wherein the subpixel array has a pattern in which the subpixels are two-dimensionally arrayed at equal intervals along two orthogonal coordinate axes on a parallel plane to the subpixel array.

The present invention includes the photodetector element, wherein $S_{subOPD}$ is 25 $\mu m^2$ or more and 10000 $\mu m^2$ or less, where $S_{subOPD}$ is an area of the subpixel.

The present invention includes the photodetector element, having: an external quantum efficiency of 15% or more in at least some wavelengths in a near-infrared wavelength region of 780 nm to 1200 nm; and a visible light transmittance of 50% or less in a laminating direction of the photodetector element in a region including the sub-sensor area.

The present invention includes the photodetector element, wherein $t_{TCE}$ is 30 nm or more and 200 nm or less, and ($t_{OPD} - t_{TCE}$) is 50 nm or more and 500 nm or less, where $t_{TCE}$ is a thickness of the metal wire and $t_{OPD}$ is a film thickness of the sub-sensor area.

The present invention includes the photodetector element, wherein $W_{TCE}$ is 0.25 $\mu m$ or more and 5.0 $\mu m$ or less, $G_{TCE}$ is 45 $\mu m$ or less, and ($G_{TCE}/W_{TCE}$) is 1.0 or more, where $W_{TCE}$ is a line width of each metal wire of the metal grid transparent electrode, and $G_{TCE}$ is a gap between adjacent metal wires extending in the same direction.

The present invention includes the photodetector element, wherein ($G_{TCE} \cdot A_{TCE}$) is 0.25 $\mu m \cdot$% or more and 45 $\mu m \cdot$% or less, where $A_{TCE}$ is an aperture rate of the conductive pattern.

The present invention includes the photodetector element, wherein an aperture rate $A_{TCE}$ of the conductive pattern is 25% or more and less than 100%.

The present invention includes the photodetector element, wherein the photoactive layer is an organic photoactive layer configured to be capable of photoelectric conversion.

The present invention includes the photodetector element, wherein the organic photoactive layer includes a bulk heterojunction structure at least having an organic donor material having an $E_g^{opt}$ of 1.65 eV or less and an organic acceptor material having an $E_g^{opt}$ of 1.65 eV or less, where $E_g^{opt}$ is an optical band gap.

The present invention includes the photodetector element, wherein the organic acceptor material is at least one selected from a group of non-fullerene acceptor materials consisting of IEICO-4F, IEICO-4Cl, IEICO, DTPC-DFIC, DCI-2, COTIC-4F, PDTTIC-4F, DTPC-IC, 6TIC-4F, COi8DFIC, FOIC, F8IC, F10IC, SiOTIC-4F, and P3.

The present invention includes the photodetector element, wherein the organic donor material is at least one selected from a group consisting of PTB7-Th (alias: PCE-10), PDTP-DFBT, PDPP3T, PDPP3T-O14, PDPP3T-O16, PDPP3T-O20, PDPP3T-C20, PDPP4T, DPPTfQxT, DPPTQxT, DPPBTQxBT, DPPBTffQxBT, FLP030 (product name), PBDTT-SeDPP, PBDTT-DPP, PBDTT-FDPP, PDPP2T-TT (PTT-DTDPP), PCDTBT, PCPDTBT, PCPDTFBT, and Si-PCPDTBT.

The present invention includes the photodetector element, wherein the metal wire includes a metal and an oxide of the metal.

The present invention includes the photodetector element, wherein the conductive pattern includes a mesh pattern.

The present invention includes a photodetector array including two or more arrayed pixels each consisting of the photodetector element.

The present invention includes the photodetector array, further including a wiring section having a second conductive pattern that is provided on the transparent substrate and is electrically connected to the conductive pattern, the wiring section being provided for each pixel, wherein $-10\% \leq (A_{wire} - A_{TCE}) \leq 10\%$, where $A_{wire}$ is an aperture rate of the second conductive pattern.

The present invention includes the photodetector array, further including a current collecting section having a third conductive pattern that is provided on the transparent substrate and is electrically connected to the second conductive pattern, wherein $\Gamma_{pad}$ is 50% or more and less than 100%, where $\Gamma_{pad}$ is an occupation area rate of the third conductive pattern per unit area.

The present invention includes the photodetector array, further including a dummy pattern that is provided on the transparent substrate and is electrically insulated from the conductive pattern.

The present invention includes the photodetector array, wherein $-10\% \leq (A_{dummy} - A_{TCE}) \leq 10\%$, where $A_{dummy}$ is an aperture rate of the dummy pattern.

The present invention includes the photodetector array, further including: a dummy subpixel array including a plurality of dummy subpixels each consisting of an insulating layer and the photoactive layer, the insulating layer being provided on the metal grid transparent electrode, the photoactive layer being provided on the insulating layer; and a subpixel array including a plurality of the subpixels, wherein the dummy subpixel array and the subpixel array, projected from an upper surface, have the same pattern structure.

The present invention includes the photodetector array, wherein a pixel size of the photodetector array is 1 mm$^2$ or more and 25 mm$^2$ or less.

The present invention includes the photodetector array, wherein a pixel density of the photodetector array is 2 ppi or more and 15 ppi or less.

The present invention includes the photodetector array, further including a pattern in which the pixels are two-dimensionally arrayed at equal intervals along two orthogonal coordinate axes on a parallel plane to the photodetector array.

The present invention includes a touchless user interface device, including the photodetector array for being arranged on a screen of a display or a display body, the device using the photodetector elements of the photodetector array to convert an optical input signal radiated to the photodetector array into an electrical output signal, thereby performing position detection, the position detection detecting a position irradiated with the optical input signal, the device being configured to enable input operation to a screen of the display or the display body based on the position detection.

The present invention includes the touchless user interface device, wherein the optical input signal includes light having at least some wavelengths in a near-infrared wavelength region of 780 nm to 1200 nm.

The present invention includes the touchless user interface device, wherein the optical input signal is frequency-modulated, and the modulated frequency is 0.5 kHz or more and 20 kHz or less.

The present invention includes the touchless user interface device, wherein the optical input signal is an optical signal emitted from a laser pointer.

The present invention includes the touchless user interface device, wherein the optical input signal is a reflected light from pointing device.

The present invention includes the touchless user interface device, wherein the optical input signal is a reflected light from the pointing device, the reflected light being generated by the pointing device coming into contact with a planar projection light beam formed in a space.

Advantageous Effects of Invention

According to the present invention, it is possible to provide a photodetector element having high transparence and high light detectivity, and a touchless user interface device using the same.

Brief Description of Drawings

[Figure 1] Figure 1 shows a cross-sectional view and a projection view projected from above of an organic photodetector element according to one embodiment.
[Figure 2] Figure 2 is an enlarged plan view of a metal grid transparent electrode according to one embodiment.
[Figure 3] Figure 3 is a modification of a sub-sensor area according to one embodiment.
[Figure 4] Figure 4 is a graph of $G_{TCE}$-external quantum efficiency (EQE, $\lambda$: 850 nm, $I_P$: 1.05 mW/cm$^2$, V: -2V) at different line widths.
[Figure 5] Figure 5 is a graph of ($G_{TCE}/W_{TCE}$)-EQE ($\lambda$: 850 nm, $I_P$: 1.05 mW/cm$^2$, V: -2V) at different line widths.

[Figure 6] Figure 6 is a graph of ($G_{TCE}$/$A_{TCE}$)-EQE ($\lambda$: 850 nm, $I_P$: 1.05 mW/cm$^2$, V: -2V) at different line widths.

[Figure 7] Figure 7 is a schematic diagram of an organic photodetector array and a partially enlarged view of a region AR1 according to one embodiment.

[Figure 8] Figure 8 is a cross-sectional view and a projection view from above of a dummy pattern section of an organic photodetector array according to one embodiment.

[Figure 9] Figure 9 is a schematic diagram of a touchless user interface device according to one embodiment.

[Figure 10] Figure 10 is a functional block diagram of a touchless user interface device according to one embodiment.

[Figure 11] Figure 11 is a graph comparing a light transmission spectrum of Example A1 and that of an optical model.

[Figure 12] Figure 12 is a graph comparing a light transmission spectrum of Comparative Example A1 and that of an optical model.

[Figure 13] Figure 13 is an optical microscope image of an organic photodetector element of Example B1.

[Figure 14] Figure 14 is a graph of dark current density ($J_{dark}$)-voltage (V) characteristics and photocurrent density ($J_{photo}$) -V characteristics of Example B1.

[Figure 15] Figure 15 is a graph of wavelength ($\lambda$)-EQE (V: -2V) for Example B1.

[Figure 16] Figure 16 is a graph of light intensity ($I_P$)-$J_{photo}$ of Example B1.

[Figure 17] Figure 17 is a graph comparing a simulation and an actual measurement of EQE (V: -2V) of Example B1.

[Figure 18] Figure 18 is a histogram of dark current density and photocurrent density of an organic photodetector array of Example D.

[Figure 19] Figure 19 is a photograph when a map operation application on a display is operated using a demonstration device of a touchless user interface device of Example D.

[Figure 20] Figure 20 is a photograph of a button operation on the display using the demonstration device of the touchless user interface device of Example D.

[Figure 21] Figure 21 is a schematic plan view and cross-sectional view of an organic photodetector array according to one embodiment.

Description of Embodiments

Hereinafter, embodiments of the present invention (hereinafter referred to as "the present embodiment") will be described in detail, but the present invention is not limited thereto, and various modifications can be made without departing from the gist thereof. The upper limit and lower limit in each numerical value range of the present embodiment can be freely combined to form any numerical range. Note that, in the drawings, the same elements are denoted by the same reference numerals and characters, and duplicate description will be omitted. In addition, the positional relationships such as up, down, left, and right are based on the positional relationships shown in the drawings unless otherwise specified. Furthermore, the dimensional ratios in the drawings are not limited to the illustrated ratios.

[1. Organic photodetector element]

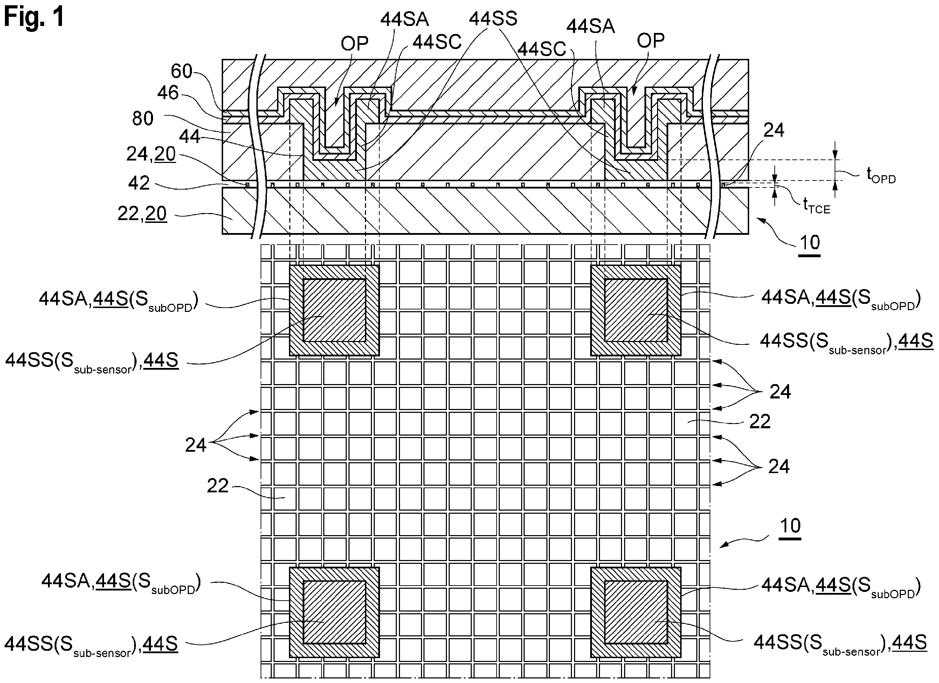

Figure 1 shows a cross-sectional view (Figure 1(A)) of an organic photodetector element (hereinafter sometimes referred to as an "organic PD element" or "OPD element") 10 according to the present embodiment, and a projection view of the OPD element 10 projected from an upper surface (Figure 1(B)). In Figure 1(A), incident light traveling upward from lower side of the paper plane passes through a metal grid transparent electrode 20 and generates electrons and holes in organic photoactive layers 44. As a result, a photovoltaic power is generated and a current flows between the metal grid transparent electrode 20 and a transparent electrode 60, so that the OPD element 10 is configured to be able to detect incident light.

As shown in the figure, the OPD element 10 includes: a metal grid transparent electrode 20 that functions as a cathode (an example of a "first electrode"); and a transparent electrode 60 that is provided facing the metal grid transparent electrode 20 and functions as an anode (an example of a "second electrode"). With such a configuration, visible light transmittance is not impaired even when the element area (so-called pixel size) of the OPD element 10 is increased. Furthermore, the OPD element 10 includes an electron transport layer 42 provided between the metal grid transparent electrode 20 and the transparent electrode 60, a hole transport layer 46, organic photoactive layers 44, and an insulating layer 80. The electron transport layer 42 is provided on the metal grid transparent electrode 20, the organic photoactive layers 44 and the insulating layer 80 are provided on the electron transport layer 42, and the hole transport layer 46 is provided on the organic photoactive layers 44 and the insulating layer 80. In other words, the insulating layer 80 is provided between the electron transport layer 42 and the hole transport layer 46, and separates the subpixels 44S, forming organic photoactive layers 44, from each other.

The metal grid transparent electrode 20 is an electrode for transmitting incident light and detecting a photocurrent generated in the organic photoactive layers 44 based on the transmitted incident light. The metal grid transparent electrode 20 according to the present embodiment has an electrode section consisting of a transparent substrate 22 and a conductive pattern 24P formed of metal wires 24 provided on the transparent substrate 22. The metal wires 24 may include a metal component responsible for conductivity and an oxide of the metal component. An example of the configuration of the metal grid transparent electrode 20 is detailed in the section [1.2 Metal grid transparent electrode 20: Metal grid TCE].

Note that, in the present description, each metal wire 24 provided on the transparent substrate 22 includes: not only a configuration consisting of the metal wire 24 that is provided on the transparent substrate 22 and is in contact with the surface of the transparent substrate 22; but also a configuration consisting of the metal wire 24 that is provided on the transparent substrate 22 and is in non-contact with the surface of the transparent substrate 22, with another layer provided between transparent substrate 22 and metal wire 24. For example, a transparent conductive inorganic compound layer may be provided between the transparent substrate 22 and the metal wire 24. Similarly, a configuration is included in which a certain object has another object provided thereon or formed thereon and the certain object is in non-contact with the other object.

Each organic photoactive layer 44 generates a photocurrent based on incident light. The organic photoactive layer 44 according to the present embodiment can be provided between the electron transport layer 42, which is provided on the metal grid transparent electrode 20 so as to cover the metal grid transparent electrode 20, and the hole transport layer 46.

Examples of configurations of the electron transport layer 42, the organic photoactive layer 44, and the hole transport layer 46 are respectively detailed in sections [1.3 Electron transport layer 42 (ETL)], [1.4 Organic photoactive layer 44], and [1.5 Hole transport layer 46 (HTL)].

The transparent electrode 60 is an electrode for detecting photocurrent generated in the organic photoactive layers 44 based on incident light. The transparent electrode 60 according to the present embodiment is provided on the organic photoactive layers 44 or the hole transport layer 46. An example of the configuration of the transparent electrode 60 is detailed in a section [1.6 Transparent electrode 60 (Anode)].

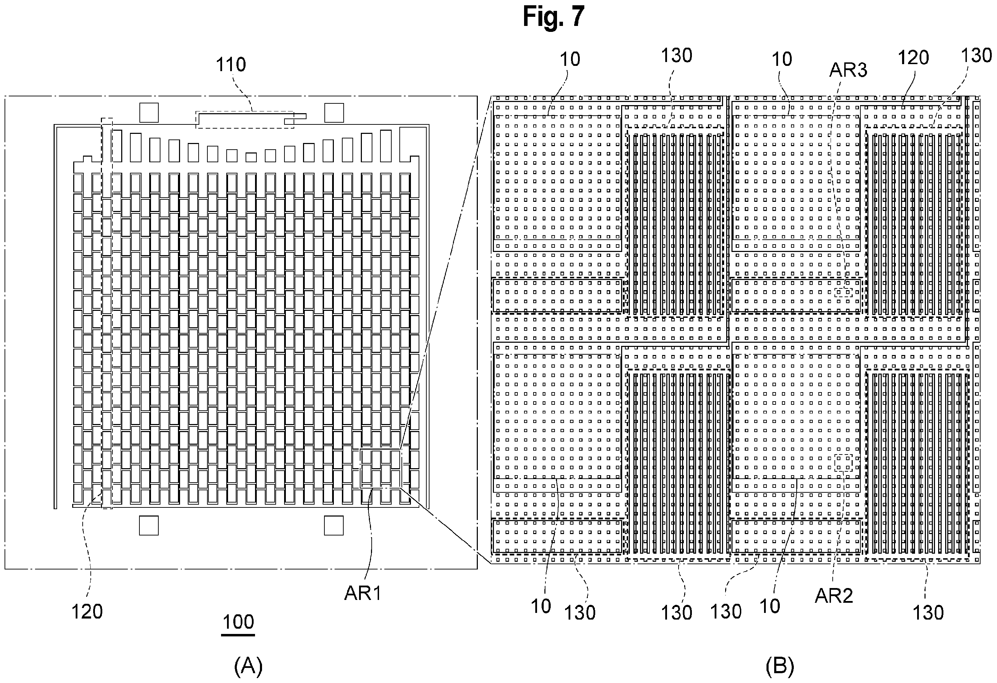

The organic photoactive layers 44 of the OPD element 10 (single pixel) according to the present embodiment are provided apart from each other in island geometry. In the present description, each of the plurality of organic photoactive layers 44 provided apart from each other is sometimes referred to as a subpixel 44S. Therefore, the OPD element 10 (pixel) of the present embodiment includes a plurality of subpixels 44S. The OPD element 10 includes, for example, a total of 196 subpixels 44S arrayed two-dimensionally, 14 in the vertical direction and 14 in the horizontal direction (Figure 7). The projection view of Figure 1(B) shows four subpixels 44S among them. As shown in the figure, in a plan view, each subpixel 44S is provided: apart from the adjacent subpixel(s) 44S in the up-down direction in the paper plane by the dimension of the subpixel 44S or more in the same direction; and apart from the adjacent subpixel(s) 44S in the left-right direction in the paper plane by the dimension of the subpixel 44S or more in the same direction. Each subpixel 44S is configured to be able to generate a photocurrent based on incident light. Therefore, the OPD element 10 is configured to cause one or more subpixels 44S in the OPD element 10 to generate a photocurrent based on the incident light, thereby being able to detect the incidence of light.

As shown in Figures 1(A) and 1(B), each subpixel 44S, which is the organic photoactive layer 44, has: a sub-sensor area 44SS provided on the electron transport layer 42 in contact with or in close proximity to the electron transport layer 42; an alignment area 44SA that surrounds the sub-sensor area 44SS in a projection view and is provided above the electron transport layer 42 apart from the electron transport layer 42 with an insulating layer 80 therebetween in a side view (cross-sectional view); and a connecting section 44SC that extends substantially perpendicularly to the surface of the transparent substrate 22 to connect the sub-sensor area 44SS and the alignment area 44SA. As shown in the figure, the subpixel 44S is formed, for example, in a substantially polygonal shape (for example, square or rectangular shape) in a projection view, and is formed into a substantially U-shape in a side view (cross-sectional view), in which the alignment area 44SA corresponding to both ends is spaced from the electron transport layer 42, and the sub-sensor area 44SS corresponding to the center connecting both the ends is in contact with or in close proximity to the electron transport layer 42. In the present description, the area of a single sub-sensor area 44SS in a projection view is sometimes referred to as $S_{sub-sensor}$.

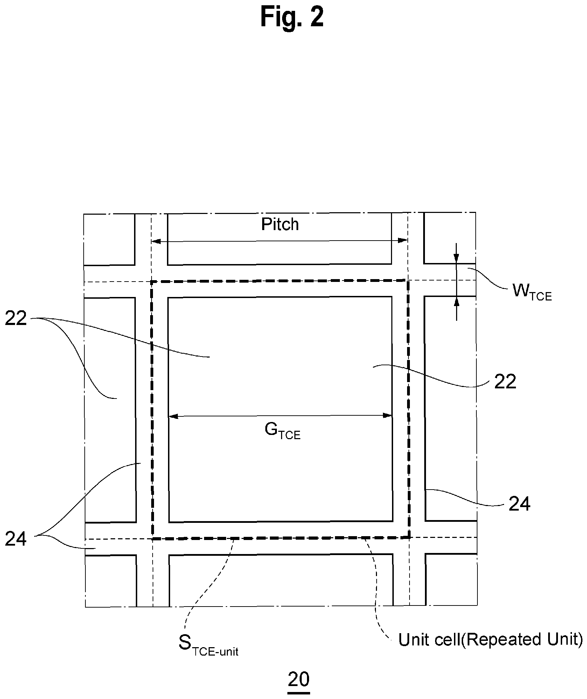

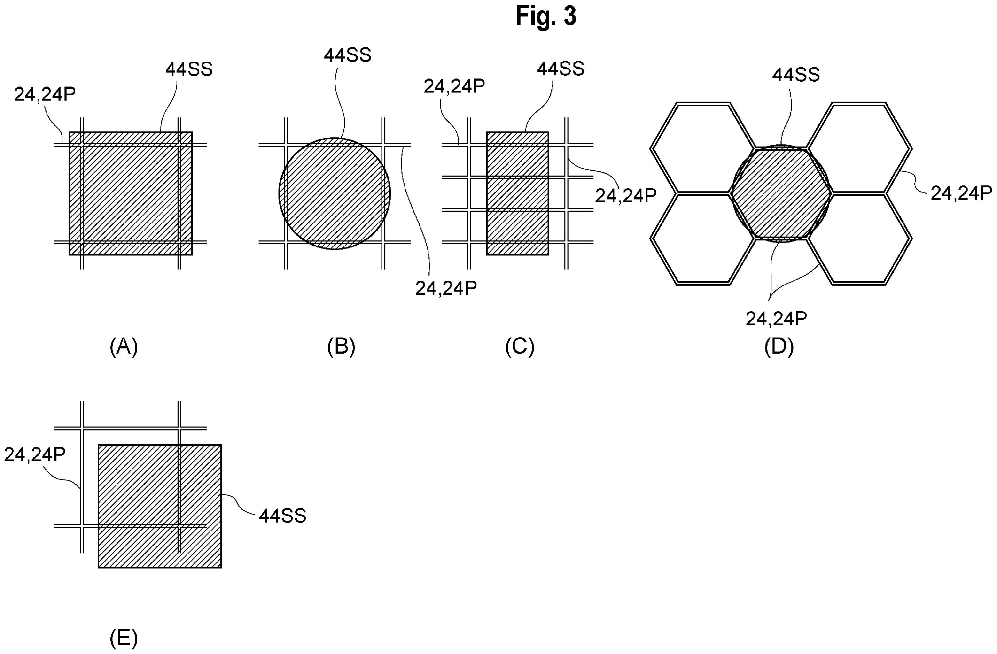

Figure 2 is an enlarged plan view of the metal grid transparent electrode 20. The metal grid transparent electrode 20 according to the present embodiment includes a mesh pattern (an example of a "conductive pattern 24P" shown in Figure 3(A)) that is formed by a plurality of metal wires 24 each extending linearly and intersecting each other at right angles in the mesh pattern. When the conductive pattern 24P formed by a plurality of metal wires 24 is formed from periodic shapes, the area of a repeated unit (unit cell) in a projection view ("a unit cell area") is sometimes referred to as an $S_{TCE-unit}$ in the present description. The mesh pattern of the metal grid transparent electrode 20 according to the present embodiment is formed of rectangular shapes arrayed repeatedly and periodically. Therefore, the area of a rectangular or rectangular-like figure surrounded by the center lines (broken lines in Figure 2) of the metal wires 24 in a plan view corresponds to the unit cell area $S_{TCE-unit}$.

As shown in Figure 1B, the organic photoactive layers 44 and the metal wires 24 of the OPD element 10 according to the present embodiment are provided so that, in a projection view projected from an upper surface, a region provided with a sub-sensor area 44SS overlaps a region provided with a metal wire 24, at least in part. In other words, in the projection view projected from an upper surface, at least one metal wire 24 is provided: so as to pass through a sub-sensor area 44SS of the organic photoactive layer 44; and preferably, so as to pass through the sub-sensor area 44SS while intersecting two different sides of the sub-sensor area 44SS of the organic photoactive layer 44.

Such a structure allows implementing a configuration in which electrons generated in each organic photoactive layer 44 are easily transported to the nearby metal wire 24 via the electron transport layer 42. This can improve external quantum efficiency (light detectivity) compared to a configuration in which the organic photoactive layers 44 is provided only in aperture sections of the conductive pattern 24P in the projection view.

Furthermore, at least one sub-sensor area 44SS (organic photoactive layer 44) is provided within the OPD element 10 (pixel). Such a configuration makes it possible to increase the area rate of a region with relatively high visible light transmittance (region excluding the subpixel 44S or sub-sensor area 44SS). This allows improving the visible light transmittance of the organic photodetector element and the organic photodetector array.

Here, as shown in the present embodiment, a plurality of (for example, preferably ten or more, and more preferably 50 or more) subpixels 44S (organic photoactive layers 44) may be provided apart from each other in the OPD element 10. Such a configuration allows improving the detectivity of incident light.

For example, the OPD element 10 may be provided with: a first subpixel 44S in which at least one metal wire 24 passes through a sub-sensor area 44SS (organic photoactive layer 44); and a second subpixel 44S that is provided apart from the first subpixel 44S, and has the sub-sensor area 44SS (organic photoactive layer 44) through which at least one metal wire 24 passes. Here, the metal wire 24 passing through the first subpixel 44S may be the same one as the metal wire 24 passing through the second subpixel 44S.

As described above, the OPD element of the present embodiment includes the organic photoactive layers 44. However, the photodetector according to the present invention may include, for example, an inorganic photoactive layer. In other words, the photoactive layer to be used can be an organic photoactive layer or an inorganic photoactive layer consisting of a quantum dot or an inorganic semiconductor, and can be suitably an organic photoactive layer. Similarly, the electron transport layer 42 and the hole transport layer 46 may be made of an organic material or an inorganic material.

Furthermore, in the projection view of the OPD element 10 (Figure 1(B)), $S_{sub-sensor}$ corresponding to the area of a sub-sensor area 44SS and $S_{TCE-unit}$ corresponding to the unit cell area of the conductive pattern 24P are preferably $S_{sub-sensor}/S_{TCE-unit} \geq 1$. $S_{sub-sensor}/S_{TCE-unit}$ is preferably 3 or more, more preferably 4 or more, and still more preferably 5 or more. In the embodiment shown in Figure 1(B), $S_{sub-sensor}/S_{TCE-unit}$ is 5 or more ($S_{sub-sensor}/S_{TCE-unit} \geq 5$).

Since $S_{sub-sensor}/S_{TCE-unit}$ is 1 or more, in the projection view, a sub-sensor area 44SS can be provided on at least one or more metal wires 24 of the metal wires 24 that extend in the same direction, in at least one direction, within the conductive pattern 24P and face each other in the direction substantially perpendicular to the extending direction. This relationship holds true even when the relative positions of the conductive pattern 24P and the sub-sensor area 44SS change in a lamination process. Therefore, $S_{sub-sensor}/S_{TCE-unit}$ being 1 or more causes electrons, which are generated in an organic photoactive layer 44 provided on the aperture section of the conductive pattern 24P, to be more likely to be transported to the nearest metal wire 24 via the electron transport layer 42. This makes the charges more likely to be collected, thereby improving external quantum efficiency. As $S_{sub-sensor}/S_{TCE-unit}$ increases, the number of metal wires 24 that overlap a sub-sensor area 44SS tends to increase. This improves a charge collection efficiency $\eta_{cc}$, causing the external quantum efficiency to tend to improve. The upper limit value of $S_{sub-sensor}/S_{TCE-unit}$ is not particularly limited and can be, for example, 100. The upper limit value of $S_{sub-sensor}/S_{TCE-unit}$ can be more preferably 85 or less, still more preferably 65 or less, even more preferably 50 or less, and particularly preferably 40 or less. As the $S_{sub-sensor}/S_{TCE-unit}$ decreases, each subpixel 44S can be made smaller, which is preferable since it is possible to decrease the visibility of the organic photodetector element.

In addition, it is preferable to increase the $S_{sub-sensor}/S_{TCE-unit}$ so that part of a sub-sensor area 44SS overlaps at least two or more metal wires 24 extending in the same direction in the projection view. For example, as shown in Figure 1(B), a sub-sensor area 44SS may overlap two metal wires 24 that extend together in the up-down direction on the paper plane, and may overlap three metal wires 24 that extend together in the left-right direction on the paper plane.

This configuration allows a sub-sensor area 44SS to overlap at least one metal wire 24 even if the sub-sensor area 44SS is manufactured to be shifted in the direction perpendicular to the extending direction of the metal wires 24. This enables charges to be collected suitably.

As described above, the organic photodetector element of the present embodiment uses the metal grid transparent electrode 20 as the cathode, the transparent electrode 60 as the anode, and has at least the organic photoactive layer 44 provided between the cathode and the anode.

Regarding the configuration of the organic photoactive layer 44, anode, cathode, etc., conventionally known materials and configurations can be applied that are commonly used in organic photodetector elements.

For example, each of the following configurations can be applied to the present invention as an element configuration of an organic photodetector element.

(A) Cathode/organic photoactive layer 44/anode

(B) Cathode/electron transport layer 42/organic photoactive layer 44/anode
(C) Cathode/organic photoactive layer 44/hole transport layer 46/anode
(D) Cathode/electron transport layer 42/organic photoactive layer 44/hole transport layer 46/anode

Note that the symbol "/" shown in (A) to (D) above indicates that the layers sandwiching the symbol "/" are laminated adjacently. This also applies to the following description. The organic photodetector element may have a configuration having two or more organic photoactive layers 44.

In addition, the organic photodetector element of the present embodiment may be a standard stack (forward type element) in which light enters from the anode, or may be an inverse stack (reverse type element) in which light enters from the cathode. Furthermore, the metal grid transparent electrode 20 or another metal grid transparent electrode may be used for the anode, and the transparent electrode 60 or another transparent electrode may be used for the cathode.

Since the organic photodetector element of the present embodiment has the cathode and anode that are transparent electrodes, the optical input signal may enter from the anode side or from the cathode side. The organic photodetector element is preferably an inverse stack type in which light is incident from the side of the cathode, which is a metal grid transparent electrode.

The lower limit value of the external quantum efficiency of the OPD element 10 in at least some wavelengths in a near-infrared wavelength region of 780 nm to 1200 nm is preferably 15% or more, more preferably 20% or more, still more preferably 25% or more, and particularly preferably 30% or more. The upper limit value of the external quantum efficiency is not particularly limited, and may be, for example, preferably 100% or less, more preferably 90% or less, and still more preferably 80% or less.

Since the lower limit value of external quantum efficiency is 15% or more in at least some wavelengths in the near-infrared wavelength region of 780 nm to 1200 nm, the OPD element 10 can exhibit good light detectivity in the near-infrared wavelength region.

Here, there is a trade-off relationship between the external quantum efficiency and the visible light transmittance of the organic photodetector element in the subpixel portion. Therefore, setting the external quantum efficiency to the above-described upper limit value or less increases the visible light transmittance of the organic photodetector element in the subpixel portion, and allows the visibility of the subpixel portion to tend to decrease.

Near-infrared light is invisible to the human eye, so even if it is radiated onto a display body such as a display as an optical input signal, it does not impede the visibility of the display body (the visibility of images, etc. displayed on the display body). In addition, in using reflected light from pointing device such as a finger as an optical input signal of a touchless user interface, a person is irradiated with light from a light source. Even in this case, since near-infrared light is invisible to the human eye, a person can view images, etc. displayed on the display body without minding reflected light from the pointing device.

Furthermore, of the near-infrared wavelength regions, the wavelength region of 780 nm to 1200 nm has a high reflectance from human skin, as disclosed in M. J. Mendenhall, A. S. Nunez, and R. K. Martin, "Human skin detection in the visible and near infrared," Appl. Opt. 54(35), 10559-10570 (2015). This reflectance is particularly high in the wavelength region of 780 nm to 950 nm, and there are many commercial LEDs that can be used as light sources for optical input signals. Therefore, when near-infrared light reflected from pointing device including a finger is used as an optical input signal for a touchless user interface, it is preferable that the organic photodetector element be able to detect light having at least some wavelengths in the near-infrared wavelength region of 780 nm to 1200 nm with high efficiency.

The visible light transmittance in the laminating direction of the organic photodetector element in the region including a sub-sensor area 44SS corresponds to, in Figure 1(A), the visible light transmittance of the subpixel 44S that travels upward from the lower side of the paper plane and passes through the metal grid transparent electrode 20, the sub-sensor area 44SS of the organic photoactive layer 44, and the transparent electrode 60. The visible light transmittance in the laminating direction thereof is preferably 50% or less, more preferably 40% or less, still more preferably 35% or less, even more preferably 30% or less, even more preferably 25% or less, and particularly preferably 20% or less.

The lower limit value of the visible light transmittance is not particularly limited, and can be, for example, preferably more than 0%, more preferably 5% or more, and still more preferably 10% or more. In order to obtain high external quantum efficiency for at least part of the near-infrared wavelength region of 780 nm to 1200 nm, it is preferable for the organic photodetector element of the present embodiment to select organic photoactive layers 44 each having a high extinction coefficient k (absorption coefficient $\alpha$) in the wavelength region, and/or increase the film thickness $t_{OPD}$ of each organic photoactive layer 44. On the other hand, such an organic photoactive layer 44 has a high light absorption rate even in the long wavelength region of visible light (550 nm or more).

Therefore, setting the visible light transmittance to 50% or less allows obtaining high external quantum efficiency in the above-described near-infrared wavelength region. In addition, setting the visible light transmittance to a lower limit value or more allows the visibility of each subpixel 44S to tend to decrease.

The dark current density $J_{dark}$ of the organic photodetector element of the present embodiment at an applied voltage of -2 V is preferably $10^{-4}$ mA/cm$^2$ or less, more preferably $10^{-5}$ mA/cm$^2$ or less, and particularly preferably $5 \times 10^{-6}$

mA/cm$^2$ or less. The dark current density being the upper limit value or less allows the organic photodetector element to tend to obtain high detectivity.

[1.1 Insulating layer 80: ECL, Edge Cover Layer]

The organic photodetector element of the present embodiment includes an insulating layer 80 (Figure 1(A)) provided between the metal grid transparent electrode 20 and the transparent electrode 60. In the present embodiment, the insulating layer 80 is laminated on the electron transport layer 42 formed on the metal grid transparent electrode 20 so as to cover the metal grid transparent electrode 20. The insulating layer 80 has a plurality of aperture sections OP (portions of the insulating layer 80 each provided with an aperture) provided apart from each other. The electron transport layer 42 is exposed upward through the aperture sections OP.

In a projection view projected onto a surface from an upper surface in the laminating direction, each subpixel 44S is arranged so as to cover the aperture section OP. A portion of the subpixel 44S coinciding with the aperture section OP corresponds to the sub-sensor area 44SS, and a portion thereof surrounding the aperture section OP corresponds to the alignment area 44SA. The alignment area 44SA is provided on the insulating layer 80 in the cross-sectional view (Figure 1(A)). Providing the insulating layer 80 allows preventing short circuits between the cathode and the anode in the area other than the subpixels 44S.

For the insulating layer 80, conventionally known materials and configurations can be used that are commonly used in organic photodetector elements and semiconductor devices. The insulating layer 80 to be used is not particularly limited, and the examples can include: layers of inorganic compounds such as silicon oxides ($SiO_{X\,(0\,<\,X\,\leq\,2)}$, silicon nitrides ($SiN_{X\,(0\,<\,X\,\leq\,4/3)}$), silicon oxynitrides ($SiO_XN_Y$), aluminum oxides ($AlO_{X\,(0\,<\,X\,\leq\,3/2)}$), and aluminum nitrides (AlN); and layers of the following resins: thermosetting resins such as phenolic resins, thermosetting epoxy resins, thermosetting polyimides, melamine resins, urea resins, unsaturated polyester resins, alkyd resins, polyurethanes, diallyl phthalate resins, and silicone resins; UV curable resins such as urethane acrylates, acrylic resin acrylates, epoxy acrylates, silicone acrylates, and UV curable epoxy resins; and commercially available coating agent resins. The insulating layer 80 may be one made of one type of material or may be one made of two or more types materials that are laminated.

A method of forming the insulating layer 80 having the aperture section OP includes: first forming a solid film of the material to be the insulating layer 80 throughout the surface of the element through dry film forming or wet film forming; and then, using a known patterning method such as photolithography, nanoimprint, lift-off, or laser ablation to form the aperture sections OP in the insulating layer 80. Also, a known printing method such as gravure printing, gravure offset printing, relief printing, flexographic printing, inkjet printing, or screen printing allows patterning printing to form the insulating layer 80 (especially any of the above-mentioned resin layers) having the aperture sections OP. As necessary, the formed insulating layer 80 can be cured by ultraviolet rays or heat. Furthermore, the insulating layer 80 can be fixed by baking.

Examples of dry film forming methods for a solid film of an inorganic compound layer to be used as the insulating layer 80 include vapor phase deposition methods such as PVD (physical vapor deposition) and CVD (chemical vapor deposition). For the purpose of forming a film of a dense inorganic compound layer with few pinholes, the film of the inorganic compound layer is preferably formed by a sputtering method, PECVD, or ALD (atomic layer deposition). The film thickness of the inorganic compound layer is preferably 10 nm or more and 2000 nm or less, more preferably 30 nm or more and 1000 nm or less, and still more preferably 50 nm or more and 500 nm or less. The film thickness of the inorganic compound layer being 10 nm or more causes the insulating properties to be excellent. The film thickness of the inorganic compound layer being 2000 nm or less causes the visible light transparency to be excellent. In addition, this allows preventing occurrence of cracks due to bending, and also preventing increase in internal stress in film formation, thereby preventing generation of defects.

Also, a wet film forming method for a solid film of the resin layer to be used as the insulating layer 80 can be a known coating method such as slot die coating or spin coating, or casting method. The film thickness of the resin layer is preferably 100 nm or more and 5000 nm or less, more preferably 500 nm or more and 2500 nm or less, and still more preferably 800 nm or more and 2000 nm or less. The film thickness of the resin layer being 100 nm or more causes the insulating properties to be excellent. The film thickness of the resin layer being 5000 nm or less causes the visible light transparency to be excellent.

The insulating layer 80 having the aperture sections OP is particularly preferably formed by: forming of a solid film of photocurable epoxy resin SU-8 (product name) throughout the surface of the element; soft-bake; patterning exposure; and development.

In the present embodiment, the shapes of a sub-sensor area 44SS and a subpixel 44S are rectangular or square in a projection view of the OPD element 10 viewed from above. However, the shapes of the sub-sensor area 44SS and the subpixel 44S are not particularly limited, and may be circular, square, rectangular, polygonal, substantially circular, substantially square, substantially rectangular, substantially polygonal, etc. in the projection view.

Figures 3(A), 3(B), 3(C), and 3(D) show square, circular, rectangular, and circular sub-sensor areas 44SS, respectively. For example, there may be a configuration such that: a circular aperture is provided in the insulating layer 80;

and a circular sub-sensor area 44SS is formed and a square subpixel 44S is formed that includes the circular sub-sensor area 44SS in the projection view. Furthermore, when there are a plurality of subpixels 44S, each subpixel 44S has different shapes. The shapes of the subpixels 44S is preferably at least one selected from the group consisting of a square, a rectangle, a substantially square, and a substantially rectangle. However, a substantially square shape means a shape that includes four sides with an equal length, each of which is perpendicular to the adjacent sides. For example, the substantially square shape includes a shape that has four sides with an equal length, each of which is perpendicular to the adjacent sides, and corners each being formed into an arc to connect the two adjacent sides. A substantially rectangular shape means a shape that includes four sides that are perpendicular to the adjacent sides. For example, the substantially rectangular shape includes a shape that has four sides that are perpendicular to the adjacent sides, and corners each being formed into an arc to connect the two adjacent sides.

[Subpixel 44S]

Here, when $S_{subOPD}$ is the area of a single subpixel 44S, $S_{subOPD}$ is preferably 25 $\mu m^2$ or more and 10000 $\mu m^2$ or less, more preferably 100 $\mu m^2$ or more and 6400 $\mu m^2$ or less, still more preferably 225 $\mu m^2$ or more and 4900 $\mu m^2$ or less, even more preferably 400 $\mu m^2$ or more and 3600 $\mu m^2$ or less, and particularly preferably 1600 or more and 3000 $\mu m^2$ or less.

It is preferable that the $S_{subOPD}$ be 25 $\mu m^2$ or more because the photodetection current is large. It is preferable that the $S_{subOPD}$ be 10000 $\mu m^2$ or less because the visibility of a subpixel 44S with low visible light transmittance to the human eye can be decreased.

Furthermore, it is preferable that the area of the single subpixel 44S be at least one tenth or less of the area of the pixel of the OPD element 10.

As described above, the OPD element 10 of the present embodiment includes a plurality of subpixels 44S that are spaced apart from each other and formed into islands. As shown in Figure 1(B), each subpixel 44S is provided on the electron transport layer 42 integrally formed so as to have the same electrical potential, and is provided under the hole transport layer 46 integrally formed so as to have the same electrical potential. Therefore, the plurality of subpixels 44S forming the pixel are electrically joined or connected. In other words, one pixel is formed of the plurality of subpixels 44S that are electrically joined or connected.

Here, the plurality of subpixels 44S may be arrayed one-dimensionally in the OPD element 10, or may be arranged two-dimensionally as shown in the present embodiment. Furthermore, the plurality of subpixels 44S may be arrayed randomly, may form any regular array pattern, or may be a combination of a plurality of these.

The OPD element 10 of the present embodiment has a subpixel array formed of a pattern in which the plurality of subpixels 44S are arrayed that are provided apart from each other. More preferably, as shown in Figure 1(B), the OPD element 10 has a pattern structure in which the plurality of subpixels 44S are two-dimensionally arrayed at equal intervals along two orthogonal coordinate axes on a parallel plane to the subpixel array.

The following describes significance of forming a single pixel by electrically joining or connecting a plurality of subpixels 44S provided apart from each other.

In general, the current I($\lambda$) detected from an organic photodetector element is expressed by the following expression.

[Expression 1]

$$I(\lambda) = EQE(\lambda) \cdot I_P(\lambda) \cdot S \cdot \frac{\lambda q}{hc}$$

In the expression, EQE($\lambda$) (%) is the external quantum efficiency of the organic photodetector element, IP($\lambda$) (mW/cm$^2$) is the light intensity radiated to the organic photodetector element, S (cm$^2$) is the effective sensor area of the organic photodetector element per unit pixel, $\lambda$ is the wavelength of the radiated light, q is the elementary charge, h is Planck's constant, and c is the speed of light. In other words, the detection current I is proportional to the effective sensor area S within a unit pixel.

On the other hand, the effective sensor area of an organic photodetector element disclosed in Non Patent Literature 1 is as small as 100 $\mu m^2$. Therefore, the detection current I is also very small.

In addition, disturbances such as natural light, indoor light, and light emitted from a display body such as a display contain a lot of visible light, and these visible lights become noise.

Furthermore, when an optical input signal propagates through space, the light intensity attenuates by 1/d$^2$ with respect to the propagation distance d.

For the above reasons, it is difficult to use a photodetector array formed of organic photodetector elements disclosed in Non Patent Literature 1 for a touchless user interface from the viewpoint of the S/N ratio in an actual usage environment.

Then, the inventors of the present application has focused on the following point: when used for a touchless user interface, the photodetector array is not required to have high resolution (for example, 164 ppi (pixel per inch)) like a photodetector array of Non Patent Literature 1; and it is sufficient that, for example, the pixel pitch be set to 4 mm to 6 mm (approximately 4 to 7 ppi) in each of the two-dimensional directions (for example, orthogonal X-axis and Y-axis directions).

Furthermore, the inventors of the present application have conceived a configuration in which a photoactive layer of a subpixel smaller than the pixel size is provided within a single pixel by patterning or the like. A photodetector element with such a configuration has a single pixel that internally includes subpixels in island geometry, each consisting of an organic or inorganic photoactive layer with relatively low visible light transmittance. This allows increasing the area of the aperture section with relatively high visible light transmittance (so-called the region where the photoactive layer is not formed). This can improve the visible light transmittance of the photodetector element as a whole.

The number of subpixels provided within a single pixel may be one or more. For example, a plurality of subpixels each consisting of an organic photoactive layer are provided apart from each other within a single pixel, thereby making it possible to increase the area rate of the aperture section with relatively high visible light transmittance. This allows improving the visible light transmittance of the organic photodetector element and the organic photodetector array.

Here, a pixel corresponds to a unit of spatial resolution of a photodetector array. Since one or more photoactive layers are provided within a single pixel, each photoactive layer is provided at a subpixel smaller than one pixel. As described above, each photoactive layer may be formed by patterning, for example.

In addition, the inventors of the present application have conceived a configuration of a sub-sensor area within the subpixel in which, when projected from an upper surface, a region provided with a sub-sensor area overlaps a region provided with a metal wire of the metal grid transparent electrode, at least in part. Here, the sub-sensor area refers to a region that functions as a sensor, and more specifically refers to a region of a portion in close proximity to and facing an electrode, in each of the photoactive layers formed into islands.

With this configuration, electrons generated in the photoactive layer on the aperture section of the metal grid transparent electrode can be transported to the nearby metal wire via the electron transport layer, and the charges can be collected. This allows improving external quantum efficiency (light detectivity) in a photodetector element using a metal grid transparent electrode.

Furthermore, the area of the sub-sensor area within the subpixel may be designed to be equal to or larger than the area of the unit cell of the conductive pattern of the metal grid transparent electrode. Here, the area of the sub-sensor area refers to the area of the sub-sensor area in a top view (plan view).

With this configuration, even if the relative positions of the metal grid transparent electrode and the subpixel consisting of the photoactive layer change in manufacturing (lamination process), at least part of the sub-sensor area is provided so as to overlap the metal wire. This makes it possible to more reliably improve external quantum efficiency (light detectivity) in a photodetector element using a metal grid transparent electrode for the reasons described above.

In order to improve the S/N ratio, the present inventors have devised, for example, an OPD element 10 that has a pixel size of 4 mm × 4 mm or less, and has a plurality of minute organic photoactive layers 44 as subpixels 44S arrayed in island geometry within the pixel. This configuration allows increasing the rate of the area other than the subpixels 44S with low visible light transmittance. This allows increasing the total effective sensor area within the pixel while enjoying an improvement in the visible light transmittance of the pixel as a whole. For achieving the same total effective sensor area in the same pixel size, it is more preferable to array a large number of subpixels 44S with a small area than to array a small number of subpixels 44S with a large area, because visibility of the subpixels 44S can be decreased.

In the expression, $\Gamma_{subOPD}$ is defined as an area occupation rate of the subpixel 44S within a repeated pattern unit of the subpixel array. For example, if a subpixel array with an area of Y is provided for each area of X, the area occupation rate corresponds to "$100 \times (Y/X)$ (%)". In this definition, $\Gamma_{subOPD}$ is preferably 3% or more and 25% or less, more preferably 4% or more and 20% or less, still more preferably 5% or more and 15% or less, even more preferably 5.5% or more and 12% or less, and particularly preferably 6% or more and 10% or less. It is preferable that $\Gamma_{subOPD}$ be 3% or more because the total effective sensor area of the subpixel array can be large. It is preferable that $\Gamma_{subOPD}$ be 25% or less because the total occupation area of the subpixels 44S with low visible light transmittance is small resulting in improved visible light transmittance of the organic photodetector element as a whole.

[1.2 Metal grid transparent electrode 20: Metal grid TCE]

As shown in Figure 1(A), the metal grid transparent electrode 20 of the present embodiment has an electrode section consisting of a transparent substrate 22 and a conductive pattern 24P formed of metal wires 24 provided on the transparent substrate 22.

[1.2.1 Transparent substrate]

In the present embodiment, a transparent substrate 22 is used. Here, "transparent" means that the visible light transmittance is preferably 80% or more, more preferably 90% or more, and still more preferably 95% or more. Here, the visible light transmittance can be measured in accordance with JIS K 7361-1: 1997.

The transparent substrate 22 may be made of one type of material, or may be made of two or more types of materials laminated. In addition, when the transparent substrate 22 is a multilayer body in which two or more types of materials are laminated, the transparent substrate 22 may be one in which there are laminated transparent organic substrates only or transparent inorganic substrates only that are listed in the core layer described later. Also, the transparent substrate 22 may be one in which there is laminated a combination of transparent organic substrate and transparent inorganic substrate that are listed in the core layer described later. Also, the transparent substrate 22 can have a barrier layer, an intermediate layer, or the like appropriately provided on the core layer of a single layer or a multilayer body. Examples of the form of the transparent substrate 22 include core layer, core layer/barrier layer, core layer/barrier layer/intermediate layer, core layer/intermediate layer/barrier layer, and the like. It is also possible to have a barrier layer and intermediate layer in one layer.

The material for the core layer is not particularly limited, and examples thereof include: transparent inorganic substrates including glass such as quartz glass, and others; and transparent organic substrates including polyethylene terephthalate, polyethylene naphthalate, polyimide, and others. The thickness of the core layer is preferably 5 $\mu$m or more and 2 mm or less, and more preferably 10 $\mu$m or more and 1.5 mm or less.

The intermediate layer is not particularly limited, and examples thereof include silicon compounds (for example, (poly)siloxanes, silicon oxide, silicon nitride), aluminum compounds (for example, aluminum oxide), and magnesium compounds (for example, magnesium fluoride). The film thickness of the intermediate layer is preferably 0.01 $\mu$m or more and 100 $\mu$m or less, more preferably 0.01 $\mu$m or more and 10 $\mu$m or less, and still more preferably 0.01 $\mu$m or more and 1 $\mu$m or less. The film thickness of the intermediate layer being within the above range causes the adhesion to tend to further improve, while causing the metal grid transparent electrode 20 to tend to have a further improved transparence and durability.

The barrier layer is a layer that has high shielding performance against moisture and oxygen, and contributes to preventing deterioration of properties of the organic photodetector element due to moisture and oxygen entering the interior of the organic photodetector element. As for the gas barrier properties of the barrier layer, the water vapor permeability (25 $\pm$0.5°C, relative humidity (90 $\pm$2)%) measured by a method in accordance with JIS K 7129-1992 is preferably in the range of $1 \times 10^{-7}$ g/(m$^2$·24hr) to $1 \times 10^{-3}$ g/(m$^2$·24hr), more preferably in the range of $1 \times 10^{-7}$ g/(m$^2$·24hr) to $1 \times 10^{-4}$ g/(m$^2$·24hr), and still more preferably in the range of $1 \times 10^{-7}$ g/(m$^2$·24hr) to $1 \times 10^{-5}$ g/(m$^2$·24hr). The water vapor permeability being within this range can prevent deterioration of properties such as decrease in EQE and increase in dark current of the organic photodetector element under long-term use. Furthermore, the oxygen permeability measured by a method in accordance with JIS K 7126-1987 is preferably $1 \times 10^{-6}$ mL/m$^2$·24h·atm to $1 \times 10^{-2}$ mL/m$^2$·24h·atm, more preferably $1 \times 10^{-6}$ mL/m$^2$·24h·atm to $1 \times 10^{-3}$ mL/m$^2$·24h·atm, and still more preferably $1 \times 10^{-6}$ mL/m$^2$·24h·atm to $1 \times 10^{-4}$ mL/m$^2$·24h·atm.

For the barrier layer, conventionally known compositions, structures, and formation methods can be applied that are commonly used for organic photodetector elements. The barrier layer may be one layer or may have a laminated structure of two or more layers. The laminated structure may be one in which only inorganic compound layers, only organic compound layers, or only inorganic polymer layers are laminated, or may be one in which an inorganic compound layer, an organic compound layer, and an inorganic polymer layer are laminated in combination. Among these, in order to improve the brittleness of the barrier layer, a structure is preferably one in which inorganic compound layers and organic compound layers are alternately laminated a plurality of times.

The inorganic compound layer of the barrier layer to be used is not particularly limited, and the examples can include, silicon oxides (SiO$_{X \, (0 < X \leq 2)}$), silicon nitrides (SiN$_{X \, (0 < X \leq 4/3)}$), silicon oxynitrides (SiO$_X$N$_Y$), aluminum oxides (AlO$_{X \, (0 < X \leq 3/2)}$), and aluminum nitrides (AlN). The film thickness of the inorganic compound layer is preferably 30 nm or more and 1000 nm or less, more preferably 50 nm or more and 500 nm or less, and still more preferably 100 nm or more and 200 nm or less. The film thickness of the inorganic compound layer being 30 nm or more causes the gas barrier properties to be excellent. The film thickness of the inorganic compound layer being 1000 nm or less causes the visible light transparency to be excellent.

The organic compound layer of the barrier layer to be used is not particularly limited, and the examples can include: thermosetting resins such as phenolic resins; UV curable resins such as urethane acrylates, acrylic resin acrylates, epoxy acrylates, and silicone acrylates; and commercially available coating agents. The organic compound layer can also have a structure in which particles serving as a hygroscopic compound are dispersed within the layer. Examples of the hygroscopic compound include metal oxides (for example, calcium oxides), sulfates, metal halides, and perchlorates. The film thickness of the organic compound layer is preferably 0.5 $\mu$m or more and 100 $\mu$m or less, more preferably 5 $\mu$m or more and 50 $\mu$m or less, and still more preferably 10 $\mu$m or more and 30 $\mu$m or less. The film thickness of the organic compound layer being 0.5 $\mu$m or more causes the gas barrier properties to be excellent. The film thickness of the organic compound layer being 100 $\mu$m or less causes the visible light transparency to be excellent.

The inorganic polymer layer of the barrier layer to be used is not particularly limited, and the examples can include silicon-containing polymers such as polysilazanes, polysiloxanes, and polysiloxazanes. The film thickness of the inorganic polymer layer is preferably 10 nm or more and 10 $\mu$m or less, more preferably 30 nm or more and 8 $\mu$m or less, and still more preferably 50 nm or more and 5 $\mu$m or less. The film thickness of the inorganic polymer layer being 10 nm or more causes the gas barrier properties to be excellent. The film thickness of the inorganic polymer layer being 10 $\mu$m or less causes the visible light transparency to be excellent.

As the barrier layer, it is particularly preferable to apply the same material and configuration as those of a thin film encapsulation (TFE) disclosed in Non Patent Literature 2.

[1.2.2 Electrode section]

The electrode section is formed of a transparent electrode (hereinafter also referred to as a "metal grid transparent electrode" or "Metal grid TCE") including a conductive pattern 24P consisting of fine metal wires 24 on a transparent substrate 22. Metal grid transparent electrode achieves high flexibility and low sheet resistance due to the high ductility and high electrical conductivity of each metal wire. In addition, the electrode has an advantage in which it can be optionally changed in properties such as visible light transmittance and sheet resistance by adjusting the line width and film thickness of the metal wire, the gap of the conductive pattern, etc. In addition, although the metal wire itself is opaque, adjustment of the line width of the metal wire to 3 $\mu$m or less enables the metal wire to be invisible to the human eye. This also allows further improving the transparence (transmittance) of the metal grid transparent electrode itself.

The "metal grid" electrode includes an electrode in which: a plurality of metal wires 24 are provided, part of which extend in a direction and the rest of which extend in a different direction; and thereby a plurality of regions are provided, each of which has apexes at the points where the metal wires 24 intersect and is surrounded by the metal wires 24. Here, each metal wire 24 may extend linearly or may be curved. The areas surrounded by the metal wires 24 are each called an aperture, and the portion where the aperture is provided is sometimes called an aperture section. As described later, the plurality of metal wires 24 may be arrayed periodically at a predetermined pitch, or may be arranged irregularly, that is, arrayed randomly in all or part of the region.

(Conductive pattern 24P)

The conductive pattern 24P may be a regular pattern or an irregular pattern. The examples thereof include: a mesh pattern formed in such a way that a plurality of metal wires 24, each linearly extending, intersect in a mesh shape; a honeycomb pattern in which metal wires 24 are provided each in a portion corresponding to a side of a hexagon so that hexagonal apertures are provided without gaps; and a line pattern in which a plurality of substantially parallel metal wires 24 are formed. Also, the conductive pattern 24P may be any combination of a mesh pattern, a honeycomb pattern, and a line pattern. Furthermore, the conductive pattern 24P may be provided such that apertures having polygonal shapes other than rectangular and hexagonal shape are formed without gaps. For example, when the metal wires 24 defining polygonal apertures simultaneously defines adjacent polygonal apertures, a plurality of polygonal apertures are formed without gaps. Note that the conductive pattern 24P may be configured to have apertures in different polygonal shapes. The mesh of the mesh pattern may be square or rectangular, or diamond-shaped. The honeycomb pattern may be provided in a regular hexagonal shape with a constant line width, but for example, or may be provided in a hexagonal shape such that the line width of the part corresponding to each apex is larger and the apexes of each aperture section is rounded, for example. In addition, the metal wires 24 forming the line pattern may be straight or curved. Furthermore, also in the metal wires 24 forming a mesh pattern or a honeycomb pattern, part or all of the metal wires 24 can be curved.

Figure 3(A) shows an embodiment in which a mesh pattern having a square aperture is provided as the conductive pattern 24P, a square sub-sensor area 44SS is provided as the sub-sensor area 44SS, and $S_{sub-sensor}$ corresponding to the area of the sub-sensor area 44SS and $S_{TCE-unit}$ corresponding to the unit cell area of the conductive pattern 24P have a relationship of $S_{sub-sensor}/S_{TCE-unit} \geq 1$. As shown in the figure, since $S_{sub-sensor} > S_{TCE-unit}$, at least two metal wires 24 extending in a predetermined direction (first direction) in the projection view pass through the sub-sensor area 44SS, and at least two metal wires 24 extending in a direction perpendicular to the predetermined direction (second direction) pass through the same sub-sensor area 44SS. Therefore, as shown in Figure 3(E), even if the relative positions of the conductive pattern 24P and a sub-sensor area 44SS change in the lamination process, the sub-sensor area 44SS is allowed to still overlap the metal wires 24 in the projection view. Therefore, the electrons generated in the organic photoactive layer 44 are likely to be transported to the nearest metal wire 24 via the electron transport layer 42 and the charges are likely to be collected, making it possible to improve the external quantum efficiency.

Figure 3(B) shows an embodiment in which a mesh pattern having a square aperture is provided as the conductive pattern 24P, a circular sub-sensor area 44SS is provided as the sub-sensor area 44SS, and there is a relationship of $S_{sub\text{-}sensor}/S_{TCE\text{-}unit} \geq 1$ (for example, in the same figure, $S_{sub\text{-}sensor}/S_{TCE\text{-}unit} = 1$). Similarly to Figure 3(A), even if the relative positions of the conductive pattern 24P and a sub-sensor area 44SS change in the lamination process, the sub-sensor area 44SS is allowed to still overlap the metal wires 24 in the projection view. This allows improving the external quantum efficiency.

Figure 3(C) shows an embodiment in which a mesh pattern having a rectangular apertures is provided as the conductive pattern 24P, a rectangular sub-sensor area 44SS is provided as the sub-sensor area 44SS, and there is a relationship of $S_{sub\text{-}sensor}/S_{TCE\text{-}unit} \geq 1$. Figure 3(D) shows an embodiment in which a honeycomb pattern having hexagonal apertures is provided as the conductive pattern 24P, a circular sub-sensor area 44SS is provided as the sub-sensor area 44SS, and there is a relationship of $S_{sub\text{-}sensor}/S_{TCE\text{-}unit} \geq 1$. It is possible to exhibit similar technical effects also in these embodiments.

(Line width)

The line width $W_{TCE}$ of a metal wire 24 means the line width $W_{TCE}$ (Figure 2) when the metal wire 24 is projected onto the surface of the transparent substrate 22 from the side on which the conductive pattern 24P of the transparent substrate 22 is placed. In the metal wire 24 having a trapezoidal cross section with a long base on the interface side with the transparent substrate 22, the line width $W_{TCE}$ is the width of the surface of the metal wire 24 in contact with the transparent substrate 22.

$W_{TCE}$ is preferably 0.25 $\mu$m or more and 5.0 $\mu$m or less, more preferably 0.25 $\mu$m or more and 4.0 $\mu$m or less, still more preferably 0.25 $\mu$m or more and 3.0 $\mu$m or less, even more preferably 0.25 $\mu$m or more and 2.0 $\mu$m or less, and particularly preferably 0.25 $\mu$m or more and 1.0 $\mu$m or less. The $W_{TCE}$ being 0.25 $\mu$m or more allows the resistance of the metal grid transparent electrode 20 to be lower, and reducing the voltage drop caused by the detection current allows the organic photodetector element to tend to have a larger area. In addition, it is possible to sufficiently prevent increase in electrical resistance due to oxidation, corrosion, etc. on the surface of the metal wire 24. In contrast, the line width $W_{TCE}$ of the metal wire 24 being 5.0 $\mu$m or less allows the gap $G_{TCE}$ of the conductive pattern 24P to be reduced while maintaining a high aperture rate. As a result, the unit cell area of the conductive pattern 24P can be reduced, and accordingly, the area of a sub-sensor area 44SS can be designed to be small. This allows the organic photodetector element to tend to have a further improved visible light transmittance as a whole, and tend to have an improved appearance at the same time. Furthermore, adjusting the line width $W_{TCE}$ of the metal wire 24 to 3.0 $\mu$m or less allows the opaque metal wire 24 to be invisible to the human eye. As a result, placing the organic photodetector element even on a display body such as a display does not impair the appearance and design of the display body.

(Gap)

In the present description, the gap $G_{TCE}$ (Figure 2) of the conductive pattern 24P refers to the shortest (minimum) distance of the distances (intervals) between adjacent metal wires 24 extending in the same direction in the conductive pattern 24P and facing each other in the direction substantially perpendicular to the extending direction. However, when the metal wires 24 extends in a curved shape, the gap $G_{TCE}$ corresponds to the minimum distance between two adjacent metal wires 24 that respectively have the straight lines approximating the curves thereof and extend nearly in the same direction at least within a predetermined region.

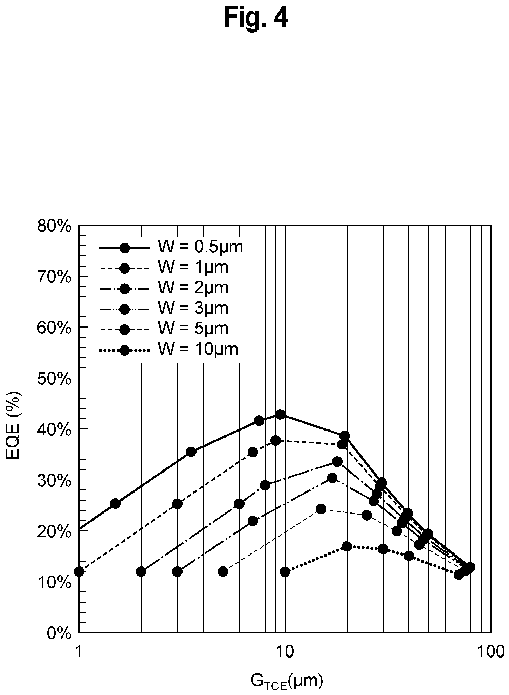

Figure 4 is a graph showing simulation results for different line widths $W_{TCE}$, with the horizontal axis representing the gap $G_{TCE}$ of the conductive pattern 24P and the vertical axis representing the external quantum efficiency (EQE) obtained in the simulation. As shown in the figure, the upper limit value of $G_{TCE}$ is preferably 45 $\mu$m or less, more preferably 40 $\mu$m or less, still more preferably 35 $\mu$m or less, even more preferably 30 $\mu$m or less, and particularly preferably 25 $\mu$m or less.

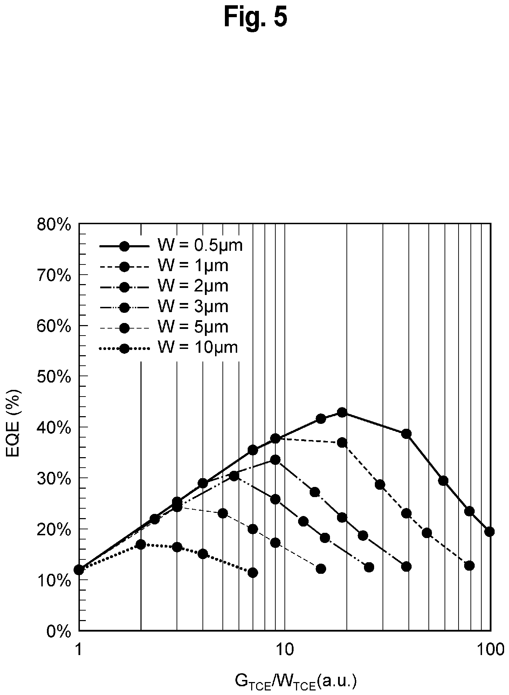

In addition, Figure 5 is a graph showing simulation results for different line widths $W_{TCE}$, with the horizontal axis representing the relative value of the gap to the line width ($G_{TCE}/W_{TCE}$) and the vertical axis representing the external quantum efficiency (EQE) obtained in the simulation.

As shown in the figure, the lower limit value of ($G_{TCE}/W_{TCE}$) is preferably 1.0 or more, more preferably 1.5 or more, still more preferably 2.0 or more, even more preferably 3.0 or more, even more preferably 5.0 or more, and particularly preferably 7.0 or more.

The ($G_{TCE}/W_{TCE}$) being 1.0 or more increases the aperture rate and prevents the shadowing effect caused by metal wires 24. Improving the efficiency of taking light into each organic photoactive layer 44 allows the organic photodetector element to tend to have an improved external quantum efficiency.

In contrast, the $G_{TCE}$ being 45 $\mu$m or less causes the aperture section of the conductive pattern 24P to tend to have a uniform surface potential distribution. This causes the organic photodetector element to tend to have a further improved external quantum efficiency as a whole. The inventors of the present application presume that the reason why reducing the gap causes the organic photodetector element to have an improved external quantum efficiency as a whole as follows. Electrons generated by photoexcitation within an organic photoactive layer 44 provided on the aperture sections of the conductive pattern 24P diffuse in plane in the electron transport layer 42 with high sheet resistance, to be transported to the metal wire 24. Reducing the gap $G_{TCE}$ to shorten the diffusion distance of electrons from the center of the aperture to the metal wire 24 allows reducing the voltage drop caused by the surface resistance of the electron transport layer 42 involved by in-plane diffusion of electrons. This causes the aperture section of the conductive pattern 24P to tend to have a uniform surface potential distribution.

Charge collection efficiency $\eta_{cc}$, that is one of the elements of external quantum efficiency tends to improve with increase in the effective voltage applied to an organic photoactive layer 44 (difference between the surface potentials of the cathode and anode), as disclosed in J. Xue et al., A Hybrid Planar-Mixed Molecular Heterojunction Photovoltaic Cell, Advanced Materials., January 2005, Vol. 17, P. 66-71. Therefore, it is considered that the aperture section of the conductive pattern 24P has a uniform surface potential distribution for the above-described reason, causing the organic photodetector element to have a further improved external quantum efficiency as a whole.

(Aperture rate)

The aperture rate $A_{TCE}$ of the conductive pattern 24P is preferably 25% or more and less than 100%, more preferably 35% or more and 99% or less, still more preferably 47% or more and 98% or less, even more preferably 68% or more and 97% or less, and particularly preferably 71% or more and 95% or less. The aperture rate $A_{TCE}$ being 25% or more allows the organic photodetector element to have an improved external quantum efficiency for the reason described above. The aperture rate $A_{TCE}$ also allows the visible light transmittance to tend to improve. The aperture rate $A_{TCE}$ being less than 100% increases the occupation rate of the metal wires 24 per unit area and therefore causes the sheet resistance to reduce, allowing the organic photodetector element to tend to have a larger area.

Note that the "aperture rate" of the conductive pattern 24P can be calculated with the following expression for the region on the transparent substrate 22 where the conductive pattern 24P is formed.

Aperture rate = (1 - area occupied by conductive pattern 24P (metal wires 24)/area of transparent substrate 22 in region where conductive pattern 24P is formed) $\times$ 100

For example, if the conductive pattern 24P is a mesh pattern in which square apertures are formed as shown in Figure 3(A), and if the line width is 1 $\mu$m and the gap is 19 $\mu$m, the area occupied by the conductive pattern 24P per unit area (the area occupied by the metal wires 24) is approximately 10%, and the area of the aperture where the transparent substrate 22 is exposed is approximately 90%, so that the aperture rate is approximately 90%.

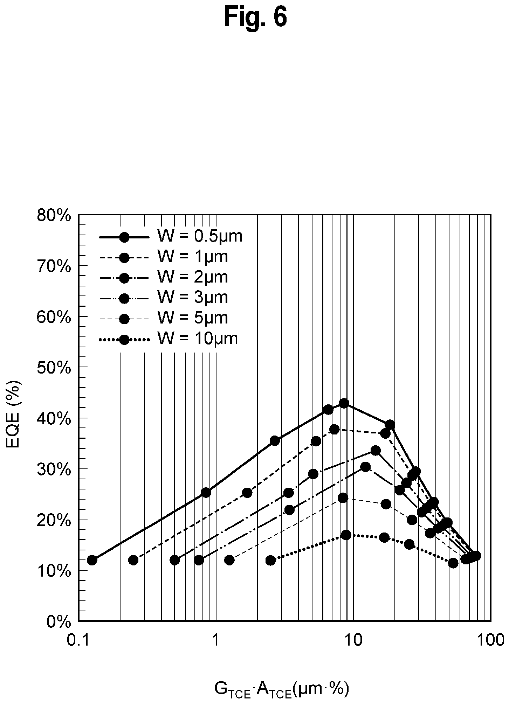

Figure 6 is a graph showing simulation results for different line widths $W_{TCE}$, with the horizontal axis representing the product of the gap $G_{TCE}$ and the aperture rate $A_{TCE}$ of the conductive pattern 24P, and the vertical axis representing the external quantum efficiency (EQE) obtained in the simulation. The ($G_{TCE} \cdot A_{TCE}$) is an index indicating that two of the following improve the external quantum efficiency of the organic photodetector element: uniformity of the surface potential distribution caused by reduction in the electron diffusion distance ($G_{TCE}$) in in-plane direction at each aperture section of the conductive pattern 24P; and increase in efficiency of taking light into each organic photoactive layer 44 caused by increase in aperture rate ($A_{TCE}$). For example, the gap being made smaller for the same line width reduces the electron diffusion distance and uniformizes the surface potential distribution of the aperture section, thereby improving the charge collection efficiency $\eta_{cc}$. On the other hand, as the aperture rate decreases, the shadowing effect of the opaque metal wires 24 increases, and the amount of light taken into an organic photoactive layer 44 decreases. Therefore, the inventors of the present application has focused on the following point: ($G_{TCE}/A_{TCE}$) being adjusted to a suitable range can improve the external quantum efficiency of the organic photodetector element including the metal grid transparent electrode 20. As shown in the figure, ($G_{TCE}/A_{TCE}$) is preferably 0.25 $\mu$m·% or more and 45 $\mu$m·% or less, more preferably 0.45 $\mu$m·% or more and 40 $\mu$m·% or less, still more preferably 1.0 $\mu$m·% or more and 35 $\mu$m·% or less, even more preferably 2.0 $\mu$m·% or more and 30 $\mu$m·% or less, even more preferably 4.0 $\mu$m·% or more and 25 $\mu$m·% or less, and particularly preferably 6.0 $\mu$m·% or more and 22 $\mu$m·% or less. ($G_{TCE}/A_{TCE}$) being 0.25 $\mu$m·% or more uniformizes the surface potential distribution in the aperture section while preventing decrease in the amount of light taken in due to the shadowing effect of the metal wires 24, and allows the organic photodetector element to have an improved external quantum efficiency. In contrast, ($G_{TCE}/A_{TCE}$) being 45 $\mu$m·% or less increases the aperture rate to allow the organic photodetector element to have an improved external quantum efficiency while preventing decrease in charge collection efficiency $\eta_{cc}$ involved by voltage drop in the aperture section. In the present description, $\mu$m·%, which is the unit of ($G_{TCE} \cdot A_{TCE}$), indicates the product of the gap $G_{TCE}$ ($\mu$m) multiplied by the value of the aperture rate $A_{TCE}$ expressed in percentage. For example, when the conductive pattern 24P has a gap $G_{TCE}$ of 20 $\mu$m and an aperture rate $A_{TCE}$ of 90%, ($G_{TCE} \cdot A_{TCE}$) is written as 20 $\mu$m $\times$ 0.9 = 18 $\mu$m·%.

In the present embodiment, the thickness $t_{TCE}$ of a metal wire 24 is preferably 30 nm or more and 200 nm or less, more preferably 50 nm or more and 170 nm or less, still more preferably 60 nm or more and 150 nm or less, and even more preferably 70 nm or more and 130 nm or less. The $t_{TCE}$ being 30 nm or more allows the metal grid transparent electrode 20 to have a lower resistance, and allows the organic photodetector element to tend to have a larger area. In addition, the $t_{TCE}$ allows a metal wire 24 to tend to sufficiently prevent its surface from increase in electrical resistance due to its oxidation, corrosion, etc. In contrast, the $t_{TCE}$ being 200 nm or less allows the convex metal wires 24 to be sufficiently covered to be prevented from an electrical short with the opposing electrode, within an appropriate adjustment range of the film thickness of each organic photoactive layer 44. In addition, there is a tendency in which high transparence is exhibited over a wide viewing angle.

The $t_{TCE}$ can be measured by observing the cross section of the metal grid transparent electrode 20 or the organic photodetector element using an electron microscope (SEM, TEM, STEM), or by observing the plane of the metal grid transparent electrode 20 using a confocal laser microscope or the like. Furthermore, the $t_{TCE}$ can also be checked by measuring the film thickness profile of the metal grid transparent electrode 20 using a stylus type thin film step meter.

The line width $W_{TCE}$ of a metal wire 24, and the gap $G_{TCE}$ and the aperture rate $A_{TCE}$ of the conductive pattern 24P can be checked by observing the surface or cross section of the metal grid transparent electrode 20 with an electron microscope, a laser microscope, an optical microscope, or the like. Methods of adjusting the line width $W_{TCE}$ of a metal wire 24 and the gap $G_{TCE}$ of the conductive pattern 24P to a desired range include a method of adjusting the grooves of a plate used in a manufacturing method of the metal grid transparent electrode 20, and a method of adjusting the average particle diameter of metal particles in ink, which will be described later.

Each metal wire 24 can include a metal component M and an oxide of the metal component M. The metal component M is responsible for the conductivity of the metal wire 24. The mechanism in which the metal component M exhibits conductivity is not particularly limited, but is presumed to be similar to the free electron model of metal. The metal component M is not particularly limited, and examples thereof include gold, silver, copper, and aluminum. Among these, copper is more preferable that is relatively inexpensive and has high conductivity. Using such a metal component M causes the conductivity of the metal grid transparent electrode 20 to tend to be further more excellent.

The oxide of the metal component M is not particularly limited, and it is preferable to select copper as the metal component M for the above-described reasons, so cuprous oxide, cupric oxide, copper hydroxide, etc. are preferable.

Furthermore, each metal wire 24 can include a non-conductive component in addition to the metal component M that is responsible for the conductivity. Examples of the non-conductive component include, but are not particularly limited to, oxides of the metal component M and organic compounds. More specifically, these non-conductive components are components derived from the components contained in the ink, which will be described later, and include, of the components contained in the ink, the oxides of the metal component M or organic compounds remaining on the metal wire 24 after firing.

The content rate of the metal component M in a metal wire 24 is preferably 50% by mass or more, more preferably 60% by mass or more, and still more preferably 70% by mass or more. The upper limit of the content rate of the metal component M is not particularly limited, but is less than 100% by mass. In addition, the content rate of the non-conductive component in a metal wire 24 is preferably 50% by mass or less, more preferably 40% by mass or less, and still more preferably 30% by mass or less. The lower limit of the content rate of the non-conductive component is not particularly limited, but is larger than 0% by mass.

(Sheet resistance)

The sheet resistance $R_{s\_TCE}$ of the conductive pattern 24P of the metal grid transparent electrode 20 is preferably 0.1 Q/sq. or more and 100 Q/sq. or less. The upper limit value of the sheet resistance $R_{s\_TCE}$ is more preferably 90Q/sq. or less, still more preferably 80Q/sq. or less, and even more preferably 70Ω/sq. or less, and particularly preferably 60Ω/sq. or less. Sheet resistance $R_{s\_TCE}$ being 100Ω/sq. or less can prevent the voltage drop due to the electrical resistance of the metal grid transparent electrode 20, allowing the organic photodetector element to tend to have a larger area. The sheet resistance $R_{s\_TCE}$ can be reduced by adjustment such as reducing the aperture rate $A_{TCE}$ of the conductive pattern 24P, increasing the film thickness $t_{TCE}$ of each metal wire 24, increasing the content rate of the metal component M in each metal wire 24, and selecting a metal component M with high electrical conductivity.

The sheet resistance $R_{s\_TCE}$ can be measured using a four-terminal method in accordance with JIS K 7194: 1994 for the portion where the conductive pattern 24P is placed. Examples of measuring instruments using the four-terminal method include "Loresta GP" (product name, manufactured by Mitsubishi Chemical Corporation). In addition, the sheet resistance $R_{s\_TCE}$ can be measured by a non-contact method using an eddy current in accordance with ASTM F 673-02 for the portion where the conductive pattern 24P is placed.

(Visible light transmittance)

The visible light transmittance ($VLT_{TCE}$) of the region where the conductive pattern 24P of the metal grid transparent electrode 20 is placed is preferably 23% or more and 98% or less, more preferably 32% or more and 96% or less, still more preferably 43% or more and 95% or less, even more preferably 55% or more and 94% or less, even more preferably 62% or more and 93% or less, and particularly preferably 69% or more and 92% or less. The visible light transmittance $VLT_{TCE}$ tends to be improved by increasing the aperture rate $A_{TCE}$ of the conductive pattern 24P. The visible light transmittance $VLT_{TCE}$ can be calculated from the transmission spectrum of the region where the conductive pattern 24P of the metal grid transparent electrode 20 is placed in accordance with JIS R 3106: 2019 or ISO9050: 2003. The visible light transmittance $VLT_{TCE}$ can also be calculated by multiplying the visible light transmittance of the transparent substrate 22 by the aperture rate of the conductive pattern 24P.

[1.2.3 Method of manufacturing metal grid transparent electrode 20]

Methods of manufacturing the metal grid transparent electrode 20 include a method having a pattern forming step of forming a pattern on a transparent substrate 22 using an ink containing a metal component M, and a firing step of firing the ink to form a conductive pattern 24P thereon.

[Pattern forming step]

The pattern forming step is a step of forming a pattern using ink containing a metal component M. The pattern forming step is not particularly limited as long as it is a plate printing method using a plate having grooves for the desired conductive pattern 24P, and has: for example, a step of coating a transfer medium surface with ink; a step of placing the ink-coated transfer medium surface to face the raised surface of the relief plate, applying pressure, and bringing them into contact with each other, to transfer the ink on the transfer medium surface to the raised surface of the relief plate; and a step of placing the transfer medium surface, on which the ink remains, to face the surface of the transparent substrate 22, applying pressure, and bring them into contact with each other, to transfer the ink remaining on the transfer medium surface to the surface of the transparent substrate 22.

The ink to be used in the pattern forming step includes a metal component M and a solvent, and may also include a surfactant, a dispersant, and a reducing agent as necessary. The metal component M may be contained in the ink as metal particles or as a metal complex.

The average primary particle diameter of the metal particles is preferably 100 nm or less, more preferably 50 nm or less, and still more preferably 30 nm or less. The lower limit of the average primary particle diameter of the metal particles is not particularly limited, and may be 1 nm or more. The average primary particle diameter of the metal particles being 100 nm or less allows the obtained metal wire 24 to have a narrower line width. Note that the "average primary particle diameter" refers to the particle diameter of each metal particle (so-called primary particle), and is distinguished from the average secondary particle diameter, which is the particle diameter of an aggregate (so-called secondary particle) formed by a plurality of metal particles gathering together.

Examples of metal particles include, but are not particularly limited to, a metal oxide or a metal compound containing a metal component M such as copper oxide as constituent atoms, and core/shell particles in which the core is a metal component M such as copper and the shell is a metal oxide containing the metal component M such as copper oxide as constituent atoms. The embodiment of the metal particles can be determined as appropriate from the viewpoint of dispersibility and sinterability.

The content of the metal particles in the ink based on the total mass of the ink composition is preferably 1% by mass or more and 40% by mass or less, more preferably 5% by mass or more and 35% by mass or less, and still more preferably 10% by mass to 35% by mass.

In the firing step, for example, the metal component M in the ink transferred onto the surface of the transparent substrate 22 is sintered to form the conductive pattern 24P. Firing is not particularly limited as long as it is a method that can fuse the metal component M to form a metal component sintered film. For example, firing may be performed in a firing furnace, or may be performed using plasma, heated catalyst, ultraviolet rays, vacuum ultraviolet rays, electron beams, infrared lamp annealing, flash lamp annealing, laser, or the like. Note that the obtained metal component sintered film contains a conductive component derived from the metal component M, and may also contain a non-conductive component depending on the components used in the ink and the firing temperature.

[1.3 Electron transport layer 42 (ETL)]

The electron transport layer 42 of the present embodiment efficiently transports electrons generated by photoexcitation in the organic photoactive layers 44 to the metal grid transparent electrode 20, which is a cathode. In addition, the electron transport layer 42 preferably also functions as a hole blocking layer for the purpose of reducing dark current density. The electron transport layer 42 is formed so as to cover the conductive pattern 24P of the metal grid transparent electrode 20.

From the viewpoint of electron transport properties, the difference between: the conduction band or LUMO (lowest unoccupied molecular orbital) of the electron transport layer 42, or at least any of the defect level and doping level thereof responsible for electron conduction; and the LUMO of the organic acceptor material is preferably within 1.0 eV, more preferably within 0.5 eV, and still more preferably within 0.3 eV. In addition, the conduction band or LUMO of the electron transport layer 42, or at least any of the defect level and doping level thereof responsible for electron conduction is preferably shallower than the energy level determined by the work function (4.65 eV in the case of copper) of the metal grid transparent electrode 20. Furthermore, from the viewpoint of hole blocking properties, the valence band or HOMO (highest occupied molecular orbital) of the electron transport layer 42 has an energy level that is preferably 0.3 eV or more deeper than the HOMO of the organic donor material, more preferably 0.5 eV or more deeper than the same, and still more preferably 1.0 eV or more deeper than the same.

For the electron transport layer 42, conventionally known materials and configurations can be used that are commonly used in organic photodetector elements and organic solar cells. The electron transport layer 42 is not particularly limited, and examples thereof include IGZO, ZnO, $TiO_X$ $(1 \leq X \leq 2)$, $SnO_X$ $(1 \leq X \leq 2)$, $CeO_X$ $(4/3 \leq X \leq 2)$, $Nb_2O_5$, $Eu_2O_3$, $MoO_X$ $(2 \leq X \leq 3)$, $AlO_X$ $(0 < X \leq 3/2)$, $In_2O_3$, $BaSnO_4$, ZnMgO, ZnS, and $Bi_2S_3$. In addition, the electron transport layer 42 can be understood by those skilled in the art since it is described in: Boping Yang et al., Inorganic top electron transport layer for high performance inverted perovskite solar cells, EcoMat, October 2021, Vol. 3, P. e12127; Liangyou Lin et al., Inorganic Electron Transport Materials in Perovskite Solar Cells, Advanced Functional Materials, January 2021, Vol. 31, P. 2008300; Kobra Valadi et al., Metal oxide electron transport materials for perovskite solar cells: a review, 2021, Vol. 19, P. 2185-2207, and the like.

From the viewpoint of electron transport properties and hole blocking properties, it is particularly preferable that the electron transport layer 42 be a-IGZO (amorphous IGZO).

The film thickness of the electron transport layer 42 is preferably 5 nm or more and 100 nm or less, more preferably 8 nm or more and 80 nm or less, still more preferably 10 nm or more and 60 nm or less, particularly preferably 12 nm or more and 40 nm or less. It is preferable that the film thickness of the electron transport layer 42 be 5 nm or more from the viewpoint of electron transport properties and hole blocking properties. It is preferable that the film thickness of the electron transport layer 42 be 100 nm or less because the visible light transmittance is improved.

The film of the electron transport layer 42 is preferably formed by a vapor phase deposition method such as PVD or CVD. In particular, it is preferable to form a film through a sputtering method or a vacuum deposition method.

[1.4 Organic photoactive layer 44]

Each organic photoactive layer 44 of the present embodiment is a (photoactive) layer that absorbs light including an optical input signal, separates photoexcited excitons, and generates carriers of electrons and holes. The organic photoactive layer 44 preferably includes at least one or more organic donor materials and one or more organic acceptor materials. The organic photoactive layers 44 of the present embodiment have a structure of subpixels 44S (or subpixel array) in island geometry for the purpose of improving the visible light transmittance of the organic photodetector element as a whole.

For the organic photoactive layers 44, conventionally known materials, configurations, and structures can be used that are commonly used in organic photodetector elements and organic solar cells.

Examples of the structure of an organic photoactive layer 44 include a planar heterojunction, a bulk heterojunction, and a hybrid type combining these. The planar heterojunction has a structure that has at least one PN junction formed by laminating a layer (P-type layer) made of one or more organic donor materials and a layer (N-type layer) made of one or more organic acceptor materials. The bulk heterojunction has a structure (i-layer (intrinsic layer)) that has a mixed junction of one or more organic donor materials (or a layer made of one or more organic donor materials) with one or more organic acceptor materials (or a layer made of one or more organic acceptor materials). The hybrid type can have a structure in which a P-type layer/i-layer/N-type layer are sequentially laminated. Furthermore, the hybrid type can have a structure called a mutual immersion type in which the P-type layer/i-layer/N-type layer are sequentially and continuously transferred without having a layer boundary. From the viewpoint of obtaining high external quantum efficiency, the organic photoactive layer 44 preferably has a structure having a bulk heterojunction that facilitates separation of excitons.

For the reasons described above, each organic photoactive layer 44 of the present embodiment preferably photoelectrically converts near-infrared light having at least some wavelengths in the near-infrared wavelength region of 780 nm to 1200 nm.

[Organic acceptor material]

The organic acceptor material is a material that has the property of being likely to accept electrons, and more specifically, it is an electron-accepting material that has a large electron affinity when an organic acceptor material and an organic donor material are used in contact with each other.

For the purpose of photoelectrically converting the above-described near-infrared light, the optical band gap $E_g^{opt}$ of the organic acceptor material is preferably 1.65 eV or less, more preferably 1.60 eV or less, still more preferably 1.50 eV or less, even more preferably 1.45 eV or less, even more preferably 1.40 eV or less, even more preferably 1.35 eV or less, and particularly preferably 1.30 eV or less. Note that the optical band gap $E_g^{opt}$ in the present description is a value calculated using the longest wavelength (light absorption edge) at which light absorption of a material starts, as is similar to the common definition in the technical field.

For the organic acceptor material, conventionally known materials can be used that are commonly used in organic photodetector elements and organic solar cells. Examples of the organic acceptor material include, but are not particularly limited to, fullerenes such as $C_{60}$, $C_{70}$, and $C_{84}$; fullerene derivatives such as $PC_{61}BM$, $PC_{71}BM$, and $IC_{60}BA$; and non-fullerene acceptors (NFA). For the purpose of photoelectrically converting the above-described near-infrared light, it is preferable to use a non-fullerene acceptor (NFA) as the organic acceptor material.

Examples of the non-fullerene acceptor (NFA) include, but are not particularly limited to, IEICO, IEICO-4F, IEICO-4Cl, IEIC1, IEIC2, IEIC3, TPE-4DPPDCV, SCPDT-4DPPDCV, SCPDT-PDI4, TVIDTPDI, TVIDTzPDI, DTPC-DFIC, DCI-2, COTIC-4F, PDTTIC-4F, DTPC-IC, 6TIC, 6TIC-4F, F10IC, COi8DFIC, F6IC, F8IC, F10IC, PBI-Por, FOIC, SiOTIC-4F, ATT-2, ATT-1, P2, P3, ITDI, CDTDI, INPIC, INPIC-4F, NFBDT, NFBDT-Me, NFBDT-F, IHIC, BTP, BTP-4F, BTP-4Cl, ITIC, ITIC-F, ITIC-M (m-ITIC), ITIC-DM, ITIC-Th, ITIC-Th1, O-IDTBR, EH-IDTBR, IDT-2BR, IDT-2BR1, IDT-2PDI, IDT-N, IDT-T-N, IDT2Se, IDT2Se-4F, IDT-4CN, IDT-BOC6, IDTT(TCV)2, IDTT(TCV)3, IDTT(TCV)4, IDTT-2BM, IDTTIDT-IC, IDTIDSe-IC, BDTIT-M, BDTThIT-M, FDICTF, IDSe-T-IC, IC-C6IDT-IC, IT-M, IT-DM, IT-4F, IT-4Cl, BT-IC, BT-CIC, P(NDI2OD-T2), P(NDI2HD-T2), P(NDI2TOD-T2), PNDIS-HD, P(IDT-NDI), PNDI-T10, NDI-CNTVT, ITCC-M, ITC6-IC, ITCPTC, Ph-DTDP-IC, Ph-DTDP-TIC, Ph-DTDP-TTIC, NFTI, MPU1(2), DC-IDT2T, INIC2, INIC3, DTCC-IC, N2200, DFBDT, CZTT-IC, NDIC, DTCFO-IC, MO-IDIC, IC-2IDT-IC, m-IDTV-PhIC, PTB4F, BDSeIC, TC-FIC, M1, IDTT-2BM, DOC2C6-IC, A4T-16, SN6IC-4F, Y1, Y1-4F, Y1, Y2, Y5, Y6, Y1-4F, Y6Se, Y6-Se-4Cl, Y14, AQx, BTCIC-4Cl, BTPV-4F, IUIC, ITVflC, and IEICS-4F.

For the non-fullerene acceptor (NFA), for example, the materials described in the following can be used, which will be understood by those skilled in the art:

Dong Meng et al., Near-infrared Materials: The Turning Point of Organic Photovoltaics, Advanced Materials, 2021, Accepted Author Manuscript 2107330;

Hao-Wen Cheng et al., Toward High-Performance Semitransparent Organic Photovoltaics with Narrow-Bandgap Donors and Non-Fullerene Acceptors, Advance Energy Materials, 2021, P. 2102908;

Yiwen Wang et al., Recent Progress and Challenges toward Highly Stable Nonfullerene Acceptor-Based Organic Solar Cells, Advance Energy Materials, 2021, Vol. 11, P. 2003002;

Andrew Wadsworth et al., Critical review of the molecular design progress in non-fullerene electron acceptors towards commercially viable organic solar cells Alternative p-doped hole transport material for low operating voltage and high efficiency organic light-emitting diodes, Chemical Society Reviews, 2019, Vol. 48, P. 1596-1625;

Cenqi Yan et al., Non-fullerene acceptors for organic solar cells, Nature Reviews Materials, 2018, Vol. 3, P. 18003;

Leiping Duan et al., Progress in non-fullerene acceptor based organic solar cells, Solar Energy Materials and Solar Cells, May 2019, Vol. 193, P. 22-65;

Guangye Zhang et al., Non-fullerene Acceptor Molecules for Bulk Heterojunction Organic Solar Cells, Chemical Reviews, 2018, Vol. 118, P. 3447-3507;

Pei Cheng et al., Next-generation organic photovoltaics based on non-fullerene acceptors, Nature Photonics, 2018, Vol. 12, P. 131-142;

Lichun Chang et al., Ternary organic solar cells based on non-fullerene acceptors: A review, Organic Electronics, March 2021, Vol. 90, P. 106063; and

Huiting Fu et al., Advances in Non-Fullerene Acceptor Based Ternary Organic Solar Cells, Solar RRL, December 2017, Vol. 2, P. 1700158, etc.

From the viewpoint of obtaining high external quantum efficiency in the above-described near-infrared region, the organic acceptor material is preferably at least one selected from the non-fullerene acceptor group consisting of IEICO, IEICO-4F, IEICO-4Cl, DTPC-DFIC, DCI-2, COTIC-4F, PDTTIC-4F, DTPC-IC, 6TIC, 6TIC-4F, F10IC, COi8DFIC, F6IC, F8IC, F10IC, PBI-Por, FOIC, SiOTIC-4F, ATT-2, P3, ITDI, and BTP-4Cl. From the same viewpoint, the organic acceptor material is particularly preferably at least one selected from the non-fullerene acceptor group consisting of IEICO-4F, IEICO-4Cl, IEICO, DTPC-DFIC, DCI-2, COTIC-4F, PDTTIC-4F, DTPC-IC, 6TIC-4F, COi8DFIC, FOIC, F8IC, F10IC, SiOTIC-4F, and P3.

[Organic donor material]

The organic donor material is a material that has the property of being likely to donate electrons, and more specifically, it is an electron-donating material that has a small ionization potential when an organic acceptor material and an organic donor material are used in contact with each other.

For the purpose of photoelectrically converting the above-described near-infrared light, the optical band gap $E_g^{opt}$ of the organic donor material is preferably 1.65 eV or less, more preferably 1.63 eV or less, still more preferably 1.62 eV or less, even more preferably 1.61 eV or less, and particularly preferably 1.60 eV or less.

For the organic donor material, conventionally known materials can be used that are commonly used in organic photodetector elements and organic solar cells. Examples of the organic donor material include, but are not particularly limited to, PTB7-Th (alias: PCE-10), PDTP-DFBT, PDPP3T, PDPP3T-O14, PDPP3T-O16, PDPP3T-O20, PDPP3T-C20, PDPP4T, DPPTfQxT, DPPTQxT, DPPBTQxBT, DPPBTffQxBT, FLP030 (product name), PBDTT-SeDPP, PBDTT-DPP, PBDTT-FDPP, PDPP2T-TT (PTT-DTDPP), PCDTBT, PCPDTBT, PCPDTFBT, Si-PCPDTBT, PCPDT-BSe, PBDTTT-E, PBDTTT-C, PBDTTT-CF, PSBT-BT, C3-DPPTT-T, C3-DPPTT-Se, C3-DPPTT-Te, PDPP-DTS, DPPTBI, DPPTDTSffBzDTST, ZnP2-DPP, P3, P(ffDITDQx-BT), PFDPPSe-C18, CS-DP, BDP-OMe, P2-Bronstein, PFDQ, PTBEHT, PDPPTDTPT, PDPPSDTPS, PDTTDPP, PDTP-DTDPP(Bu), P2-Aso, PTTDTP, APFO-Green1, P1-Ying, P1-Iraqi, F2, CDTDOP, CEHTP, TTV2, TBDPTV, PPor1, and P3TPQ.

For the organic donor material, for example, the materials described in the following can be used, which will be understood by those skilled in the art:

Dong Meng et al., Near-infrared Materials: The Turning Point of Organic Photovoltaics, Advanced Materials, 2021, Accepted Author Manuscript 2107330;

Hao-Wen Cheng et al., Toward High-Performance Semitransparent Organic Photovoltaics with Narrow-Bandgap Donors and Non-Fullerene Acceptors, Advance Energy Materials, 2021, P. 2102908;

Yiwen Wang et al., Recent Progress and Challenges toward Highly Stable Nonfullerene Acceptor-Based Organic Solar Cells, Advance Energy Materials, 2021, Vol. 11, P. 2003002;

Andrew Wadsworth et al., Critical review of the molecular design progress in non-fullerene electron acceptors towards commercially viable organic solar cells Alternative p-doped hole transport material for low operating voltage and high efficiency organic light-emitting diodes, Chemical Society Reviews, 2019, Vol. 48, P. 1596-1625;

Cenqi Yan et al., Non-fullerene acceptors for organic solar cells, Nature Reviews Materials, 2018, Vol. 3, P. 18003;

Leiping Duan et al., Progress in non-fullerene acceptor based organic solar cells, Solar Energy Materials and Solar Cells, May 2019, Vol. 193, P. 22-65;

Guangye Zhang et al., Non-fullerene Acceptor Molecules for Bulk Heterojunction Organic Solar Cells, Chemical Reviews, 2018, Vol. 118, P. 3447-3507;

Pei Cheng et al., Next-generation organic photovoltaics based on non-fullerene acceptors, Nature Photonics, 2018, Vol. 12, P. 131-142;

Lichun Chang et al., Ternary organic solar cells based on non-fullerene acceptors: A review, Organic Electronics, March 2021, Vol. 90, P. 106063; and

Huiting Fu et al., Advances in Non-Fullerene Acceptor Based Ternary Organic Solar Cells, Solar RRL, December 2017, Vol. 2, P. 1700158, etc.

From the viewpoint of obtaining high external quantum efficiency and low dark current density in the above-described near-infrared region, the organic donor material is preferably at least one selected from the group consisting of PTB7-Th (alias: PCE-10), PDTP-DFBT, PDPP3T, PDPP3T-O14, PDPP3T-O16, PDPP3T-O20, PDPP3T-C20, PDPP4T, DPPTfQxT, DPPTQxT, DPPBTQxBT, DPPBTffQxBT, FLP030 (product name), PBDTT-SeDPP, PBDTT-DPP, PBDTT-FDPP, PDPP2T-TT (PTT-DTDPP), PCDTBT, PCPDTBT, PCPDTFBT, and Si-PCPDTBT.

When the film thickness of the organic photoactive layer 44 in a sub-sensor area 44SS provided on the metal wires 24 is $t_{OPD}$, ($t_{OPD}$-$t_{TCE}$) is the difference between the film thickness of the organic photoactive layer 44 and the film thickness of each metal wire 24 in the sub-sensor area 44SS. The ($t_{OPD}$-$t_{TCE}$) is preferably 50 nm or more and 500 nm or less, more preferably 100 nm or more and 450 nm or less, still more preferably 140 nm or more and 380 nm or less, even more preferably 160 nm or more and 330 nm or less, and particularly preferably 180 nm or more and 280 nm or less. The ($t_{OPD}$-$t_{TCE}$) being 50 nm or more allows the convex metal wires 24 to be sufficiently covered by the organic photoactive layer 44 in the sub-sensor area 44SS and further to secure a sufficient distance to the opposing anode, making it possible to prevent an electrical short. Furthermore, since light absorption increases exponentially with respect to $t_{OPD}$, external quantum efficiency tends to improve as $t_{OPD}$ increases. In contrast, the ($t_{OPD}$-$t_{TCE}$) being 500 nm or less prevents decrease in charge collection efficiency $\eta_{cc}$ due to thickening of the organic photoactive layer 44 in the sub-sensor area 44SS, making it possible to maintain high external quantum efficiency. The charge collection efficiency $\eta_{cc}$ decreases inversely proportional to $t_{OPD}$ in a region where the organic photoactive layer 44 is sufficiently thick, as disclosed in J. Xue et al., A Hybrid Planar-Mixed Molecular Heterojunction Photovoltaic Cell, Advanced Materials., January 2005, Vol. 17, P. 66-71. Furthermore, ($T_{OPD}$-$t_{TCE}$) being 500 nm or less allows the organic photodetector in the subpixel 44S portion to tend to have an improved visible light transmittance to decrease visibility of the subpixel 44S.

The $T_{OPD}$ is not particularly limited as long as ($T_{OPD}$ - $t_{TCE}$) can be adjusted within the above-described range, and is preferably 80 nm or more and 700 nm or less, more preferably 150 nm or more and 500 nm or less, still more preferably 200 nm or more and 400 nm or less, particularly preferably 250 nm or more and 350 nm or less. It is preferable that the $t_{OPD}$ be within the above-described range for the reasons described above.

The $t_{OPD}$ can be made into a value determined from process conditions of dry film forming, wet film forming, or patterning printing by using a calibration curve of the process conditions and film thickness of each organic photoactive layer 44. The $t_{OPD}$ can be checked by observing the cross section of the organic photodetector element using an electron microscope (SEM, TEM, STEM). Also, the film thickness can be measured by: using EDX (energy dispersive X-ray analysis) for the observation field of the electron microscope image of the cross section of the organic photodetector element to map the EDX intensities of the K shells of carbon atoms C; and determining that the organic photoactive layer 44 is the region having a high EDX intensity of the carbon atoms C between the metal wires 24 and the opposing electrode (for example, anode).

For a method for forming an organic photoactive layer 44, a conventionally known method can be used that are commonly used for organic photodetector elements and organic solar cells. In such a method, for example, an organic photoactive layer 44 having a bulk heterojunction structure can be formed by dry film forming such as codeposition of one or more organic donor materials and one or more organic acceptor materials. Also, an organic photoactive layer 44 having a bulk heterojunction structure can be formed by subjecting an ink for forming an organic photoactive layer, prepared by dissolving a predetermined amount of one or more organic donor materials and one or more organic acceptor materials in an appropriate solvent, to: wet film forming through a known coating method such as slot die coating or spin coating, or a casting method; drying; and annealing as necessary. It is also possible to adjust the morphology of the bulk heterojunction through adjustment of drying and annealing conditions on the ink for forming an organic photoactive layer to adjust a nano-level phase-separated structure of a phase made of one or more organic donor materials and a phase made of one or more organic acceptor materials.

For the solvent for the ink for forming an organic photoactive layer, conventionally known solvents can be used that are commonly used in organic photodetector elements and organic solar cells. The examples thereof include: aromatic-based solvents such as toluene, xylene, mesitylene, and cyclohexylbenzene; halogen-containing solvents such as 1,2-dichloroethane, chlorobenzene, and o-dichlorobenzene; ether-based solvents such as aliphatic ethers, such as ethylene glycol dimethyl ether, ethylene glycol diethyl ether, and propylene glycol-1-monomethyl ether acetate (PGMEA), and aromatic ethers, such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole; aliphatic ester-based solvents such as ethyl acetate, n-butyl acetate, ethyl lactate, and n-butyl lactate; and ester-based solvents such as aromatic esters, such as phenyl acetate, phenyl propionate, methyl benzoate, ethyl benzoate, isopropyl benzoate, propyl benzoate, and n-butyl benzoate.

Additives such as chloronaphthalene and 1,8-diode octane can be appropriately added to the ink for forming an organic photoactive layer for the purpose of adjusting the morphology of the bulk heterojunction.

In a method of forming subpixels 44S, the solid film to be the organic photoactive layers 44 is first formed throughout the surface of the element by dry film forming or wet film forming through the method described above. Next, the subpixels 44S can be formed using a known patterning method such as photolithography, nanoimprint, lift-off, or laser ablation for the solid film of the organic photoactive layer 44. A patterning method is particularly preferably a method disclosed in Non Patent Literature 3. Also, the subpixels 44S may be formed by subjecting an ink for forming an organic photoactive layer to: patterning printing using a known printing method such as gravure printing, gravure offset printing, relief printing, flexographic printing, inkjet printing, or screen printing; drying; and annealing as necessary.

[1.5 Hole transport layer 46 (HTL)]

The hole transport layer 46 of the present embodiment efficiently transports holes generated by photoexcitation in the organic photoactive layers 44 to the anode. The hole transport layer 46 preferably also functions as an electron blocking layer for the purpose of reducing dark current density.

From the viewpoint of hole transport properties, the difference between: the valence band or HOMO of the hole transport layer 46, or at least any of the defect level and the doping level responsible for hole conduction; and the HOMO of the organic donor material is preferably within 0.5 eV, and more preferably within 0.3 eV. In addition, from the viewpoint of electron blocking properties, the conduction band or LUMO of the hole transport layer 46 is preferably on an energy level shallower by 0.3 eV or more, more preferably on an energy level shallower by 0.5 eV or more, and still more preferably on an energy level shallower by 1.0 eV or more, than the LUMO of the organic acceptor materials.

For the hole transport layer 46, conventionally known materials and configurations can be used that are commonly used in organic photodetector elements and organic solar cells. The hole transport layer 46 may be made of, but not limited to, $MoO_{X\ (2 \leq X \leq 3)}$, $CU_{-X}O_{\ (1 \leq X \leq 2)}$, CuS, CuI, CuPc, CuSCN, CIS, $CuCrO_2$, $CuGaO_2$, $NiO_{X\ (1 \leq X \leq 2)}$, $CoO_{X\ (1 \leq X \leq 1.5)}$, PbS, $CrO_{X\ (1 \leq X \leq 5)}$, $MoS_2$, $VO_{X\ (1 \leq X \leq 2.5)}$, and the like. The hole transport layer 46 can be understood by those skilled in the art from the description in, for example, Arumugam, GM et al., Inorganic hole transport layers in inverted perovskite solar cells: A review, Nano Select., June 2021, Vol. 2, P. 1081-1116. From the viewpoint of hole transport properties and electron blocking properties, the hole transport layer 46 is particularly preferably made of $MoO_{x\ (2\ \leq\ X\ \leq\ 3)}$.

The film thickness of the hole transport layer 46 is preferably 5 nm or more and 300 nm or less, more preferably 10 nm or more and 200 nm or less, still more preferably 30 nm or more and 100 nm or less, particularly preferably 50 nm or more and 80 nm or less. It is preferable that the film thickness of the hole transport layer 46 be 5 nm or more from the viewpoint of hole transport properties and electron blocking properties. It is preferable that the film thickness of the hole transport layer 46 be 300 nm or less because visible light transmittance is improved.

The method of forming the hole transport layer 46 is preferably forming the film through a vapor phase deposition method such as PVD or CVD. In particular, it is preferable to form a film through a sputtering method or a vacuum deposition method.

[1.6 Transparent electrode 60 (Anode)]

The transparent electrode 60 of the present embodiment is used as the anode of the organic photodetector element, and contributes to improving the transparence of the organic photodetector element while collecting holes generated in the organic photoactive layers 44 as charges.

For the transparent electrode 60 of the present embodiment, conventionally known materials and configurations can be used that are commonly used in organic photodetector elements and organic solar cells. Examples thereof include, but are not limited to, the above-described metal grid transparent electrode 20 (or only the metal grid), a transparent conductive inorganic compound, a conductive polymer such as PEDOT:PSS, a metal nanowire such as silver nanowire, and a carbon material such as graphene. Any one of these may be used alone, or these may be used in combination. From the viewpoint of having high visible light transmittance and low sheet resistance, the transparent electrode 60 of the present embodiment is preferably the above-described metal grid transparent electrode 20 (or only the metal grid) or a transparent conductive inorganic compound, and more preferably a transparent conductive inorganic compound. In addition, the transparent electrode 60 of the present embodiment is preferably the metal grid transparent electrode 20 (or only the metal grid) or a conductive polymer from the viewpoint of improving the flexibility of the organic photodetector element.

The material to be used for the transparent conductive inorganic compound is not particularly limited as long as it has high transmittance in the visible light region and exhibits conductivity. The examples thereof include $In_2O_3$-based materials such as ITO, $SnO_2$-based materials such as ATO and FTO, ZnO-based materials such as AZO and GZO, (ZnO-$In_2O_3$) -based materials such as $Zn_2In_2O_5$ and $Zn_3In_2O_2$, ($In_2O_3$-$SnO_2$)-based materials such as $In_4Sn_3O_{12}$, and (ZnO-$SnO_2$)-based materials such as $Zn_2SnO_4$ and $ZnSnO_3$. Other known materials to be used for transparent conductive oxides can be used. Of these, it is preferable to use ITO (indium tin oxide), which is most widely used and has excellent transparence and conductivity.

The film thickness of the transparent conductive inorganic compound is preferably 10 nm or more and 1000 nm or less, more preferably 10 nm or more and 500 nm or less, still more preferably 10 nm or more and 300 nm or less, and particularly preferably 10 nm or more and 200 nm or less. The film thickness of the transparent conductive inorganic compound being 10 nm or more allows the transparent conductive inorganic compound to have a lower sheet resistance, and allows the organic photodetector element to tend to have a larger area. In contrast, the film thickness of the transparent conductive inorganic compound being 1000 nm or less allows the transparent conductive inorganic compound to tend to be prevented from decrease in visible light transmittance.

The upper limit value of the sheet resistance of the transparent conductive inorganic compound is preferably 500Ω/sq. or less, more preferably 200Q/sq. or less, still more preferably 100Ω/sq. or less, and particularly preferably 50Q/sq. or less. The sheet resistance of the transparent conductive inorganic compound being 500Ω/sq. or less allows the organic photodetector element to tend to have a larger area. The lower limit value of the sheet resistance of the transparent conductive inorganic compound layer is not particularly limited, and may be, for example, 0.1Ω/sq.

The lower limit value of the visible light transmittance of the transparent conductive inorganic compound is preferably 60% or more, more preferably 70% or more, still more preferably 80% or more, and particularly preferably 90% or more. The visible light transmittance of the transparent conductive inorganic compound layer being 60% or more allows the organic photodetector element to tend to have an improved transparence. The upper limit value of the visible light transmittance of the transparent conductive inorganic compound is not particularly limited, and may be, for example, 100% or less.

The transparent conductive inorganic compound is preferably formed into a film by a vapor phase deposition method such as PVD or CVD. In particular, it is preferable to form a film through a sputtering method or a vacuum deposition method.

[1.7 Encapsulation layer]

The encapsulation layer is a layer having high shielding performance against moisture and oxygen, similarly to the above-described barrier layer. Providing the encapsulation layer contributes to preventing deterioration of properties of the organic photodetector elements due to moisture and oxygen entering the interiors of the organic photodetector elements. The encapsulation layer is provided on the anode and can be formed so as to cover the organic photodetector elements or organic photodetector array other than a region of a portion of a current collecting section 110 exposed for further connection to an external terminal. For the encapsulation layer, conventionally known compositions, structures, and formation methods can be applied that are commonly used in organic photodetector elements and organic solar cells, and the same composition and structure as the barrier layer described above are preferably used. For the encapsulation layer, it is particularly preferable to apply a thin film encapsulation (TFE) disclosed in Non Patent Literature 2. Also for the encapsulation layer, a barrier laminate film can be used in which the above-described barrier layer or the thin film encapsulation disclosed in Non Patent Literature 2, and an adhesive layer having gas barrier properties are laminated sequentially on the material used as the core layer of the transparent substrate 22. When a barrier laminate film is used as an encapsulation layer, the film can be laminated so that the adhesive layer adheres to the anode, and sealed using a known lamination method using heat, pressure, light, etc.

[2. Organic photodetector array]

Figure 7(A) is a schematic diagram of an organic photodetector array (hereinafter sometimes referred to as "OPD array"), and Figure 7(B) is a partially enlarged view of region AR1 in Figure 7(A). The OPD array includes a plurality of OPD elements 10, a current collecting section 110, wiring sections 120 for electrically connecting the current collecting section 110 and each OPD element 10, and dummy pattern sections 130.
The OPD array of the present embodiment includes a plurality of OPD elements 10 arranged two-dimensionally and spaced apart from each other in two orthogonal coordinate axes (the up-down direction and the left-right direction in the paper plane) on a parallel plane. A plurality of OPD elements 10 are regularly arrayed at equal intervals in each direction. However, the OPD array is not limited to this, and may include a plurality of OPD elements 10 arrayed one-dimensionally, or may include a plurality of OPD elements 10 arrayed randomly. As described above, each OPD element 10 includes a subpixel array consisting of a plurality of subpixels 44S arrayed two-dimensionally and spaced apart from each other on two orthogonal coordinate axes (the up-down direction and the left-right direction in the paper plane) on a parallel plane.
Each organic photodetector element is an element that has a voltage (typically a reverse bias) applied from an external circuit and extracts carriers of electrons and holes generated by photoexcitation in the organic photoactive layers 44 to the external circuit as a photodetection current. The organic photodetector element forms a single pixel of the organic photodetector array. The organic photodetector element may include the configuration of the OPD element 10 as well as other organic photodetector elements described above.
The organic photodetector array of the present embodiment can include the current collecting section 110 that is connected to a terminal from an external circuit, and propagates the voltage signal applied from the external circuit to each organic photodetector element and propagates the photodetection current to the external circuit. In addition, the organic photodetector array of the present embodiment can include wiring sections 120 each electrically connecting the organic photodetector element and the current collecting section 110.

[Wiring section 120]

The organic photodetector array of the present embodiment can include wiring sections 120 having a second conductive pattern provided on the transparent substrate 22 and electrically connected to the conductive pattern 24P (metal wires 24). Each wiring section 120 can be provided independently for a pixel. In other words, the following are configured such that they can be electrically insulated from each other: the wires of the wiring section 120 connected to the metal wires 24 of the first OPD element 10 included in the OPD array; and the wires of the wiring section 120 connected to the metal wires 24 of the second OPD element 10 included in the OPD array. Therefore, each OPD element 10 can function as an independent pixel.
Here, for the purpose of uniformizing the visible light transmittance throughout the organic photodetector array, $A_{wire}$ preferably satisfies $-10\% \leq (A_{wire} - A_{TCE}) \leq 10\%$, where the $A_{wire}$ is the aperture rate of the second conductive pattern. The $A_{wire}$ more preferably satisfies $-8\% \leq (A_{wire} - A_{TCE}) \leq 8\%$, still more preferably $-6\% \leq (A_{wire} - A_{TCE}) \leq 6\%$, and particularly preferably $-4\% \leq (A_{wire} - A_{TCE}) \leq 4\%$.
Such a configuration allows reducing variations in visible light transmittance between the region where the conductive pattern 24P is provided and the region where the second conductive pattern is provided. Therefore, when an organic photodetector array is placed on the screen of a display body such as a display, variations can be reduced in the appearance of images displayed on the screen of the display body.

(Line width, gap)

The line width $W_{wire}$ of the metal wire 24 forming the second conductive pattern is preferably 0.25 $\mu$m or more and 5.0 $\mu$m or less, more preferably 0.25 $\mu$m or more and 4.0 $\mu$m or less, and still more preferably 0.25 $\mu$m or more and 3.0 $\mu$m or less, even more preferably 0.25 $\mu$m or more and 2.0 $\mu$m or less, and particularly preferably 0.25 $\mu$m or more and 1.0 $\mu$m or less. In addition, for the purpose of uniformizing the visible light transmittance and the visibility of the metal wires 24 throughout the organic photodetector array, it is preferable that $W_{wire}$ have the same line width value as $W_{TCE}$. $W_{wire}$ being 0.25 $\mu$m or more allows reducing the wiring resistance, thereby allowing the organic photodetector array to tend to have a larger area. In addition, it is possible to sufficiently prevent increase in electrical resistance due to oxidation, corrosion, etc. on the surface of a metal wire 24. In contrast, the line width $W_{wire}$ of the metal wire 24 being 5.0 $\mu$m or less allows decreasing the visibility of the opaque metal wire 24. In particular, adjusting the line width $W_{wire}$ of the metal wire 24 to 3.0 $\mu$m or less allows the opaque metal wire 24 to be made invisible to the human eye. As a result, even when the organic photodetector array is placed on a display body such as a display, the appearance and design of the display body are not impaired. The gap $G_{wire}$ of the second conductive pattern can be appropriately set depending on the second conductive pattern and $W_{wire}$ so that the aperture rate $A_{wire}$ is within the above range. For the purpose of uniformizing the visible light transmittance and the visibility of the metal wires 24 throughout the organic photodetector array, it is preferable that $G_{wire}$ have the same gap value as $G_{TCE}$.

[Current collecting section 110]

The organic photodetector array of the present embodiment can include a current collecting section 110 that has a third conductive pattern provided on the transparent substrate 22 and electrically connected to the second conductive pattern. The current collecting section 110 is a portion that collects the photodetection current detected by the OPD elements 10 each forming a pixel and supplies the current to an external circuit. The current collecting section 110 may include, for example, a contact pad (bonding area) for connecting to external FPCs (flexible printed circuits).

When $\Gamma_{pad}$ is defined as the occupation area rate of the third conductive pattern per unit area, $\Gamma_{pad}$ is preferably 50% or more and less than 100%. The lower limit value of $\Gamma_{pad}$ is more preferably 60% or more, and still more preferably 70% or more. The third conductive pattern having the occupation area rate $\Gamma_{pad}$ within the above range further improves the electrical connection with the external terminals, and lower the resistance of the current collecting section 110 to allow the applied voltage to tend to be prevented from voltage drop.

Note that the "occupation area rate" of the conductive pattern 24P can be calculated with the following expression for the region where the conductive pattern 24P is formed on the transparent substrate 22.

Occupation area rate = (area occupied by conductive pattern 24P/area of transparent substrate 22 in region where conductive pattern 24P is formed) $\times$ 100

For example, when the third conductive pattern is a square mesh pattern shown in Figure 3(A) and has a line width of 5 $\mu$m and a gap of 10 $\mu$m, the area occupied by the third conductive pattern per unit area (the area occupied by the metal wires 24) is approximately 56%. Therefore, the occupation area rate $\Gamma_{pad}$ is approximately 56%.

(Line width, gap)

The line width $W_{pad}$ of the metal wire 24 forming the third conductive pattern is preferably 0.25 $\mu$m or more and 10 $\mu$m or less, more preferably 0.5 $\mu$m or more and 8 $\mu$m or less, and still more preferably 1 $\mu$m or more and 6 $\mu$m or less. $W_{pad}$ being within the above range further improves connectivity with external terminals, and lowers the sheet resistance of the current collecting section 110, allowing the applied voltage to tend to be prevented from voltage drop. The gap $G_{pad}$ of the third conductive pattern can be appropriately set depending on the third conductive pattern and $W_{pad}$ so that the occupation area rate $\Gamma_{pad}$ is within the above range.

[Dummy pattern section 130]

The organic photodetector array of the present embodiment can include a dummy pattern section 130 configured to be able to be electrically insulated from the conductive pattern 24P and the second and third conductive patterns 24P. The dummy pattern section 130 may be provided between two adjacent OPD elements 10. For example, in a case in which a plurality of OPD elements 10 included in an organic photodetector array are arrayed two-dimensionally at equal intervals along two orthogonal coordinate axes, (however, as shown in Figure 7, this case includes an embodiment in which the OPD elements 10 are arrayed at equal intervals along one coordinate axis and at equal intervals along the other coordinate axis, but at different intervals for each coordinate axis,) the dummy pattern sections 130 may be arrayed at equal intervals along two orthogonal coordinate axes between two adjacent OPD elements 10.

Figure 7 shows dummy pattern sections 130 thus provided between two OPD elements 10 adjacent in the first coordinate axis (horizontal direction in the paper plane), and dummy pattern sections 130 thus provided between two OPD elements 10 adjacent in the second coordinate axis (vertical direction in the paper plane).

The dummy pattern sections 130 may have the same configuration as the metal grid transparent electrode 20 of the OPD element 10. The same configuration allows standardizing manufacturing processes of the metal grid transparent electrode 20 of the OPD element 10 and the dummy pattern sections 130.

Providing the dummy pattern sections 130 in the regions where the OPD elements 10 are not provided in this way allows reducing the difference in visible light transmittance between the two regions. For the purpose of uniformizing the visible light transmittance throughout the organic photodetector array, $A_{dummy}$ preferably satisfies -10% $\leq (A_{dummy} - A_{TCE})$ $\leq$ 10%, where the $A_{dummy}$ is the aperture rate of the dummy pattern. The $A_{dummy}$ more preferably satisfies -8% $\leq (A_{dummy} - A_{TCE}) \leq$ 8%, still more preferably -6% $\leq (A_{dummy} - A_{TCE}) \leq$ 6%, and particularly preferably -4% $\leq (A_{dummy} - A_{TCE}) \leq$ 4%.

(Line width, gap)

The line width $W_{dummy}$ of a metal wire 24 forming the dummy pattern section 130 is preferably 0.25 $\mu$m or more and 5.0 $\mu$m or less, more preferably 0.25 $\mu$m or more and 4.0 $\mu$m or less, still more preferably 0.25 $\mu$m or more and 3.0 $\mu$m or less, even more preferably 0.25 $\mu$m or more and 2.0 $\mu$m or less, and particularly preferably 0.25 $\mu$m or more and 1.0 $\mu$m or less. In addition, for the purpose of uniformizing the visible light transmittance and the visibility of the metal wire 24 throughout the organic photodetector array, it is preferable that $W_{dummy}$ has the same line width value as $W_{TCE}$. $W_{dummy}$ being 0.25 $\mu$m or more allows sufficiently preventing increase in electrical resistance due to oxidation, corrosion, etc. on the surface of the metal wire 24. In contrast, the line width $W_{dummy}$ of the metal wire 24 being 5.0 $\mu$m or less allows the opaque metal wire 24 to have a decreased visibility. In particular, adjusting the line width $W_{dummy}$ of the metal wire 24 to 3.0 $\mu$m or less allows the opaque metal wire 24 to be invisible to the human eye. As a result, even when the organic photodetector array is placed on a display body such as a display, the appearance and design of the display body are not impaired. The gap $G_{dummy}$ of a dummy pattern section 130 can be appropriately set depending on the pattern of the dummy pattern section 130 and $W_{dummy}$ so that the aperture rate $A_{dummy}$ is within the above range. For the purpose of uniformizing the visible light transmittance and the visibility of the metal wires 24 throughout the organic photodetector array, it is preferable that $G_{dummy}$ has the same gap value as $G_{TCE}$.

[Dummy subpixel]

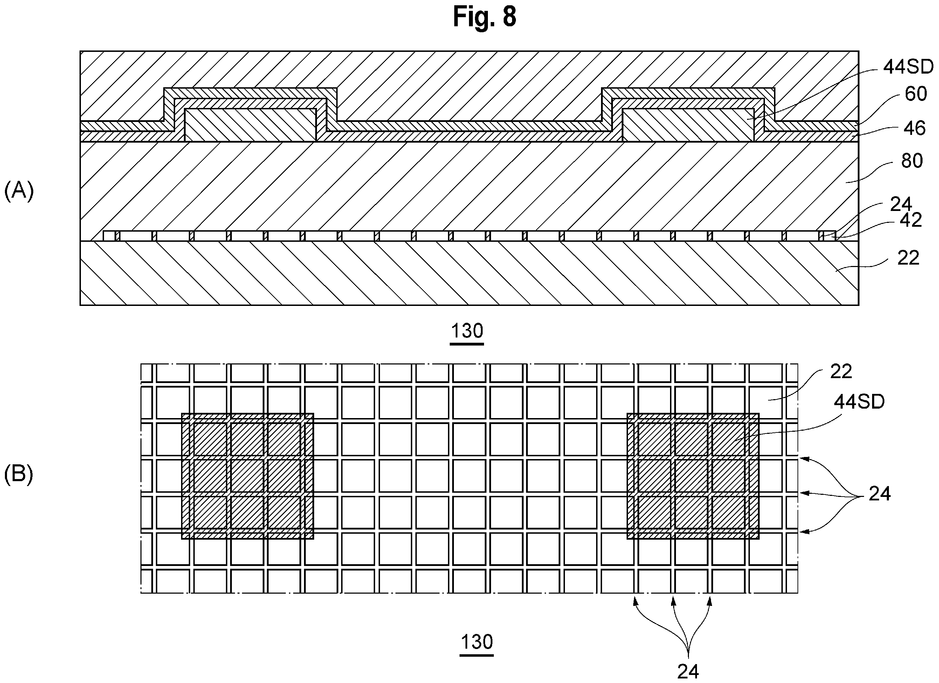

Figure 8 shows a cross-sectional view and a projection view of the dummy subpixels 44SD provided in a region AR3 on a dummy pattern section 130 of Figure 7. Note that the cross-sectional view and the projection view of the subpixels 44S provided within a region AR2 in an OPD element 10 in Figure 7 correspond to those in Figure 1.

As shown in Figure 8, the organic photodetector array 100 of the present embodiment can include an insulating layer 80 provided on the dummy pattern section 130, and organic photoactive layers (dummy subpixels 44SD) provided on the insulating layer 80 and insulated from the dummy pattern section 130. Here, the insulating layer 80 on the dummy pattern section 130 may include substantially the same thickness and the same composition as the insulating layer 80 of the OPD element 10. Both the insulating layers 80 having substantially the same thickness and the same composition allows standardizing the manufacturing processes. In other words, this allows simultaneously forming the films of the insulating layer 80 of the OPD element 10 and the insulating layer 80 on the dummy pattern section 130. The insulating layer 80 on the metal grid transparent electrode 20 of the OPD element 10 may be further provided with aperture sections OP by patterning.

Unlike an organic photoactive layer 44 of the OPD element 10, an organic photoactive layer (dummy subpixel 44SD) on the dummy pattern section 130 is provided at a position spaced at substantially the same distance from the electron transport layer 42 with the insulating layer 80 interposed therebetween, in the cross-sectional view (Figure. 8(A)). Therefore, the organic photoactive layer (dummy subpixel 44SD) on the dummy pattern section 130 is insulated from the dummy pattern section 130. Therefore, no current is detected in the dummy pattern section 130. Note that the organic photoactive layer (dummy subpixel 44SD) on the dummy pattern section 130 has substantially the same thickness as the alignment area 44SA of the OPD element 10, thereby making it possible to standardize the manufacturing processes of both organic photoactive layers. In other words, this allows simultaneously forming the films of the organic photoactive layers 44 of the OPD elements 10 and the organic photoactive layers (dummy subpixels 44SD) on the dummy pattern sections 130. Note that the dummy subpixels 44SD can be provided not only on the insulating layer 80 provided on the dummy pattern sections 130 or the electron transport layer 42, but also on the transparent substrate 22, the metal grid transparent electrode 20 other than the OPD element 10 regions, or the insulating layer 80 provided on the wiring section 120, for example.

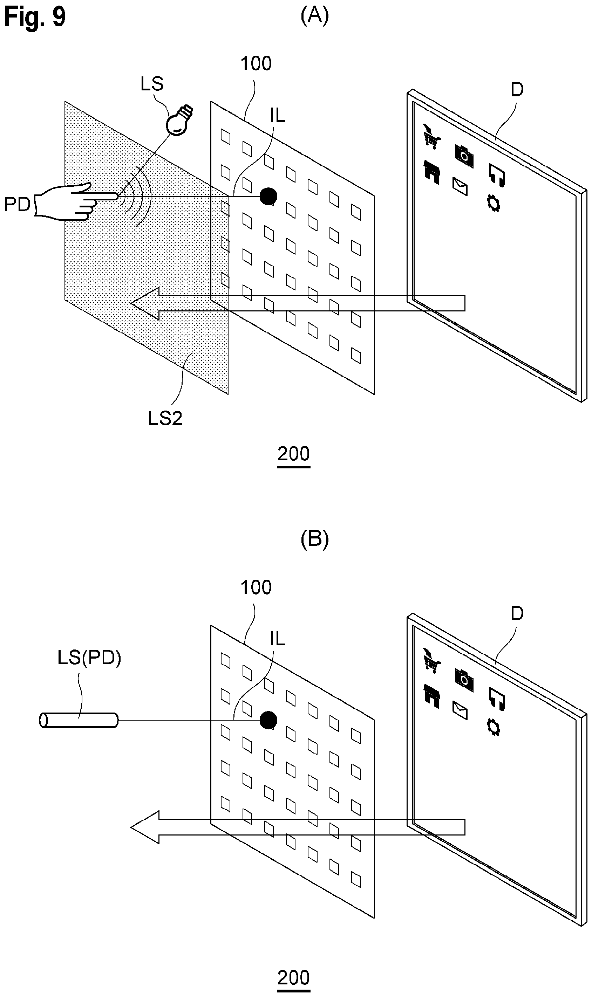

The organic photodetector array 100 (OPD array 100) of the present embodiment additionally includes dummy subpixels 44SD provided in the region between the OPD elements 10. This allows reducing the difference in visible light transmittance between the region provided with the OPD elements 10 and the region between the OPD elements 10 (the region provided with the dummy pattern sections 130, see Figure 7). In addition, providing the dummy subpixels 44SD also allows preventing the occurrence of interference fringes compared to the case in which the dummy subpixels 44SD are not provided. For this reason, when the OPD array 100 is provided on the screen of a display or a display body as described later using Figure 9 etc., interference fringes due to light emitted from the display or the display body are prevented. This allows improving visibility of the display or the display body. Therefore, the organic photodetector array formed of the organic photodetector elements disclosed in the present embodiment can be suitably applied to a touchless user interface.

The reason why the provision of the dummy subpixels 44SD makes interference fringes unlikely to be observed when the organic photodetector array is applied to a touchless user interface is considered as follows.

When the organic photodetector array 100 according to the present embodiment is applied to an existing display, the light-emitting pixels of the display are each approximately 200 to 300 $\mu$m, and the distance between the light-emitting pixel and the organic photodetector array 100 (the distance in the direction perpendicular to the screen) is approximately several mm. The visualization degree of interference fringes caused by the OPD elements 10 of the organic photodetector array 100 or the subpixels 44S in the OPD elements 10 is as shown in the following expression. Therefore, the generated interference fringes become small, and it is difficult to visually recognize such interference fringes.

$$[\text{Expression 2}]$$

$$V = (Imax - Imin)/(Imax + Imin)$$

$$= \left| \sin(\pi ad/\lambda L)/(\pi ad/\lambda L) \right|$$

In the expression, V is the visualization degree (intensity) of the interference fringes; $I_{max}$ is the light intensity of the bright part of each of the interference fringes; $I_{min}$ is the light intensity of the dark part of each of the interference fringes; a is the light source width; $\lambda$ is the emission wavelength; d is the pitch of the OPD elements 10 (for example, the distance between the centers of adjacent photodetector elements 10) or the pitch of the subpixels 44S in an OPD element 10 (for example, the distance between the centers of adjacent subpixels 44S); and L is the distance from a light-emitting pixel of the display to an organic photodetector array 100.

The pitch of the interference fringes is as shown in the following expression. Therefore, the pitch of the interference fringes caused by the OPD elements 10 of the organic photodetector array 100 or the subpixels 44S in an OPD element 10 is small, on the order of several hundreds of micrometers, and is difficult to be visually recognized.

$$[\text{Expression 3}]$$

$$X = mD\lambda/d$$

In the expression, X is the pitch of the interference fringes; m is the interference order (an integer); and D is the distance from the organic photodetector array 100 to the observer.

As described above, the interference fringes caused by the OPD elements 10 of the organic photodetector array 100, and the interference fringes caused by the subpixels 44S in an OPD element 10 each have a low visibility alone. However, it has been found that in a configuration in which the OPD elements 10 are arranged apart from each other (Figure 7) and the subpixels 44S are arranged apart from each other within each OPD element 10 (Figure 1), the superposition of the individual interference fringes can generate interference fringes having visible intensity and pitch.

Therefore, the organic photodetector array 100 of the present embodiment includes the dummy subpixels 44SD provided in a region between the OPD elements 10. Providing the dummy subpixels 44SD allows preventing the occurrence of interference fringes caused by the OPD elements 10 being arranged apart from each other. This allows preventing occurrence of the interference fringes having visible intensity and pitch caused by superposition of: interference fringes caused by the OPD elements 10 of the organic photodetector array 100; and interference fringes caused by the subpixels 44S in an OPD element 10.

[Dummy subpixel array]

Here, the same pattern structure may be used for: an array structure of a plurality of organic photoactive layers provided apart from each other (each organic photoactive layer is sometimes referred to as a "dummy subpixel 44SD", and an array structure consisting of a plurality of dummy subpixels 44SD is sometimes referred to as a "dummy subpixel array") in the projection view; and an array structure of a plurality of organic photoactive layers 44 provided apart from each other in an OPD element 10 in the projection view. For example, both may have a two-dimensional array structure in the projection view. Furthermore, the pitch of the dummy subpixel arrays in the first direction and/or the second direction may be the same as the pitch of the subpixel arrays in the first direction and/or the second direction.

[Material and process of wiring section 120, current collecting section 110, and dummy pattern section 130]

The wiring section 120 and the current collecting section 110 are not particularly limited as long as they can be electrically connected to the conductive pattern 24P. For the wiring section 120 and the current collecting section 110, conventionally known materials and configurations can be applied that are commonly used in organic photodetector elements. Examples of the materials used for the wiring section 120, the current collecting section 110, and the dummy pattern section 130 include: metals such as gold, silver, copper, aluminum, and molybdenum; metal laminates such as molybdenum/aluminum/molybdenum; and metal alloys of these.

The second conductive pattern, the third conductive pattern, and the dummy pattern sections 130 may use the same constituent materials, structure, and adjustment range of the design as the conductive pattern 24P of the [metal grid transparent electrode 20]. In addition, for the purpose of simplifying the manufacturing process, the second conductive pattern, the third conductive pattern, and the dummy pattern sections 130 are preferably formed all together with the conductive pattern 24P by the above-described [Method of manufacturing metal grid transparent electrode 20]. In addition, from the viewpoint of preventing decrease in external quantum efficiency due to a voltage drop in the current collecting section 110, the above-described metal, metal laminate, or metal alloy may be further laminated on the third conductive pattern by vacuum deposition method, sputtering method, or the like.

[Pixel]

The pixel size of the organic photodetector array of the present embodiment is preferably 1 mm$^2$ or more and 25 mm$^2$ or less, more preferably 2 mm$^2$ or more and 21 mm$^2$ or less, still more preferably 4 mm$^2$ or more and 16 mm$^2$ or less, even more preferably 6 mm$^2$ or more and 13 mm$^2$ or less, and particularly preferably 7 mm$^2$ or more and 11 mm$^2$ or less. The pixel size being 1 mm$^2$ or more can increase the total effective sensor area within the pixel, and allows the photodetection current to tend to be larger. In contrast, the pixel size being 25 mm$^2$ or less can sufficiently increase the pixel density described later. This preferably provides a touchless user interface device using the organic photodetector array of the present embodiment with an operation feeling equivalent to that of a touch user interface device using a conventional touch panel.

The pixel density of the organic photodetector array of the present embodiment is preferably 2 ppi or more and 15 ppi or less, more preferably 3 ppi or more and 10 ppi or less, still more preferably 3.5 ppi or more and 9 ppi or less, even more preferably 3.8 ppi or more and 8 ppi or less, and particularly preferably 4 ppi or more and 7 ppi or less. The pixel density being 2 ppi or more can achieve a sufficiently smooth operation feeling in the touchless user interface device using the organic photodetector array of the present embodiment. The pixel density being 15 ppi or less can increase the pixel size, preferably allowing photodetection current to tend to be larger for the reasons described above. Note that ppi in the present description means pixel per inch.

The pixel density can be calculated with a known calculation method depending on the array pattern of the organic photodetector array. For example, in the case of the two-dimensional array pattern shown in Figure 7, the density may be simply calculated using the following expression.

[Expression 4]

$$(\text{Pixel density}) \ = \ \frac{\sqrt{1^2 + 1^2}}{\dfrac{\sqrt{P_{pixel-x}^2 + P_{pixel-y}^2}}{25.4}}$$

In the expression, $P_{Pixel-x}$ (mm) and $P_{Pixel-y}$ (mm) are pitches between pixels in the X-axis direction (the left-right direction in the paper plane) and the Y-axis direction (the up-down dimension in the paper plane), respectively. For example, when $P_{Pixel-x} = P_{Pixel-y} = 6.24$ (mm) in the organic photodetector array of Figure 7, the pixel density is approximately 4 ppi.

[3. Touchless user interface]

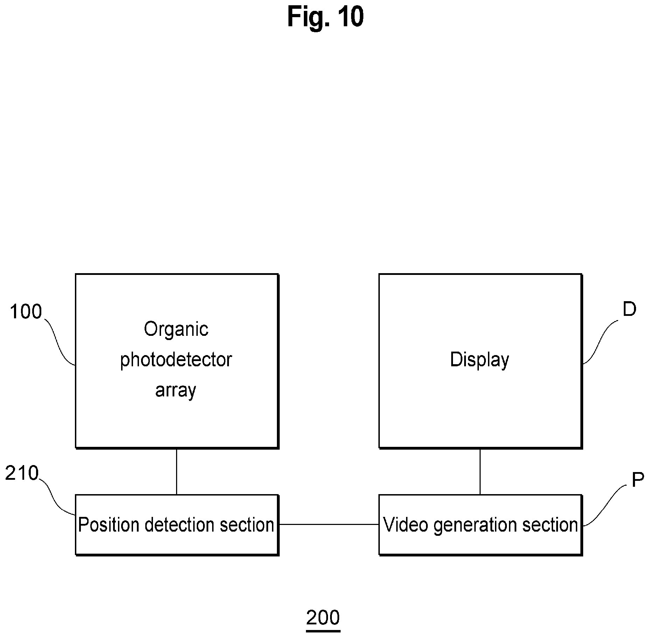

Figure 9 is a schematic diagram of a touchless user interface device (hereinafter sometimes referred to as a "UI device") according to the present embodiment. Figure 10 is a functional block diagram of the UI device 200. The UI device 200 includes an OPD array 100 provided on a display or a display body, and a position detection section 210 that is connected to the OPD array 100 and detects a position where an optical input signal is input based on an electrical output signal output from the OPD array 100. For example, the OPD array 100 may be attached to the display D or the screen of a display body (in Figure 9, both are shown apart from each other for description). When each pixel in the OPD array 100 is irradiated with incident light IL (optical input signal), the pixel converts the optical input signal into an electrical output signal and outputs the electrical output signal. Therefore, the position detection section 210 of the UI device 200 can receive the electrical output signal from a specific pixel, thereby detecting the position where the optical input signal is input (the position irradiated with the incident light IL).

Here, the display D corresponds to a part that displays an image of a display device such as an LCD device, an OLED devices, an electronic paper device, or an electrochromic display device. The display body corresponds to a part where an image is projected or displayed by a projector, etc. such as a wall surface, or a screen, as well as a display D.

The OPD array 100 is provided on such a display D or display body. Therefore, the user can view the image displayed on the display body through the OPD array. In addition, the user can cause incident light IL to be incident on a specific position of the image displayed on the display body, thereby causing the OPD array 100 to detect incident light IL and output it as an electrical output signal. Examples of a specific position in the video include: (1) the position where a menu icon is displayed; and (2) the position on a map displayed as an image.

The position detection section 210 of the UI device 200 can detect that a specific position on the image is irradiated with the incident light IL. For example, the position detection section 210 of the UI device 200 may include: a storage medium storing a computer program for receiving electrical output signals from the OPD array 100 in a non-volatile manner; and a processor (GPU, CPU, or other computing device) for executing this computer program. The processor of the position detection section 210 may be implemented by, for example, a processor (GPU, CPU, or other computing device) that constitutes a video generation section P included in the display device for generating a video signal. At this time, the processor may be configured to be able to receive an electrical output signal output from the OPD array 100 and generate a video signal to be displayed on the display D based on the electrical output signal. Examples of configuration include: (1) a configuration such that the processor can generate a video signal for displaying a detailed menu of a menu icon on a display based on incidence of incident light on the display position of the menu icon; and (2) a configuration such that the processor can generate a video signal of a zoomed map centered on a position, based on the incidence of incident light on the position of the map displayed as an image.

As described above, the OPD array 100 is provided on the display D or the display body. In addition, the OPD element 10 at the position irradiated with the optical input signal, which is the incident light IL, converts the optical input signal into an electrical output signal, thereby detecting the position irradiated with the optical input signal. This enables input operation with the screen of the display D or the display body.

[Optical input signal]

Here, it is preferable that the optical input signal include light having at least some wavelengths in the near-infrared wavelength region of 780 nm to 1200 nm. As described above, near-infrared light is invisible to the human eye. Therefore, even if a display body such as a display is irradiated with near-infrared light as an optical input signal, the visibility of the display body (the visibility of an image or the like displayed on the display body) is not impaired.

The light intensity of the optical input signal on the irradiation surface of the OPD elements 10 (for example, the lower surface of the transparent substrate 22 on which the incident light IL is incident) is not particularly limited, and can be, for example, $10^{-4}$ mW/cm$^2$ or more and 10 mW/cm$^2$ or less. The light intensity is more preferably $10^{-3}$ mW/cm$^2$ or more and 1 mW/cm$^2$ or less, and still more preferably $10^{-2}$ mW/cm$^2$ or more and 0.5 mW/cm$^2$ or less. The light intensity being $10^{-4}$ mW/cm$^2$ or more makes it easy to detect light with the organic photodetector elements of the present embodiment. In contrast, the light intensity being 10 mW/cm$^2$ or less causes the influence on the human body to tend to be further reduced.

Here, the optical input signal may be a signal having a predetermined frequency such as a pulse signal, a signal having phase fluctuation, a signal having amplitude fluctuation, or the like. For example, a configuration of modulating an optical signal having a constant output to a pulse signal for input makes it easy to extract the signal of detecting an optical input signal to be detected from all photodetection signals including disturbances such as natural light, indoor light, and light generated from a display body such as a display.

A known modulation method can be used for signal modulation, and examples thereof include, but are not limited to, frequency modulation, phase modulation, and amplitude modulation. The signal modulation is preferably frequency modulation. The modulated frequency is preferably 0.5 kHz or more and 20 kHz or less, more preferably 0.6 kHz or more and 10 kHz or less, still more preferably 0.7 kHz or more and 5 kHz or less, and particularly preferably 0.8 kHz or more and 3 kHz or less. The modulated frequency being 0.5 kHz or more makes it easy to extract a signal of detecting an optical input signal (for example, a continuous pulse signal consisting of a 1 kHz rectangular wave) from all photodetection signals including signals generated by detection of disturbances such as natural light, indoor light, and light emitted from a display body such as a display. In contrast, the modulated frequency being 20 kHz or less tends to be lower than the cutoff frequency determined by the capacitance of the organic photodetector elements of the present embodiment and the resistance of the wiring section 120. This preferably causes a signal of detecting an optical input signal to be extracted more easily. A known signal processing method can be used to extract a signal of detecting the signal-modulated optical input signal from all the photodetection signals. For example, in using a frequency-modulated optical input signal, a low pass filter, high pass filter, band pass filter, band elimination filter (band stop filter), lock-in amplifier, etc. can be used, or a combination of these can be used.

The UI device 200 may further include a light source LS such as a laser pointer shown in Figure 9(B) serving as pointing device PD for outputting an optical input signal. Here, the pointing device PD may be equipped with a modulation section for generating frequency-modulated signals, phase-modulated signals, or amplitude-modulated signals as described above. Since the OPD array can detect the position irradiated with an optical input signal by the pointing device PD, screen input operation is possible.

Alternatively, the UI device may be configured to be able to reflect the light output from the light source LS on a hand or finger serving as the pointing device PD, and detect the reflected light as an optical input signal. Here, the light source LS may be configured to be able to form a planar projection light beam (surface light source LS2) in a space. Figure 9(A) shows an embodiment in which a surface light source LS2 parallel to the display is formed in a space based on the light output from the point light source LS. The user can stick out his or her hand or finger serving as the pointing device PD to a predetermined position on the surface light source LS2. Since the light at the position through which the finger is stuck out is incident on the OPD array 100 as reflected light, the UI device 200 can detect the position irradiated with the optical input signal.

The UI device may include detection position identifying device for identifying the detection position based on a signal (electrical output signal) of detecting an optical input signal acquired from the OPD array. For such a detection position identifying device, conventionally known detection position identifying device mounted on a touch panel or the like can be used. For example, the detection position identifying device may be implemented by a computer program that executes computational processing and a processor that executes the computer program. The computational processing is a process of: calculating the signal centroid position in the X-axis direction (the left-right direction on the paper plane) and the signal centroid position in the Y-axis direction (the up-down direction on the paper plane) shown in Figure 7; and identifying the signal centroid position as the detection position. The computer program may also include instructions for executing some or all of the various computational processing described in the present embodiment. The computer program may be stored in a semiconductor device or other recording medium capable of recording information in a non-transitory manner. As well as the method of identifying the detection position based on the signal centroid, a method can be used in which the detection signal in the X-axis direction and the detection signal in the Y-axis direction in the figure are fitted with a Gaussian function, a Lorentz function, or the like, to calculate the peak position and identify the detection position.

Examples

Hereinafter, the present invention will be described more specifically using Examples and Comparative Examples. The present invention is not limited in any way by the following examples.

<<Example A>>

Hereinafter, optical properties and optical models of an organic photodetector element using a metal grid transparent electrode will be specifically described.

[Example A1]

<<Manufacture of metal grid transparent electrode>>

[Preparation of transparent substrate]

Alkali-free glass (manufactured by Corning Incorporated, product name: EAGLE XG, thickness 1.1 mm) was used as a transparent substrate.

[Ink]

The following were mixed and dispersed: cuprous oxide nanoparticles with a particle size of 21 nm, a dispersant (manufactured by BYK-Chemie GmbH, product name: Disperbyk-145), and a surfactant (manufactured by AGC Seimi Chemical Co., Ltd., product name: S-611). Thereby, an ink was prepared that contains 20% by mass of cuprous oxide nanoparticles.

[Manufacture of metal grid transparent electrode 20]

The ink was first applied to the surface of a transfer medium, and the ink-applied surface of the transfer medium was then placed to face a plate having conductive pattern grooves, and they were pressed together and brought into contact with each other. Thereby, part of the ink on the surface of the transfer medium was transferred onto the raised surface of the plate. Thereafter, the surface of the transfer medium coated with the remaining ink was placed to face a transparent substrate, and they were pressed together and brought into contact with each other, to transfer the ink in the desired conductive pattern onto the transparent substrate. Next, the film of the applied ink (film of the applied dispersion) in the conductive pattern on the transparent substrate was irradiated with 1.2 kW plasma for 496 seconds in a reducing atmosphere, to reduce the cuprous oxide, in the film of the applied dispersion, to copper. Then, through a firing process that forms a metal component sintered film of copper, a metal grid transparent electrode was obtained that has a mesh-patterned conductive pattern.

<<Evaluation of metal grid transparent electrode>>

[Measurement of line width, gap, and film thickness; and calculation of unit cell area and aperture rate]

For the obtained metal grid transparent electrode, the line width $W_{TCE}$ and film thickness $t_{TCE}$ of a metal wire of the conductive pattern, and the gap $G_{TCE}$ of the conductive pattern were measured using a planar photograph taken with a confocal laser microscope. Using these numerical values, the unit cell area $S_{TCE-unit}$ and the aperture rate $A_{TCE}$ of the conductive pattern were calculated. The results are shown in Table **1.**

[Calculation of visible light transmittance]

The visible light transmittance $VLT_{TCE}$ of the metal grid transparent electrode was calculated by multiplying the visible light transmittance of 92% of the transparent substrate by the aperture rate $A_{TCE}$ of the conductive pattern. The results are shown in Table 1.

[Table 1]

| | Metal grid TCE (Cathode) (Metal grid transparent electrode (Cathode)) | | | | | | | | Organic photoactive layer | | | | | | Organic photodetector (Organic photodetector element) | | |
|---|---|---|---|---|---|---|---|---|---|---|---|---|---|---|---|---|---|
| | $W_{TCE}$ ($\mu$m) | $G_{TCE}$ ($\mu$m) | $t_{TCE}$ (nm) | $A_{TCE}$ (%) | $G_{TCE} \cdot A_{TCE}$ ($\mu$m·%) | $S_{TCE\text{-}unit}$ ($\mu$m$^2$) | $R_{s\text{-}TCE}$ ($\Omega$/sq.) | $VLT_{TCE\text{-}a)}$ (%) | Structure | $t_{OPD}$ (nm) | $S_{su\text{-}bOPD}$ ($\mu$m$^2$) | $S_{sub\text{-}sensor}$ ($\mu$m$^2$) | $P_{su\text{-}bOPD}$ ($\mu$m) | $\Gamma_{subOPD}$ (%) | $S_{Sub\text{-}sensor}/S_{TCE\text{-}unit}$ (a.u.) | $(t_{OPD}\text{-}t_{TCE})$ (nm) | Visual light transmittance (%) |
| Example A1 | 1.2 | 8.6 | 73 | 77 | 6.62 | 96 | 29 | 71 | Subpixel array | 300 | 3600 | 2500 | 240 | 6.25 | 26 | 227 | 64 |
| Comparative example A1 | 1.3 | 8.6 | 71 | 75 | 6.49 | 98 | 29 | 69 | Solid film | 300 | - | - | - | - | - | 229 | 17 |
| a) Calculated value by $A_{TCE}$ multiplied by substrate's visual light transmittance (92%) | | | | | | | | | | | | | | | | | |

[Measurement of sheet resistance]

The sheet resistance of the conductive pattern of the metal grid transparent electrode was calculated using the conductivity of the metal wire, the film thickness $t_{TCE}$, and the aperture rate $A_{TCE}$. The conductivity of the metal wire was calculated by the following method. First, the sheet resistance of a test area consisting of a conductive pattern formed simultaneously with a metal grid transparent electrode was measured using Loresta GP (product name, manufactured by Mitsubishi Chemical Corporation). Next, the conductivity of the metal wire was calculated from the obtained sheet resistance using the film thickness and aperture rate measured from a planar photograph of the conductive pattern in the test area taken with a confocal laser microscope. Table 1 shows the results of the calculated sheet resistance of the metal grid transparent electrode.

<<Manufacture of organic photodetector element>>

[Formation of electron transport layer]

A film of a-IGZO (film thickness: 16 nm) was formed as an electron transport layer on the metal grid transparent electrode by sputtering method. Next, the a-IGZO was patterned by photolithography and wet etching to remove the unnecessary portions of the a-IGZO.

[Formation of insulating layer]

Next, an insulating layer (film thickness: 1.8 $\mu$m) with aperture sections OP, which correspond to sub-sensor areas described later, was formed by: application of SU-8 as an insulating layer through spin coating; soft-bake; patterning exposure; and development.

[Film formation of solid film of organic photoactive layer]

Per 1 mL of chlorobenzene serving as a solvent, 8 mg of PTB7-Th (alias PCE-10, $E_g^{opt}$ = 1.60 eV, HOMO = -5.20 eV, LUMO = -3.59 eV) was dissolved as an organic donor material, and 12 mg of IEICO-4F ($E_g^{opt}$ = 1.24 eV, HOMO=-5.44 eV, LUMO=-4.19 eV) was dissolved as an organic acceptor material. Next, 40 $\mu$L of chloronaphthalene was added per 1 mL of chlorobenzene, which is the solvent, to prepare an ink for forming an organic photoactive layer. The obtained ink for forming an organic photoactive layer was formed into a film by wet film forming through spin coating, dried at room temperature, and annealed at 60°C for 20 minutes, and thereby a solid film of an organic photoactive layer was formed that has a bulk heterojunction structure with a dry film thickness $t_{OPD}$ of 300 nm.

[Formation of subpixels and subpixel array]

Next, using a known photolithography patterning technique for organic semiconductor materials as described in Non Patent Literature 3, etc., the solid film of the obtained organic photoactive layer was patterned into a subpixel array with a pattern structure in which substantially square subpixels were arrayed two-dimensionally at equal intervals along the orthogonal coordinate axes of the X-axis and Y-axis. The design of the formed subpixel array is as follows.

<Design of organic photodetector element>

(X-axis direction, Y-axis direction)

- Subpixel: 60 $\mu$m × 60 $\mu$m, $S_{subOPD}$: 3600 $\mu$m$^2$
- Sub-sensor area: 50 $\mu$m × 50 $\mu$m, $S_{sub-sensor}$: 2500 $\mu$m$^2$
- Pattern pitch $P_{subOPD}$: 240 $\mu$m × 240 $\mu$m
- Area occupation rate of subpixel within pattern unit $\Gamma_{subOPD}$: 6.25%

[Formation of hole transport layer and anode]

A film of MoO$_x$ (film thickness: 60 nm) was formed as a hole transport layer over the entire organic photodetector element by vacuum deposition method. Next, as a transparent electrode for the anode, ITO (film thickness: 100 nm, sheet resistance: 40 Q/sq.) was formed into a film by sputtering method so as to be laminated on the hole transport layer.

[Formation of encapsulation layer]

Finally, as an encapsulation layer, a barrier laminate film (total film thickness: 160 $\mu$m) was used in which a known thin film encapsulation as described in Non Patent Literature 2, etc. and an adhesive layer having gas barrier properties are laminated sequentially on a PET film (125 $\mu$m, Melinex® ST504™). Barrier laminate film was laminated so that the adhesive layer was in contact with the anode, and laminated by pressing to seal the organic photodetector element.

<<Evaluation of optical properties of organic photodetector element>>

The visible light transmittance of the organic photodetector element was calculated with the following method. The light transmission spectrum of an organic photodetector element was measured using an ultraviolet/visible light/near-infrared spectrometer (UV-vis-NIR spectroscopy, Cary 5000 manufactured by Agilent Technologies Inc.). The visible light transmittance was calculated from the acquired light transmission spectrum in accordance with JIS R 3106: 2019 or ISO9050: 2003. The results are shown in Table 1.

[Comparative example A1]

[Formation of subpixels and subpixel array] in Example A1 was not performed, and an organic photoactive layer in a solid film was used. Other than that, a metal grid transparent electrode and an organic photodetector element using the same were produced and evaluated by the same operation as in Example A1. The results are shown in Table 1.

Example A1 and Comparative Example A1 show the following: a subpixel array structure of the organic photoactive layers, in which the subpixels in island geometry or two or more of the subpixels are arrayed, causes visible light to highly efficiently pass through the portions where subpixels are not formed even if used near-infrared detection type organic photoactive layers have a low visible light transmittance; and this improves visible light transmittance of the organic photodetector element as a whole. Specifically, the subpixel portions of Example A1 have a visible light transmittance of about 17%, which is the same as Comparative Example A1, in the laminating direction of the organic photodetector element. In Example A1, adjusting the area occupation rate $\Gamma_{subOPD}$ of the subpixel portion to 6.25% improved the visible light transmittance to 64%.

<<Optical model of light transmission spectrum of organic photodetector element>>

The light transmission spectrum T($\lambda$) of an organic photodetector element, which uses a metal grid transparent electrode as a cathode and includes subpixels (or subpixel array) of an organic photoactive layers, is modeled by the following expression.

[Expression 5]

$$T(\lambda) = \left\{ \Gamma_{subOPD} \cdot T_{OPD}(\lambda) + (1 - \Gamma_{subOPD}) \cdot T_{open}(\lambda) \right\} \times \left\{ (1 - A_{TCE}) \cdot T_{Cu}(\lambda) + A_{TCE} \right\}$$

In the expression, $T_{OPD}(\lambda)$ is a light transmission spectrum of a multilayer body of transparent substrate/electron transport layer/organic photoactive layer/hole transport layer/anode/encapsulation layer made of the above-described materials and configuration, and is a modeled light transmission spectrum of the subpixel portion excluding the conductive pattern in the laminating direction of the organic photodetector element. Similarly, $T_{OPEN}(\lambda)$ is a light transmission spectrum of a multilayer body of the transparent substrate/electron transport layer/insulating layer/hole transport layer/anode/encapsulation layer made of the above-described materials and configuration, and is a modeled light transmission spectrum of the portion where no subpixels are formed excluding the conductive pattern in the laminating direction of the organic photodetector element. $T_{Cu}(\lambda)$ is the light transmission spectrum of a metal wire itself. $T_{OPD}(\lambda)$ and $T_{OPEN}(\lambda)$ were simulated by an optical calculation technique based on transfer matrix formalism, using Setfos, which is an optoelectronic electrical properties and optical properties simulator software, manufactured by FLUXiM AG. For the used input parameters for the optical simulation were: the wavelength dependence of the optical constants (refractive index: n, extinction coefficient: k) of the constituent materials of each layer measured by spectroscopic ellipsometry; and the above-described film thickness. $T_{Cu}(\lambda)$ is optically simulated by the same technique for a model of a laminated structure simulating the distribution of copper and cuprous oxide, and the distribution of voids in the metal wire. The visible light transmittance was calculated from the calculated light transmission spectrum in accordance with JIS R 3106: 2019 or ISO9050: 2003. The visible light transmittances were 22% in $T_{OPD}(\lambda)$, 80% in $T_{OPEN}(\lambda)$, and 10% in $T_{Cu}(\lambda)$.

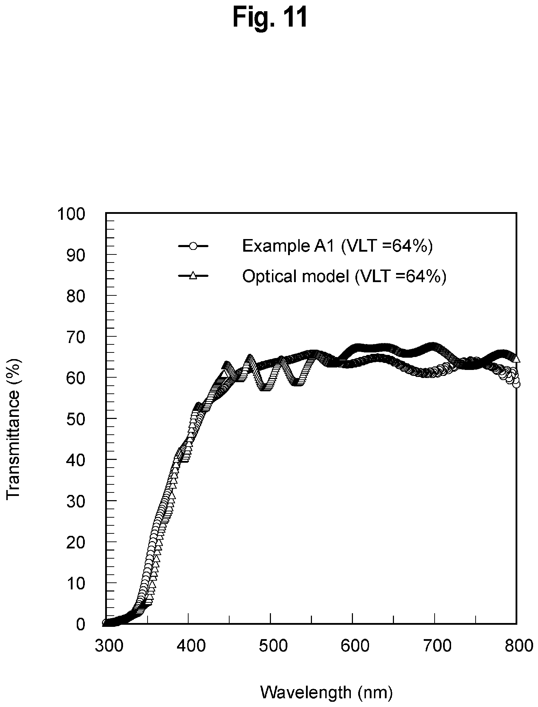

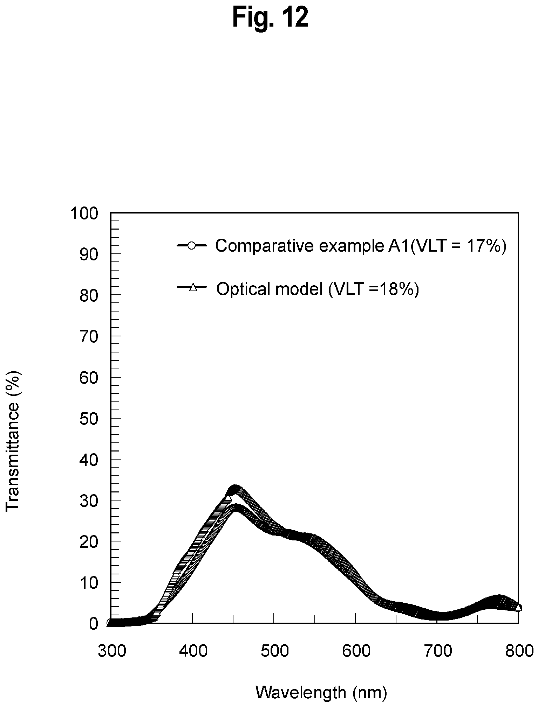

Figure 11 shows a comparison between the light transmission spectrum of the organic photodetector element of Example A1 and the light transmission spectrum calculated using the optical model described above. Figure 11 shows that the optical model can reproduce the light transmission spectrum of the organic photodetector element of the present invention represented by Example A1. The visible light transmittance calculated from the light transmission spectrum based on the optical model was 64%, which was close to the actually measured value (64%) of Example A1. In addition, Comparative Example A1 can be similarly modeled by setting $\Gamma_{subOPD}$ to 100%. Figure 12 shows a comparison of the light transmission spectra of Comparative Example A1 and a model of this. Figure 12 shows that the optical model can reproduce actually measured light transmission spectrum also for Comparative Example A1. Furthermore, the visible light transmittance (18%) calculated from this optical model was also close to the actually measured value (17%) of Comparative Example A1.

<<Example B>>

Hereinafter, the electrical properties of an organic photodetector element using a metal grid transparent electrode will be specifically described.

[Example B1]

The line width $W_{TCE}$ and gap $G_{TCE}$ in the conductive pattern of a metal grid transparent electrode were changed as shown in Table 2 by changing the groove pattern of the plate to be used in the pattern forming step. In addition, the firing process for the metal grid transparent electrode was changed to irradiation with 1.2 kW plasma for 540 seconds. In addition, [Film formation of solid film of an organic photoactive layer] was changed so that slot die coating was used instead of spin coating, and the drying and annealing steps were performed all together at 60°C for 5 minutes. Furthermore, the design in [Formation of subpixel and subpixel array] of Example A1 was changed as follows. Other than that, a metal grid transparent electrode and an organic photodetector element using the same were produced by the same operation as in Example A1.

<Design of organic photodetector element>

(X-axis direction, Y-axis direction)

- Subpixel: 70 $\mu$m $\times$ 70 $\mu$m, $S_{subOPD}$: 4900 $\mu$m$^2$
- Sub-sensor area: 50 $\mu$m $\times$ 50 $\mu$m, $S_{sub-sensor}$: 2500 $\mu$m$^2$
- Pattern pitch $P_{subOPD}$: 240 $\mu$m $\times$ 240 $\mu$m
- Number of subpixels $N_{subOPD}$: 9 $\times$ 9, 81 in total
- Area occupation rate of subpixel within pattern unit $\Gamma_{subOPD}$: 8.5%
- Total effective sensor area $S_{total-sensor}$: 0.2025mm$^2$
- Pixel size: 1.99 mm $\times$ 1.99 mm, approximately 4.0 mm$^2$

The metal grid transparent electrode was evaluated in the same manner as in Example A1. The results are shown in Table 2.

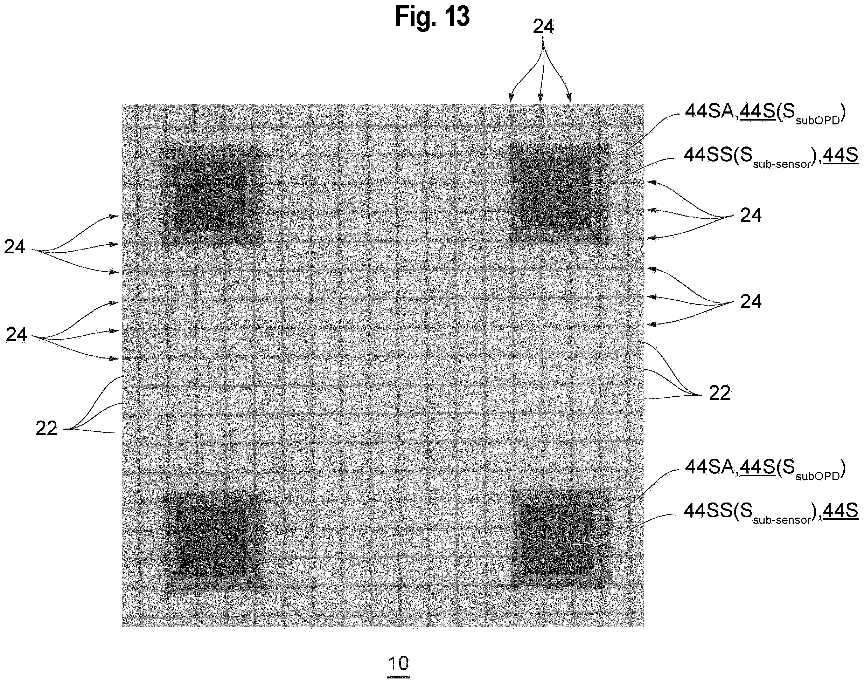

An optical microscope image of the organic photodetector element of Example B1 is shown in Figure 13 (here, the configurations having the same functions as those in other embodiments are denoted by the same reference numerals and characters and detailed description is omitted).

<<Properties evaluation of organic photodetector element>>

[Evaluation of current density-voltage characteristics (J-V characteristics)]

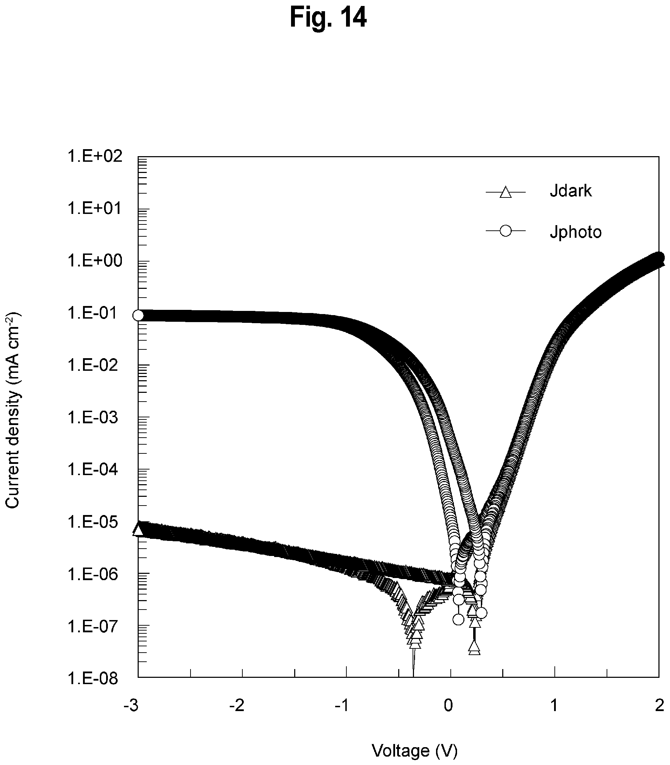

The current density-voltage characteristics were evaluated at room temperature in a glove box with a nitrogen atmosphere. First, an external terminal from a semiconductor parameter analyzer (Agilent 4155C) was connected to the current collecting section electrically connected to each of the cathode and anode of the organic photodetector element. Next, the voltage was swept from -3 V to +2 V at a scanning rate of 5 mV/s, and the current of the organic photodetector element was measured. The current density was calculated by dividing the last measured current by the total effective sensor area $S_{total-sensor}$. The dark current density ($J_{dark}$)-voltage (V) characteristics were measured by performing the above operation in a dark room. The photocurrent density ($J_{photo}$)-V characteristics were measured by performing the above operation in a dark room while irradiating the organic photodetector element with an optical input signal having a wavelength ($\lambda$) of 850 nm and a light intensity ($I_P$) of approximately 0.30 mW/cm$^2$ on the irradiation surface of the organic photodetector element. Figure 14 shows the $J_{dark}$-V characteristics and the $J_{photo}$-V characteristics. Table 2 summarizes the dark current density when the applied voltage is -2 V.

[Characteristics evaluation of external quantum efficiency (EQE)]

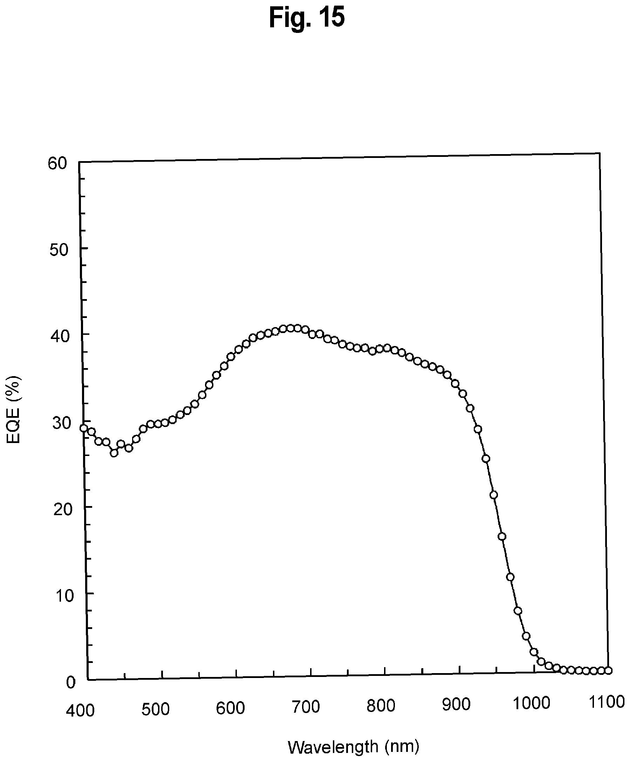

External quantum efficiency was measured using a custom-made setup device formed of the following. Configuration: tungsten halogen lamp, monochromator (Oriel, Cornerstone 130), preamplifier (Stanford Research Systems SR570), and lock-in amplifier (Stanford Research Systems SR830 DSP). Measurements were performed with the organic photodetector element set in a box sealed with a quartz window and a nitrogen atmosphere. The photodetection current was measured by irradiating the organic photodetector element with an optical input signal through a circular aperture section having a diameter of 1 mm while sweeping the wavelength of the optical input signal from 300 nm to 1100 nm in 10 nm increments with a voltage of -2V applied to the organic photodetector element. The external quantum efficiency of the organic photodetector element at each wavelength was calculated by converting the photocurrent density calculated by dividing the measured photodetection current by the total effective sensor area of the subpixel array in the irradiation area, to the external quantum efficiency, based on the calibration curve of an Si photodiode for calibration measured under the same conditions. Figure 15 shows the wavelength ($\lambda$) dependence of external quantum efficiency (EQE) at the applied voltage of -2V.

[Evaluation of responsiveness to light intensity ($I_p$)]

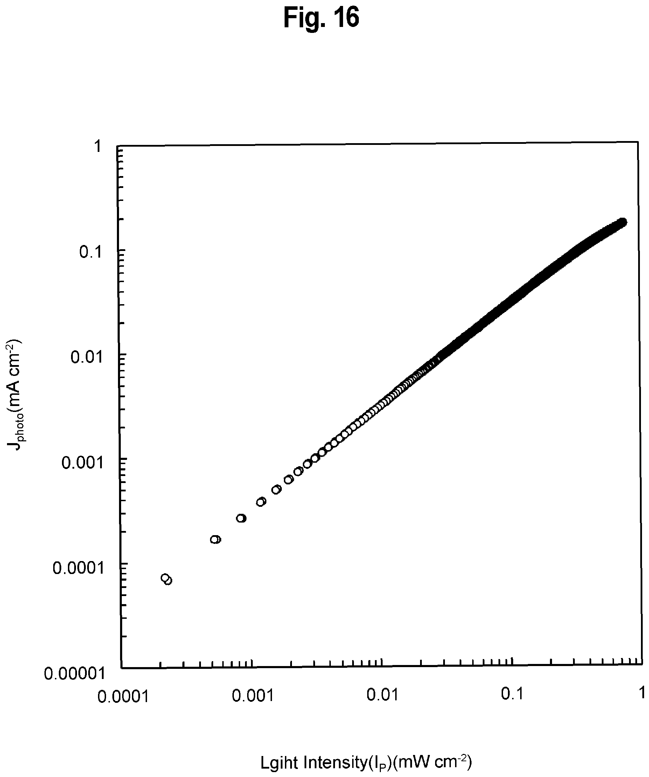

The light intensity ($I_P$) dependence of the photocurrent density ($J_{photo}$) of the organic photodetector element was measured by using a device similar to the current density-voltage characteristics measurement, and sweeping the light intensity ($I_P$) on the irradiation surface of the organic photodetector element from $2 \times 10^{-4}$ mW/cm$^2$ to $7.5 \times 10^{-1}$ mW/cm$^2$ under the same environment. Note that the wavelength of the optical input signal was 850 nm, and the voltage applied to the organic photodetector element was -2V. Figure 16 shows a graph of light intensity ($I_P$)-photocurrent density ($J_{photo}$).

[Calculation of visible light transmittance]

Based on the above-described optical model, the visible light transmittance of the organic photodetector element was calculated using the parameters listed in Table 2. The results are shown in Table 2.

[Table 2]

| | Metal grid TCE (Cathode) (Metal grid transparent electrode (Cathode)) | | | | | | | | Organic photoactive layer | | | | | | | | Organic photodetector (Organic photodetector element) | | | | |
|---|---|---|---|---|---|---|---|---|---|---|---|---|---|---|---|---|---|---|---|---|---|
| | $W_{TCE}$ ($\mu$m) | $G_{TCE}$ ($\mu$m) | $t_{TCE}$ (nm) | $A_{TCE}$ (%) | $G_{TCE} \cdot A_{TCE}$ ($\mu$m·%) | $S_{TCE-unit}$ ($\mu m^2$) | $R_{s-TCE}$ ($\Omega$/sq.) | $VLT_{TCE}$ a) (%) | Structure | $t_{OPD}$ (nm) | $S_{subOPD}$ ($\mu m^2$) | $S_{sub-sensor}$ ($\mu m^2$) | $P_{subOPD}$ ($\mu$m) | $\Gamma_{subOPD}$ (%) | $N_{subOPD}$ (unit) | $S_{total-sensor}$ ($mm^2$) | $S_{Sub-sensor}/S_{TCE-unit}$ (a.u.) | ($t_{OPD-TCE}$) (nm) | $J_{dark}$ at -2V (mA/cm$^2$) | EQE at -2V, 850 nm b) (%) | Visual light transmittance b) (%) |
| Example B1 | 1.0 | 19.0 | 102 | 90 | 17.12 | 403 | 52 | 83 | Subpixel array | 300 | 4900 | 2500 | 240 | 8.5 | 81 | 0.2025 | 6 | 198 | $3.7 \times 10^{-6}$ | 36 | 69 |
| Example B2 | 1.0 | 9.0 | 120 | 81 | 7.25 | 100 | 22 | 74 | Subpixel array | 300 | 4900 | 2500 | 240 | 8.5 | 81 | 0.2025 | 25 | 180 | $4.5 \times 10^{-6}$ | 37 | 62 |
| Example B3 | 1.9 | 18.1 | 102 | 82 | 14.93 | 399 | 29 | 76 | Subpixel array | 300 | 4900 | 2500 | 240 | 8.5 | 81 | 0.2025 | 6 | 198 | $1.1 \times 10^{-6}$ | 33 | 63 |
| Example B4 | 1.9 | 38.1 | 94 | 91 | 34.57 | 1594 | 62 | 84 | Subpixel array | 300 | 4900 | 2500 | 240 | 8.5 | 81 | 0.2025 | 2 | 206 | $1.9 \times 10^{-6}$ | 23 | 69 |

a) Calculated value by $A_{TCE}$ multiplied by substrate's visual light transmittance (92%) b) Simulated value using the optical model.

[Example B2 to B4]

The line width $W_{TCE}$ and gap $G_{TCE}$ in the conductive pattern of a metal grid transparent electrode were changed as shown in Table 2 by changing the groove pattern of the plate to be used in the pattern forming step. Other than that, the metal grid transparent electrode and the organic photodetector element using the same were produced through the same operation as in Example B1, and were evaluated.

As shown in Figure 13, in the projection view from an upper surface, a region provided with a sub-sensor area 44SS overlaps a region provided with at least one metal wire 24, at least in part. In other words, the sub-sensor area 44SS is formed on at least part of at least one (for example, two, or three or more) metal wire 24. The at least one (for example, two, or three or more) metal wire 24 extends so as to intersect two different sides of the sub-sensor area 44SS. Furthermore, the at least one (for example, two, or three or more) metal wire 24 extends so as to intersect two different sides of the first sub-sensor area 44SS, and extends so as to intersect two different sides of the second sub-sensor area 44SS.

In addition, in Figure 13, at least one (for example, two, or three or more) second metal wire 24 extending in a direction different from a first metal wires 24 (for example, perpendicular direction) has the same relationship as that of the first metal wires 24.

Therefore, in the projection view projected from an upper surface, a region provided with a sub-sensor area 44SS overlaps a region provided with at least one first metal wire 24, at least in part. In addition, the region provided with the same sub-sensor area 44SS overlaps a region provided with at least one second metal wire 24 extending in a direction different from that of the first metal wire 24, at least in part.

As described above, Figure 13 shows that a sub-sensor area 44SS is provided on at least one metal wire 24 of the metal wires that extend in the same direction, in at least one direction, within the conductive pattern 24P and face each other in a direction substantially perpendicular to the extending direction. The organic photodetector elements of Examples B1 to B4 each have a $S_{sub\text{-}sensor}/S_{TCE\text{-}unit}$ of 2 to 25, which is 1 or more. As a result, a sub-sensor area 44SS is provided so that its part overlaps a metal wire 24 even if the relative positions of the conductive pattern 24P and the subpixel 44S change in the lamination process. It can be seen that this configuration provides a high external quantum efficiency of 15% or more in at least some wavelengths in the near-infrared wavelength region of 780 nm to 1200 nm (see Table 2 and Figure 15). Furthermore, as shown in Table 2, it can be seen that these organic photodetector elements exhibit an extremely low dark current density of $10^{-5}$ mA/cm$^2$ or less. In addition, the organic photodetector elements of Examples B1 to B4 exhibit high visible light transmittance of 60% or more.

The above shows that the organic photodetector element of the present invention can exhibit high light detectivity due to its high external quantum efficiency and extremely low dark current density while exhibiting high visible light transmittance (see Table 2 and Figure 14).

Furthermore, Figure 16 shows that the organic photodetector element of Example B1 has the photodetection current linearly responding in a wide light intensity range from $10^{-4}$ mW/cm$^2$ to 1 mW/cm$^2$.

<<Example C>>

Hereinafter, a suitable range of design of a metal grid transparent electrode will be specifically described, in which the design is for improving the external quantum efficiency (EQE) of an organic photodetector element using a metal grid transparent electrode.

<<Simulation of external quantum efficiency (EQE)>> [Simulation]

Simulation was performed on an organic photodetector element using a metal grid transparent electrode, using two types of software: Setfos that is optoelectronic electrical and optical properties simulator software manufactured by FLUXiM AG, and LAOSS that is large-area organic semiconductor simulator software manufactured by FLUXiM AG.

Setfos is software that: uses optical properties (particularly light absorption properties) of an organic photodetector element in a multilayer body, simulated based on a transfer matrix formalism, to calculate a carrier distribution of electrons and holes generated by photoexcitation; simulates a charge transport process of the electrons and holes based on a drift-diffusion mathematical model; and thereby simulates the electrical properties of the organic photodetector element, such as photocurrent density.

Using Setfos, two multilayer bodies of organic photodetector element was modeled, in which one multilayer body is provided on the metal wires and the other is provided on an aperture section of the conductive pattern. Then, $J_{photo}$-V characteristics was simulated for each of the multilayer bodies. The multilayer body on the metal wires consists of a transparent substrate/metal wire/electron transport layer/organic photoactive layer/hole transport layer/anode/encapsulation layer. The multilayer body on the aperture section consists of a transparent substrate/artificial completely transparent electrode/electron transport layer/organic photoactive layer/hole transport layer/anode/encapsulation layer.

Here, the artificial completely transparent electrode is an artificial electrode that does not absorb light and is incorporated for the Setfos calculation program. For input parameters for the optical properties simulation, the following were used: the wavelength dependence of the optical constants (refractive index: n, extinction coefficient: k); and film thickness, each used in <<Optical model of light transmission spectrum of organic photodetector element>>. In addition, input parameters for the electrical properties simulation, such as the mobility and energy level of electrons and holes in each layer, were set with reference to literature values.

Next, the surface potential distribution and current density distribution of the electron transport layer/metal grid transparent electrode were calculated by two-dimensional finite element modeling (2D FEM) using LAOSS. Specifically, the differential equation expressing the relationship of local current densities and voltage drops was calculated until it converged for the whole system, and the surface potential distribution and current density distribution were calculated. The local current densities were calculated based on the surface potential of each element and the $J_{photo}$-V characteristics calculated by Setfos. The voltage drops follow Ohm's law in a process in which each local current density diffuses in the planar direction of the electron transport layer/metal grid transparent electrode. The current density $J_s(\lambda)$ of the whole system was calculated from the current density distribution, and the external quantum efficiency (EQE) was calculated with the following expression.

[Expression 6]

$$EQE(\lambda) = \frac{J_s(\lambda)}{I_P(\lambda)} \cdot \frac{\hbar c}{\lambda q}$$

In the expression, $\lambda$ is the wavelength of light, and $I_P(\lambda)$ is the light intensity. For the light intensity, 1.05 mW/cm$^2$ was used. Furthermore, q is the elementary charge, h is Planck's constant, and c is the speed of light.

The input parameters of the 2D FEM were determined as the following to simulate Example B1.

- Conductive pattern setting: mesh pattern, $W_{TCE}$ 1 $\mu$m, $G_{TCE}$ 19 $\mu$m
- Sheet resistance of metal wiring section of metal grid transparent electrode: 2.6 $\Omega$/sq.
- Sheet resistance of electron transport layer: 35 $\times$ 10$^9$ $\Omega$/sq.
- Applied voltage: -2 V

[Comparison of simulation and actually measured value]

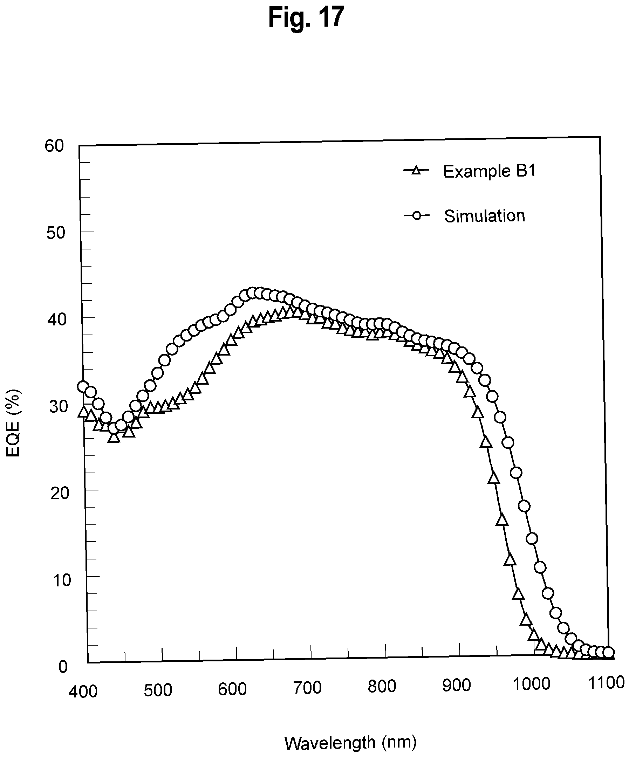

Figure 17 shows a comparison between the simulated external quantum efficiency (EQE) and the actual measurement (Example B1). It was confirmed that the actually measured external quantum efficiency was able to be reproduced by simulation.

[Design optimization of metal grid transparent electrode by simulation]

Using this simulation, the external quantum efficiency (EQE) was calculated through simulation in which the line width $W_{TCE}$ of the metal wire was varied from 0.5 $\mu$m to 10 $\mu$m, and the gap $G_{TCE}$ of the conductive pattern is varied within the range of ($G_{TCE}/W_{TCE}$) of 1.0 or more and ($W_{TCE}+G_{TCE}$) of 80 $\mu$m or less. Figure 4 shows the gap $G_{TCE}$ dependence of the simulated external quantum efficiency (EQE) at each line width. Similarly, Figure 5 shows the ($G_{TCE}/W_{TCE}$) dependence of the simulated external quantum efficiency (EQE) at each line width. Similarly, Figure 6 shows the ($G_{TCE}\cdot A_{TCE}$) dependence of the simulated external quantum efficiency (EQE) at each line width.

Figures 4 and 5 shows that the external quantum efficiency (EQE) of an organic photodetector element using a metal grid transparent electrode can be improved by: adjusting the line width $W_{TCE}$ of the metal wire of the metal grid transparent electrode to 0.5 $\mu$m or more and 5.0 $\mu$m or less; while adjusting ($G_{TCE}/W_{TCE}$) to 1.0 or more and adjusting $G_{TCE}$ to 45 $\mu$m or less when the gap of the conductive pattern is $G_{TCE}$. Furthermore, Figure 6 shows that the external quantum efficiency (EQE) of an organic photodetector element using a metal grid transparent electrode can be further improved by adjusting ($G_{TCE}\cdot A_{TCE}$) to 0.25 $\mu$m·% or more and 45 $\mu$m·% or less when the aperture rate of the conductive pattern is $A_{TCE}$. This presumably shows that: the external quantum efficiency (EQE) of the organic photodetector element can be improved for the following reason: reduction in the diffusion distance ($G_{TCE}$) of electrons in the in-plane direction in the electron transport layer, which electrons are generated in the organic photoactive layer provided on the aperture section of the conductive pattern, uniformizes the surface potential distribution and improves the charge collection efficiency $\eta_{cc}$; while reduction in the $W_{TCE}$ of the metal wire and increase in the aperture rate ($A_{TCE}$) prevent the shadowing effect of the metal wire, which improves the efficiency of taking light into the organic photoactive layer.

<<Example D>>

Hereinafter, an organic photodetector array including organic photodetector elements each using a metal grid transparent electrode and a touchless user interface device using the same will be specifically described.

[Example D]

Based on the results of Examples B and C, a metal grid transparent electrode design similar to Example B1 was implemented in an organic photodetector array. In addition, the organic photodetector array had a structure that includes a pattern in which: the pixels, each of which consists of an organic photodetector element described below, are arrayed two-dimensionally at equal intervals along the orthogonal coordinate axes; and the number of the pixels is 16 in the X-axis direction, 16 in the Y-axis direction, and 256 in total.

<Design of organic photodetector element (pixel)>

(X-axis direction, Y-axis direction)

- Subpixel: 70 $\mu$m $\times$ 70 $\mu$m, $S_{subOPD}$: 4900 $\mu$m$^2$
- Sub-sensor area: 50 $\mu$m $\times$ 50 $\mu$m, $S_{sub\text{-}sensor}$: 2500 $\mu$m$^2$
- Pattern pitch $P_{subOPD}$: 240 $\mu$m $\times$ 240 $\mu$m
- Number of subpixels $N_{subOPD}$: 14 $\times$ 14, 196 in total
- Area occupation rate of subpixel within pattern unit $\Gamma_{subOPD}$: 8.5%
- Total effective sensor area $S_{total\text{-}sensor}$: 0.49 mm$^2$
- Pixel size: 3.19 mm $\times$ 3.19 mm, approximately 10.2 mm$^2$

<Design of organic photodetector array>

(X-axis direction, Y-axis direction)

- Sensor area: 96.77 mm $\times$ 96.77 mm,
- Pixel pitch: 6.24 mm $\times$ 6.24 mm
- Number of pixels: 16 $\times$ 16, 256 in total
- Pixel density: 4.2 ppi

<<Manufacture of metal grid transparent electrodes, wiring sections, current collecting sections, and dummy pattern sections>>

The metal grid transparent electrodes 20, the wiring sections 120, the current collecting sections 110, and the dummy pattern sections 130 were formed all together by the following printing and firing process. In order that each metal grid transparent electrode 20 provided for each pixel had the same line width $W_{TCE}$ and gap $G_{TCE}$ in the conductive pattern as in Example B1, a corresponding groove pattern was provided on the plate. In addition, in order that the wiring section 120 and the dummy pattern section 130 each had an aperture rate to be described later, a corresponding groove pattern was provided on the plate. Similarly, in order that each current collecting section 110 had an occupation area rate to be described later, a corresponding groove pattern was provided on the plate. Using the plate, the film of the applied ink (film of the applied dispersion) in the conductive patterns, which correspond to the metal grid transparent electrode 20, the wiring sections 120, the current collecting section 110, and the dummy pattern sections 130, was printed all together on a transparent substrate through the same operation of forming the pattern as in Example B1. Next, the conductive pattern 24P of the metal grid transparent electrode 20, the second conductive patterns of the wiring sections 120, the third conductive pattern of the current collecting section 110, and the dummy pattern sections 130 were manufactured through the same operation of firing process as in Example B1 except for irradiation with 1.2 kW plasma for 590 seconds in a reducing atmosphere. Note that the conductive patterns 24P, the second and third conductive patterns, and the dummy pattern sections were all mesh patterns.

Each wiring section and each current collecting section were structured to be electrically independently provided for the corresponding pixel. The second conductive pattern of each wiring section has a structure that electrically connects the conductive pattern 24P of the corresponding pixel and the third conductive pattern of corresponding current collecting section.

<<Evaluation of metal grid transparent electrode, wiring section, current collecting section, and dummy pattern section>>

Regarding the metal grid transparent electrode 20, the wiring section 120, the current collecting section 110, and the dummy pattern section 130, each gap in the conductive pattern 24P, the second to third conductive patterns, and the dummy pattern section, as well as the line width and film thickness of each metal wire were measured with representative planar photographs taken with a confocal laser microscope. Using these numerical values, the unit cell area $S_{TCE-unit}$ and the aperture rate $A_{TCE}$ of the conductive pattern 24P were calculated. The results are shown in Table 3.

[Table 3]

| | Metal grid TCE (Cathode) (Metal grid transparent electrode (Cathode)) | | | | | | | | Organic photoactive layer | | | | | | | | Organic photodetector (Organic photodetector element) | | | | |
|---|---|---|---|---|---|---|---|---|---|---|---|---|---|---|---|---|---|---|---|---|---|
| | $W_{T\text{-}CE}$ ($\mu$m) | $G_{T\text{-}CE}$ ($\mu$m) | $t_{TC\text{-}E}$ (nm) | $A_{T\text{-}CE}$ (%) | $G_{TCE}\cdot A_{TCE}$ ($\mu$m$\cdot$%) | $S_{TCE\text{-}unit}$ ($\mu$m$^2$) | $R_{s\text{-}TCE}$ ($\Omega$/sq.) | $VLT_{TC\text{-}E}$ a) (%) | Structure | tOPD (nm) | $S_{su\text{-}bOPD}$ ($\mu$m$^2$) | Ssubsensor ($\mu$m$^2$) | $P_{su\text{-}bOPD}$ ($\mu$m) | $\Gamma_{subOPD}$ (%) | $N_{su\text{-}bOPD}$ (unit) | $S_{total\text{-}sensor}$ (mm$^2$) | $S_{Sub\text{-}sensor}/S_{TCE\text{-}unit}$ (a.u.) | $(t_{OPD}\text{-}t_{TC\text{-}E})$ (nm) | $J_{dark}$ at -2V (mA/cm$^2$) | EQE at -2V, 850 nm (%) | Visual light transmittance b) (%) |
| Example D | 1.3 | 18.7 | 90 | 87 | 16.35 | 400 | 45 | 80 | Subpixel array | 300 | 4900 | 2500 | 240 | 8.5 | 196 | 0.49 | 6 | 210 | $3.6\times10^{-6}$ | 48% | 67 |

a) Calculated value by $A_{TCE}$ multiplied by substrate's visual light transmittance (92%) b) Simulated value using the optical model.

Furthermore, for the second conductive pattern and the dummy pattern section, the respective aperture rates $A_{wire}$ and $A_{dummy}$ were calculated using these numerical values. The results are shown below.

<Wiring section (second conductive pattern)>

- Line width: 1 $\mu$m
- Gap: 15 $\mu$m
- Aperture rate $A_{wire}$: 88%

<Dummy pattern section>

- Line width: 1 $\mu$m
- Gap: 15 $\mu$m to 19 $\mu$m
- Aperture rate $A_{wire}$: 88% to 90%

As shown in Table 3, the aperture rate $A_{TCE}$ of the conductive pattern of Example D was 87%. Therefore, both $A_{wire}$ and $A_{dummy}$ were within $\pm 10\%$ of $A_{TCE}$. As a result, the visible light transmittances of areas other than the pixels were adjusted to about the same level as that of the pixels, and the visibility was uniformized.

Furthermore, for the third conductive pattern, the occupation area rate $\Gamma_{pad}$ was calculated using these numerical values. The results are shown below.

<Current collecting section (third conductive pattern)>

- Line width: 5 $\mu$m
- Gap: 10 $\mu$m
- Occupation area rate $\Gamma_{pad}$: 55.6%

<<Manufacture of organic photodetector array>>

The electron transport layer and the insulating layer were sequentially formed on the obtained metal grid transparent electrode though the same operation as in Example B1. The aperture sections OP of the insulating layer on the metal grid transparent electrode were patterned and formed for each pixel so as to correspond to the sub-sensor area of the above-described <Design of organic photodetector element (pixel)>. Next, through the same operation as in Example B1, a solid film of an organic photoactive layer was formed over the entire surface of the organic photodetector array by slot die coating using the ink for forming an organic photoactive layer. Thereafter, the organic photoactive layer was patterned to form a subpixel array for each pixel through the same operation as in Example B1 except for change so as to follow the above-described <Design of organic photodetector element (pixel)> in [Formation of subpixels and subpixel array] of Example B1. When the organic photoactive layer was patterned, a dummy subpixel array having the same design as the subpixel array was formed on the insulating layer in an area other than the pixels (so-called the area where the aperture section OP of the insulating layer is not provided) for the entire surface of the organic photodetector array. Since the dummy subpixel array is separated from the metal grid transparent electrode 20, the wiring section 120, and the dummy pattern section 130 by the insulating layer, the dummy subpixel array has a structure that does not function as an organic photodetector element. Through the same operation as in Example B1 except for that, an organic photodetector array was produced in which pixels consisting of organic photodetector elements were arranged two-dimensionally at equal intervals along orthogonal coordinate axes, and the number of the pixels is 16 in the X-axis direction and 16 in the Y-axis direction, and 256 in total, so as to follow <Design of organic photodetector array>.

<<Evaluation of organic photodetector array>>

A flexible printed circuit board was pressure-bonded to the current collecting section 110 of the organic photodetector array and connected to an external control circuit. Furthermore, the organic photodetector array and the external control circuit were built into a housing so that only an array sensor area of the organic photodetector array was exposed. In addition, the organic photodetector array was evaluated by connecting the external control circuit and a laptop computer for control via USB.

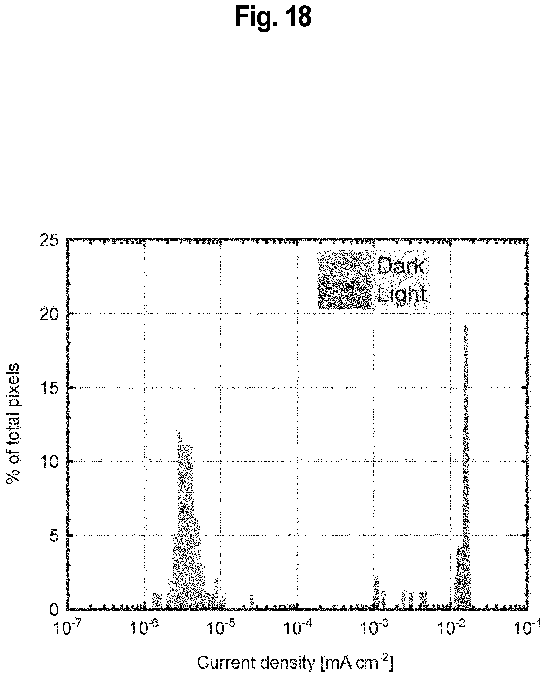

The dark current density ($J_{dark}$) for each pixel at an applied voltage of -2V was measured in a dark room. In addition, in the same dark room, the array sensor area of the organic photodetector array was irradiated with a surface light source with near-infrared light with a wavelength of 850 nm and a light intensity of 46 $\mu$W/cm$^2$, and the photocurrent density ($J_{photo}$) for each pixel at an applied voltage of -2 V was measured. Figure 18 shows a histogram of dark current density and photocurrent density of the organic photodetector array. The mode values of dark current density and photocurrent density were calculated from this histogram. The results are shown in Table 3.

In addition, the external quantum efficiency (EQE) was calculated from the mode value of the obtained photocurrent density. The results are shown in Table 3.

Table 3 shows that the organic photodetector array also had electrical properties equivalent to those of the organic photodetector element of Example B1. This shows that the organic photodetector array of the present invention can be expanded in area and mass-produced industrially.

<<Configuration and evaluation of touchless user interface device>>

[Configuration of touchless user interface device]

The organic photodetector array housed within the housing was placed on the display of the above-described laptop computer for control.

In addition, as an optical input signal, a laser pointer was used that can emit continuous pulse optical signals of three rectangular waves with a wavelength of 850 nm and frequencies of 1202 Hz, 962 Hz, and 801 **Hz.** The laser pointer includes two buttons, call button A and call button B, and the frequency can be changed by operating these buttons. Specifically, the operation is as follows.

- If neither call button is pressed: 1202 Hz rectangular wave continuous pulse optical signal
- If call button A is pressed: 962 Hz rectangular wave continuous pulse optical signal
- If call button B is pressed: 801 Hz rectangular wave continuous pulse optical signal

Note that the light intensity at the laser pointer emission surface was approximately 18 mW/cm$^2$ in all the frequencies.

[Signal processing of photodetection signal]

The light detection signal of the organic photodetector array was caused to pass through digital bandpass filters corresponding to each of the three frequencies described above. Thereby, only the signal of detecting an optical input signal was extracted from all the light detection signals including signals generated by detecting disturbances such as natural light or indoor light, and light emitted from the display body such as the display. At the same time, signal processing is performed in which only the largest photodetection signal was selected from among the three frequencies described above and was extracted as a signal to be used in the detection position identifying device to be described later.

Furthermore, the obtained detection signal was fitted with a Gaussian function for each of the X-axis direction and the Y-axis direction, and from the peak positions, the signal centroid position in the X-axis direction and the signal centroid position in the Y-axis direction were calculated. Using these signal centroid positions, detection position identifying device was used that identifies the detection position.

[Screen operation using touchless user interface device]

Software was implemented that allows mouse movement, up/down/left/right scrolling, and zooming in/out on a map of a map operation application (Google Earth, made by Google) by means to be described later using the identified detection position.

Mouse movement on the map was controlled using the detection position of a light detection signal responding to a continuous pulse optical signal of 1202 Hz rectangular wave.

Scrolling of the map was controlled by: detecting a light detection signal responding to a continuous pulse optical input signal of 962 Hz rectangular wave emitted by pressing the call button A; and using the displacement of the detected position.

Zooming in/out of the map was controlled by: detecting a light detection signal responding to a continuous pulse optical input signal of 801 Hz rectangular wave emitted by pressing the call button B; and detecting the decrease (increase) in the spot diameter at the light detection position when the distance between the laser pointer and the organic photodetector array is shortened (lengthened).

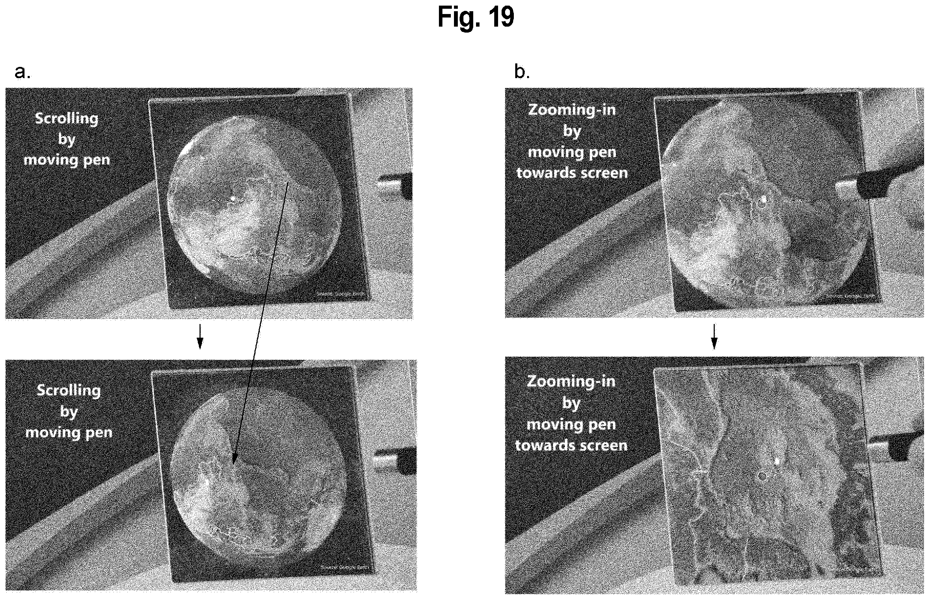

Figure 19a. are photographs showing a state in which a map of a map operation application is scrolled left and right using the touchless user interface device of the present invention. Figure 19b. are photographs showing a state in which a map of a map operation application is zoomed in using the touchless user interface device of the present invention.

In addition, as another configuration, a touchless user interface device was constructed in which: a surface light source of a continuous pulse signal of a rectangular wave having a wavelength of 850 nm and a frequency of 1202 Hz is formed by using a plurality of near-infrared LED light sources installed so as to surround the array sensor area; and the reflected light generated by touching the surface light source with a finger serving as pointing device is used as an optical input signal. The surface light source was adjusted so that it was projected onto a parallel plane spaced apart from the organic photodetector array.

The optical input signal was detected by the organic photodetector array, and the detection position was identified by the same operation as in the above-described [Signal processing of photodetection signal]. Software control was implemented that allows selection of buttons displayed on the display using this detected position.

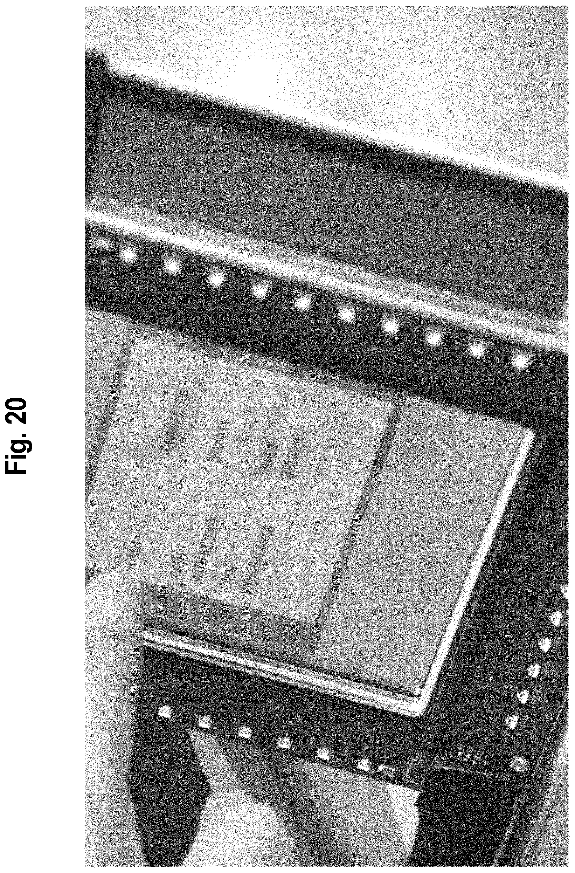

Figure 20 is a photograph of touching a near-infrared surface light source formed in a space using the touchless user interface device of the present invention, thereby operating a button on a screen imitating an ATM on the display.

Figures 19 and 20 show that the organic photodetector array, which has two or more arrayed organic photodetector elements using a metal grid transparent electrode according to the present invention that simultaneously exhibits both high visible light transmittance and high external quantum efficiency, can detect optical input signals without impairing the visibility of a display body such as a display, and can be suitably used as a touchless user interface device.

[Second embodiment]

Hereinafter, a different embodiment of the present invention will be described. However, components that, those skilled in the art understand, exhibit the same or similar functions as those of the other embodiment will be given the same or similar names or denoted by the same or similar reference numerals and characters as appropriate, and the description will be omitted or simplified. Accordingly, the description will be mainly made on different portions.

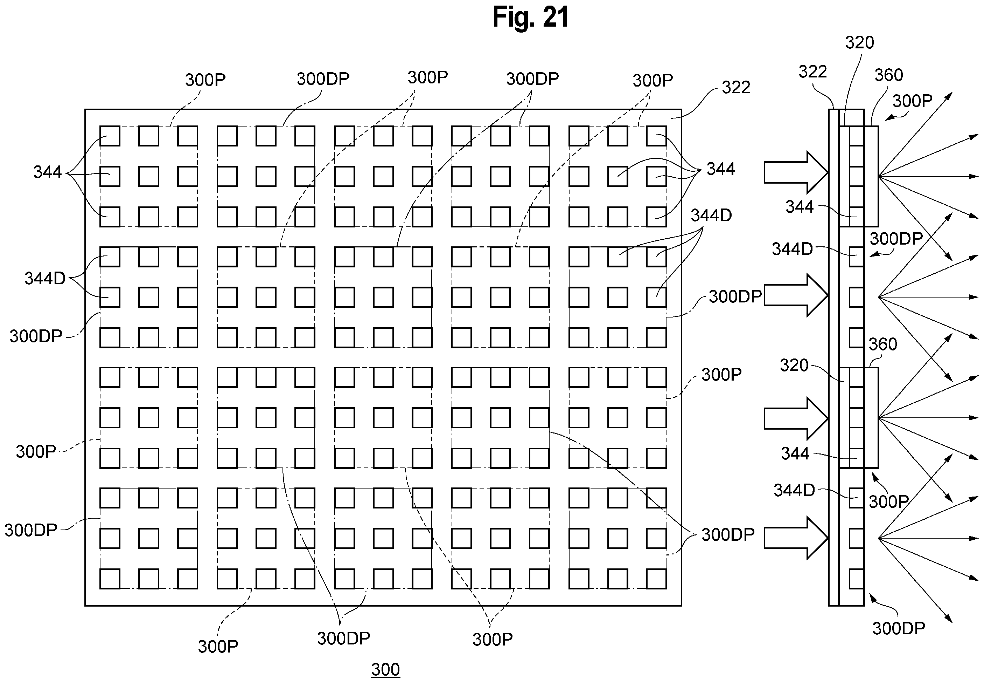

Figure 21 is a schematic diagram of an OPD array 300 seen from an upper surface to describe an array configuration of pixels 300P and dummy pixels 300DP of the OPD array 300 according to the present embodiment.

The OPD array 300 includes a transparent substrate 322 and a plurality of pixels 300P spaced apart from each other on the transparent substrate 322.

Each pixel 300P is configured to be able to detect incidence of light, and includes an OPD element. The OPD element includes a first transparent electrode 320 formed on the transparent substrate 322, a plurality of organic semiconductor layers 344 provided apart from each other on the first transparent electrode 320, and a second transparent electrode 360 formed on the plurality of organic semiconductor layers 344. According to such a configuration, electrons and holes are generated in the organic semiconductor layers 344 due to the incident light, and a photovoltaic power is generated between the first transparent electrode 320 and the second transparent electrode 360 to cause a current to flow. Therefore, the OPD element of each pixel 300P is configured to be able to detect incident light. The OPD element included in each pixel 300P of the OPD array 300 only needs to have a configuration capable of detecting incident light. For example, the OPD element may have a configuration that is the same as or similar to the OPD element 10, or it may have a different configuration.

The first transparent electrode 320 may employ a known configuration. For example, the first transparent electrode 320 may be the metal grid transparent electrode 20 or may be a transparent electrode having a different configuration.

The organic semiconductor layers (sometimes called "organic semiconductor films") 344 are provided on the same first transparent electrode 320 and spaced apart from each other. In the present embodiment, nine, that is three times three, organic semiconductor layers 344 are provided apart from each other on the same first transparent electrode 320. Providing a plurality of organic semiconductor layers apart from each other in this manner causes light to be able to pass between the adjacent organic semiconductor layers even if the organic semiconductor layers have low transparency. Therefore, even when the OPD array 300 is provided on the screen of a display or a display body, it is possible to prevent decrease in the visibility of the display or the display body.

Each organic semiconductor layer 344 may employ a known configuration. For example, the organic semiconductor layer 344 may have the same configuration as the organic photoactive layer 44, or may be formed into a flat film shape as shown in Figure 21, for example. Also, the organic semiconductor layer 344 may be formed from a material that can be used for the organic photoactive layer 44 shown in other embodiment, or may be formed from another material.

The second transparent electrode 360 is provided on a plurality of organic semiconductor layers 344 that are provided on the same first transparent electrode 320 and spaced apart from each other. The second transparent electrode 360 may have the same configuration as the transparent electrode 60, or may be formed into a flat film shape as shown in Figure 21, for example.

As shown in Figure 21, the plurality of pixels 300P are arranged in a checkered pattern. In other words, the pixels 300P are arranged apart from each other in a first direction (the left-right direction on the paper plane in the figure), and arranged apart from each other in a second direction (the up-down direction on the paper plane in the figure). At the same time, a pixel 300P is also arranged at a position corresponding to the intermediate position between adjacent pixels 300P in the first direction and the intermediate position between adjacent pixels 300P in the second direction.

Employing a configuration in which the pixels 300P are spaced apart from each other in this way makes it possible to increase detection resolution compared to a case in which pixels are also provided at intermediate positions between adjacent pixels 300P in the first direction and the second direction so that the pixels are densely packed. In other words, when pixels are densely packed, there is more likely to be a case in which a plurality of pixels detect incident light for the same optical input signal, which may actually decrease the detection resolution. Contrarily, in the case of a configuration in which the pixels 300P are spaced apart from each other, there is less likely to be a case in which a plurality of pixels detect incident light for the same optical input signal, which can prevent decrease in detection resolution.

The distance between adjacent pixels 300P may be, for example, the length of a single pixel 300P or more. For example, the distance between adjacent pixels 300P in the first direction may be longer than or equal to the length of the pixels 300P in the first direction. In addition, the distance between adjacent pixels 300P in the first direction may be equal to or less than twice the length of the pixels 300P in the first direction. Similarly, the distance between adjacent pixels 300P in the second direction perpendicular to the first direction may be longer than or equal to the length of the pixels 300P in the second direction. In addition, the distance between adjacent pixels 300P in the second direction may be equal to or less than twice the length of the pixels 300P in the second direction.

The plurality of pixels 300P of the present embodiment are arranged in a checkered pattern. The pixels 300P being evenly arranged in this way allows the incident light to be less likely to be detected by none of the pixels.

The dummy pixels 300DP are provided between adjacent pixels 300P on the transparent substrate 322. Here, the dummy pixel 300DP refers to a region provided with organic semiconductor layers 344D that are insulated and therefore do not have a function of detecting incident light.

Each dummy pixel 300DP has a plurality of organic semiconductor layers 344D provided on the transparent substrate 322 so as to be spaced apart from each other and insulated. In the present embodiment, nine, that is three times three, organic semiconductor layers 344D are provided apart from each other on the transparent substrate 322. Here, as shown in the same figure, the organic semiconductor layers 344D of each dummy pixel 300DP are not electrically connected to at least one of the first transparent electrode 320 and the second transparent electrode 360. Therefore, the organic semiconductor layer 344D has no current to flow therethrough and detects no incident light.

Here, on the organic semiconductor layers 344D, an insulating film (not shown) may be formed, or a second transparent electrode 360 may be formed.

However, the dummy pixels 300DP are not limited to the configuration shown in the present embodiment. For example, each dummy pixel 300DP may have the same structure as the pixel 300P except for being provided with no wire connecting the current collecting section 110 and the dummy pixel 300DP, thereby being insulated. According to such a configuration, it is possible to standardize at least part of the manufacturing processes for the pixel 300P and the dummy pixel 300DP. Also in the configuration shown in Figure 21, it is possible to provide the organic semiconductor layer 344 and the organic semiconductor layer 344D using the same material at the same height from the surface of the transparent substrate 322, thereby standardizing at least part of the film formation processes for the organic semiconductor layer 344 and the organic semiconductor layer 344D.

Note that the number, size, and shape of the organic semiconductor layers 344D included in each pixel 300P and each dummy pixel 300DP may be different. For example, the number of organic semiconductor layers 344 included in the pixel 300P may be four, that is, two times two, two being in the first direction and two being in the second direction, while the number of the organic semiconductor layers 344D included in the dummy pixel 300DP may be two, that is two times one, two being in the first direction and one being in the second direction.

As shown in Figure 21, the plurality of dummy pixels 300DP are arranged in a checkered pattern. In other words, the pixels 300P and the dummy pixels 300DP are arrayed alternately in the first direction (the left-right direction on the paper plane in the figure) and alternately arrayed in the second direction (the up-down direction on the paper plane the figure). However, the sizes of a pixel 300P and a dummy pixel 300DP may be different. For example, the width of the pixel 300P in the first direction may be twice or more the width of the dummy pixel 300D in the first direction.

According to the OPD array 300 having the above configuration, the dummy pixels 300DP are provided between the adjacent pixels 300P. This can prevent the occurrence of interference fringes caused by the OPD elements of the pixels 300P being arranged apart from each other. This can prevent the occurrence of visible interference fringes due to superposition of interference fringes caused by the OPD elements and interference fringes caused by the organic semiconductor layers 344 formed apart from each other.

Therefore, when the OPD array 300 is provided on the screen of a display or a display body as described using Figure 9 etc., it is possible to prevent interference fringes caused by light emitted from a display or a display body, and improve the visibility of the display or the display body.

Industrial Applicability

The organic photodetector element using the metal grid transparent electrode that can achieve both high visible light transmittance and high external quantum efficiency according to the present embodiment can detect optical input signals without impeding the visibility of display body such as a display, can be suitably used for a touchless user interface device, and has industrial applicability.

As described above, the organic photodetector element using the metal grid transparent electrode according to the present embodiment is provided with a subpixel 44S consisting of at least one organic photoactive layer 44 in the organic photodetector element. The subpixel 44S includes a sub-sensor area 44SS at least in part. In a projection view of this organic photodetector element projected from an upper surface, the region provided with the sub-sensor area 44SS is provided so as to overlap the region provided with the metal wire 24, at least in part. Such a configuration allows realizing a configuration in which electrons generated in the organic photoactive layer 44 are easily transported to the nearby metal wire 24 via the electron transport layer 42, and allows improving external quantum efficiency. In addition, such a configuration allows increasing the area rate of the region with a relatively high visible light transmittance (region excluding the subpixel 44S) even when a near-infrared detection type material with low visible light transmittance is used as the organic photoactive layer 44. This allows improving the visible light transmittance of the organic photodetector element and the organic photodetector array as a whole. Furthermore, the area of the sub-sensor area 44SS is designed to be equal to or larger than the unit cell area of the conductive pattern 24P of the metal grid transparent electrode 20. Thereby, even if the relative positions of the sub-sensor area 44SS and the conductive pattern 24P change in manufacturing (lamination process), the region provided with the sub-sensor area 44SS is allowed to overlap the region provided with the metal wires 24, at least in part. This allows the organic photodetector element of the present invention to exhibit high light detectivity due to high external quantum efficiency and extremely low dark current density while exhibiting high visible light transmittance.

Furthermore, the metal wire 24 of the metal grid transparent electrode 20 may be manufactured by a printing method. Forming the metal wire 24 by a printing method allows easily providing the metal wire 24 having a thickness of 30 nm or more. In addition, this makes it possible to easily change the gap between metal wires, line width, etc. The inventors of the present application have focused on the following: a too small gap between the metal wires decreases the efficiency of taking light into the organic photoactive layer 44 due to light blocking by the metal wires 24; while a too large gap therebetween increases the diffusion distance of the electrons to the metal wire 24 in the aperture section in the in-plane direction in the electron transport layer 42, and actually decreases the charge collection efficiency $\eta_{cc}$. The inventors of the present application have then determined the range of the product of the gap and the aperture rate to increase the external quantum efficiency as described above.

The inventors of the present application also have found: an organic photodetector array in which two or more organic photodetector elements according to the present invention are arrayed, the elements being able to achieve both high visible light transmittance and high external quantum efficiency; and an optical input signal and a signal processing method suitable to this. In addition, the inventors have constructed a new configuration of touchless user interface device.

The present invention can be modified in various ways without departing from the gist thereof. For example, some components of an embodiment may be added to other embodiments within the ordinary creative ability of those skilled in the art. Also, some components in an embodiment can be replaced with corresponding components in other embodiments.

Regarding the above embodiments, the following supplementary notes are further disclosed.

(Supplementary note 1)

A photodetector element including:

a metal grid transparent electrode for a first electrode;
a transparent electrode for a second electrode, the transparent electrode facing the metal grid transparent electrode; and
at least one subpixel between the metal grid transparent electrode and the transparent electrode, the subpixel consisting of an organic semiconductor layer, wherein
the metal grid transparent electrode includes a transparent substrate and a conductive pattern having at least one metal wire provided on the transparent substrate,
the subpixel includes a sub-sensor area at least in part of the subpixel, and
when projected from an upper surface, a region provided with the sub-sensor area overlaps a region provided with the metal wire at least in part.

(Supplementary note 2)

The photodetector element according to supplementary note 1, wherein $S_{sub-sensor}/S_{TCE-unit}$ is 1 or more, where $S_{TCE-unit}$ is an area of a repeated unit of the conductive pattern and $S_{sub-sensor}$ is an area of the sub-sensor area.

(Supplementary note 3)

The photodetector element according to supplementary note 1 or 2, wherein
when being projected from an upper surface of the photodetector element, at least part of the sub-sensor area overlaps two or more of the metal wires extending in the same direction, the direction being at least one direction.

(Supplementary note 4)

The photodetector element according to any one of supplementary notes 1 to 3, wherein

an insulating layer having an aperture section is provided between the metal grid transparent electrode and the transparent electrode,
the subpixel is arranged so as to cover the aperture section when projected onto a surface from an upper surface in a laminating direction, and
the sub-sensor area corresponds to a region where the subpixel and the aperture section overlap when projected onto a surface from an upper surface in a laminating direction.

(Supplementary note 5)

The photodetector element according to any one of supplementary notes 1 to 4, wherein
when projected from an upper surface, shapes of regions provided with subpixels include at least one or more shapes selected from a group consisting of a square, a rectangle, a substantially square, and a substantially rectangle.

(Supplementary note 6)

The photodetector element according to any one of supplementary notes 1 to 5,
the photodetector element further including a subpixel array, the subpixel array consisting of the subpixels provided apart from each other.

(Supplementary note 7)

The photodetector element according to supplementary note 6, wherein the subpixel array has a pattern in which the subpixels are two-dimensionally arrayed at equal intervals along two orthogonal coordinate axes on a parallel plane to the subpixel array.

(Supplementary note 8)

The photodetector element according to any one of supplementary notes 1 to 7, wherein $S_{subOPD}$ is 25 $\mu m^2$ or more and 10000 $\mu m^2$ or less, where $S_{subOPD}$ is an area of the subpixel.

(Supplementary note 9)

The photodetector element according to any one of supplementary notes 1 to 8, wherein the photodetector element has:

an external quantum efficiency of 15% or more in at least some wavelengths in a near-infrared wavelength region of 780 nm to 1200 nm; and
a visible light transmittance of 50% or less in a laminating direction of the photodetector element in a region including the sub-sensor area.

(Supplementary note 10)

The photodetector element according to any one of supplementary notes 1 to 9, wherein

$t_{TCE}$ is 30 nm or more and 200 nm or less, and
($t_{OPD}$ - $t_{TCE}$) is 50 nm or more and 500 nm or less,
where $t_{TCE}$ is a thickness of the metal wire and $t_{OPD}$ is a film thickness of the sub-sensor area.

(Supplementary note 11)

The photodetector element according to any one of supplementary notes 1 to 10, wherein

$W_{TCE}$ is 0.25 $\mu$m or more and 5.0 $\mu$m or less,
$G_{TCE}$ is 45 $\mu$m or less, and
($G_{TCE}$/$W_{TCE}$) is 1.0 or more,
where $W_{TCE}$ is a line width of each metal wire of the metal grid transparent electrode, and $G_{TCE}$ is a gap between adjacent metal wires extending in the same direction.

(Supplementary note 12)

The photodetector element according to supplementary note 11, wherein
($G_{TCE} \cdot A_{TCE}$) is 0.25 $\mu$m·% or more and 45 $\mu$m·% or less,
where $A_{TCE}$ is an aperture rate of the conductive pattern.

(Supplementary note 13)

The photodetector element according to supplementary note 12, wherein an aperture rate $A_{TCE}$ of the conductive pattern is 25% or more and less than 100%.

(Supplementary note 14)

The photodetector element according to any one of supplementary notes 1 to 13, wherein the organic semiconductor layer is an organic semiconductor layer configured to be capable of photoelectric conversion.

(Supplementary note 15)

The photodetector element according to supplementary note 14, wherein
the organic semiconductor layer includes a bulk heterojunction structure at least having an organic donor material having an $E_g^{opt}$ of 1.65 eV or less and an organic acceptor material having an $E_g^{opt}$ of 1.65 eV or less,
where $E_g^{opt}$ is an optical band gap.

(Supplementary note 16)

The photodetector element according to supplementary note 15, wherein the organic acceptor material is at least one selected from a group of non-fullerene acceptor materials consisting of IEICO-4F, IEICO-4Cl, IEICO, DTPC-DFIC, DCI-2, COTIC-4F, PDTTIC-4F, DTPC-IC, 6TIC-4F, COi8DFIC, FOIC, F8IC, F10IC, SiOTIC-4F, and P3.

(Supplementary note 17)

The photodetector element according to supplementary note 15 or 16, wherein the organic donor material is at least one selected from a group consisting of PTB7-Th (alias: PCE-10), PDTP-DFBT, PDPP3T, PDPP3T-O14, PDPP3T-016, PDPP3T-O20, PDPP3T-C20, PDPP4T, DPPTfQxT, DPPTQxT, DPPBTQxBT, DPPBTffQxBT, FLP030, PBDTT-SeDPP, PBDTT-DPP, PBDTT-FDPP, PDPP2T-TT (PTT-DTDPP), PCDTBT, PCPDTBT, PCPDTFBT, and Si-PCPDTBT.

(Supplementary note 18)

The photodetector element according to any one of supplementary notes 1 to 17, wherein the metal wire includes a metal and an oxide of the metal.

(Supplementary note 19)

The photodetector element according to any one of supplementary notes 1 to 18, wherein the conductive pattern includes a mesh pattern.

(Supplementary note 20)

A photodetector array including two or more arrayed pixels each consisting of a photodetector element according to any one of supplementary notes 1 to 19.

(Supplementary note 21)

The photodetector array according to supplementary note 20, further including a wiring section having a second conductive pattern that is provided on the transparent substrate and is electrically connected to the conductive pattern, the wiring section being provided for each pixel,
wherein $-10\% \leq (A_{wire} - A_{TCE}) \leq 10\%$,
where $A_{TCE}$ is an aperture rate of the conductive pattern, and $A_{wire}$ is an aperture rate of the second conductive pattern.

(Supplementary note 22)

The photodetector array according to supplementary note 21, further including a current collecting section having a third conductive pattern that is provided on the transparent substrate and is electrically connected to the second conductive pattern,
wherein $\Gamma_{pad}$ is 50% or more and less than 100%,
where $\Gamma_{pad}$ is an occupation area rate of the third conductive pattern per unit area.

(Supplementary note 23)

The photodetector array according to any one of supplementary notes 20 to 22, further including a dummy pattern that is provided on the transparent substrate and is electrically insulated from the conductive pattern.

(Supplementary note 24)

The photodetector array according to supplementary note 23, wherein

$$-10\% \leq (A_{dummy} - A_{TCE}) \leq 10\%,$$

where $A_{TCE}$ is an aperture rate of the conductive pattern, and $A_{dummy}$ is an aperture rate of the dummy pattern.

(Supplementary note 25)

The photodetector array according to any one of supplementary notes 20 to 24, further including:

a dummy subpixel array including a plurality of dummy subpixels each consisting of an insulating layer and an organic semiconductor layer, the insulating layer being provided on the metal grid transparent electrode, the organic semiconductor layer being provided on the insulating layer; and
a subpixel array including a plurality of the subpixels,
wherein the dummy subpixel array and the subpixel array, projected from an upper surface, have the same pattern structure.

(Supplementary note 26)

The photodetector array according to any one of supplementary notes 20 to 25, wherein a pixel size of the photodetector array is 1 mm$^2$ or more and 25 mm$^2$ or less.

(Supplementary note 27)

The photodetector array according to any one of supplementary notes 20 to 26, wherein a pixel density of the photodetector array is 2 ppi or more and 15 ppi or less.

(Supplementary note 28)

The photodetector array according to any one of supplementary notes 20 to 27, further including a pattern in which the pixels are two-dimensionally arrayed at equal intervals along two orthogonal coordinate axes on a parallel plane to the photodetector array.

(Supplementary note 29)

A touchless user interface device, including a photodetector array according to any one of supplementary notes 20 to 28 for being arranged on a screen of a display or a display body,

the device using the photodetector elements of the photodetector array to convert an optical input signal radiated to the photodetector array into an electrical output signal, thereby performing position detection, the position detection detecting a position irradiated with the optical input signal,
the device being configured to enable input operation to a screen of the display or the display body based on the position detection.

(Supplementary note 30)

The touchless user interface device according to supplementary note 29, wherein the optical input signal includes light having at least some wavelengths in a near-infrared wavelength region of 780 nm to 1200 **nm.**

(Supplementary note 31)

The touchless user interface device according to supplementary note 29 or 30, wherein the optical input signal is frequency-modulated, and the modulated frequency is 0.5 kHz or more and 20 kHz or less.

(Supplementary note 32)

The touchless user interface device according to any one of supplementary notes 29 to 31, wherein the optical input signal is an optical signal emitted from a laser pointer.

(Supplementary note 33)

The touchless user interface device according to any one of supplementary notes 29 to 31, wherein the optical input signal is a reflected light from pointing device.

(Supplementary note 34)

The touchless user interface device according to supplementary note 33, wherein the optical input signal is a reflected light from the pointing device, the reflected light being generated by the pointing device coming into contact with a planar projection light beam formed in a space.

(Supplementary note 35)

A photodetector array including:

a transparent substrate;
a plurality of pixels provided apart from each other on the transparent substrate, each pixel having a photodetector element; and
a plurality of dummy pixels that are provided apart from each other on the transparent substrate and are provided between two of the pixels, each dummy pixel being insulated,
wherein each photodetector element includes a first transparent electrode formed on the transparent substrate, a plurality of organic semiconductor layers provided apart from each other on the first transparent electrode; and a second transparent electrode formed on the plurality of organic semiconductor layers, and

each dummy pixel includes a plurality of organic semiconductor layers provided apart from each other on the transparent substrate.

(Supplementary note 36)

The photodetector array according to supplementary note 35, wherein
the plurality of pixels and the plurality of dummy pixels

are arrayed alternately in a first direction, and
are arrayed alternately in a second direction orthogonal to the first direction.

(Supplementary note 37)

The photodetector array according to supplementary note 35 or 36, wherein the plurality of organic semiconductor layers included in each pixel and the plurality of organic semiconductor layers included in each dummy pixel are made of the same material and are provided at the same height with respect to a surface of the transparent substrate.

(Supplementary note 38)

The photodetector array according to any one of supplementary note 35 to 37, wherein the first transparent electrode includes a metal grid transparent electrode including a conductive pattern having metal wires provided on the transparent substrate.

Reference Signs List

10 organic photodetector element (OPD element)
20 metal grid transparent electrode
22 transparent substrate
24 metal wire
24P conductive pattern
42 electron transport layer
44 organic photoactive layer
44S subpixel
44SS sub-sensor area
44SA alignment area
44SC connecting section
46 hole transport layer
60 transparent electrode
80 insulating layer
100 organic photodetector array (OPD array)
110 current collecting section
120 wiring section
130 dummy pattern section
200 touchless user interface device (UI device)
OP aperture section
D display
IL incident light (optical input signal)
PD pointing device
LS light source (point light source)
LS2 planar projection light beam (surface light source)

**Claims**

1. A photodetector element comprising:

   a metal grid transparent electrode for a first electrode;
   a transparent electrode for a second electrode, the transparent electrode facing the metal grid transparent electrode; and
   at least one subpixel between the metal grid transparent electrode and the transparent electrode, the subpixel consisting of an organic semiconductor layer, wherein
   the metal grid transparent electrode includes a transparent substrate and a conductive pattern having at least one metal wire provided on the transparent substrate,
   the subpixel includes a sub-sensor area at least in part of the subpixel, and
   when projected from an upper surface, a region provided with the sub-sensor area overlaps a region provided with the metal wire at least in part.

2. The photodetector element according to claim 1, wherein $S_{sub\text{-}sensor}/S_{TCE\text{-}unit}$ is 1 or more, where $S_{TCE\text{-}unit}$ is an area of a repeated unit of the conductive pattern and $S_{sub\text{-}sensor}$ is an area of the sub-sensor area.

3. The photodetector element according to claim 1, wherein
   when being projected from an upper surface of the photodetector element, at least part of the sub-sensor area overlaps two or more of the metal wires extending in the same direction, the direction being at least one direction.

4. The photodetector element according to claim 1, wherein

   an insulating layer having an aperture section is provided between the metal grid transparent electrode and the transparent electrode,
   the subpixel is arranged so as to cover the aperture section when projected onto a surface from an upper surface in a laminating direction, and
   the sub-sensor area corresponds to a region where the subpixel and the aperture section overlap when projected onto a surface from an upper surface in a laminating direction.

5. The photodetector element according to claim 1, wherein
   when projected from an upper surface, shapes of regions provided with subpixels include at least one or more shape selected from a group consisting of a square, a rectangle, a substantially square, and a substantially rectangle.

6. The photodetector element according to claim 1,
   the photodetector element further comprising a subpixel array, the subpixel array consisting of the subpixels provided apart from each other.

7. The photodetector element according to claim 6, wherein the subpixel array has a pattern in which the subpixels are two-dimensionally arrayed at equal intervals along two orthogonal coordinate axes on a parallel plane to the subpixel array.

8. The photodetector element according to claim 1, wherein $S_{subOPD}$ is 25 $\mu m^2$ or more and 10000 $\mu m^2$ or less, where $S_{subOPD}$ is an area of the subpixel.

9. The photodetector element according to claim 1, wherein the photodetector element has:

   an external quantum efficiency of 15% or more in at least some wavelengths in a near-infrared wavelength region of 780 nm to 1200 nm; and
   a visible light transmittance of 50% or less in a laminating direction of the photodetector element in a region including the sub-sensor area.

10. The photodetector element according to claim 1, wherein

    $t_{TCE}$ is 30 nm or more and 200 nm or less, and
    $(T_{OPD} - t_{TCE})$ is 50 nm or more and 500 nm or less,
    where $t_{TCE}$ is a thickness of the metal wire and $t_{OPD}$ is a film thickness of the sub-sensor area.

**11.** The photodetector element according to claim 1, wherein

$W_{TCE}$ is 0.25 $\mu$m or more and 5.0 $\mu$m or less,
$G_{TCE}$ is 45 $\mu$m or less, and
$(G_{TCE}/W_{TCE})$ is 1.0 or more,
where $W_{TCE}$ is a line width of each metal wire of the metal grid transparent electrode, and $G_{TCE}$ is a gap between adjacent metal wires extending in the same direction.

**12.** The photodetector element according to claim 11, wherein
$(G_{TCE} \cdot A_{TCE})$ is 0.25 $\mu$m·% or more and 45 $\mu$m·% or less,
where $A_{TCE}$ is an aperture rate of the conductive pattern.

**13.** The photodetector element according to claim 12, wherein an aperture rate $A_{TCE}$ of the conductive pattern is 25% or more and less than 100%.

**14.** The photodetector element according to claim 1, wherein the organic semiconductor layer is an organic semiconductor layer configured to be capable of photoelectric conversion.

**15.** The photodetector element according to claim 14, wherein
the organic semiconductor layer includes a bulk heterojunction structure at least having an organic donor material having an $E_g^{opt}$ of 1.65 eV or less and an organic acceptor material having an $E_g^{opt}$ of 1.65 eV or less,
where $E_g^{opt}$ is an optical band gap.

**16.** The photodetector element according to claim 15, wherein the organic acceptor material is at least one selected from a group of non-fullerene acceptor materials consisting of IEICO-4F, IEICO-4Cl, IEICO, DTPC-DFIC, DCI-2, COTIC-4F, PDTTIC-4F, DTPC-IC, 6TIC-4F, COi8DFIC, FOIC, F8IC, F10IC, SiOTIC-4F, and P3.

**17.** The photodetector element according to claim 15 or 16, wherein the organic donor material is at least one selected from a group consisting of PTB7-Th (alias: PCE-10), PDTP-DFBT, PDPP3T, PDPP3T-O14, PDPP3T-O16, PDPP3TO20, PDPP3T-C20, PDPP4T, DPPTfQxT, DPPTQxT, DPPBTQxBT, DPPBTffQxBT, FLP030, PBDTT-SeDPP, PBDTT-DPP, PBDTT-FDPP, PDPP2T-TT (PTT-DTDPP), PCDTBT, PCPDTBT, PCPDTFBT, and Si-PCPDTBT.

**18.** The photodetector element according to claim 1, wherein the metal wire includes a metal and an oxide of the metal.

**19.** The photodetector element according to claim 1, wherein the conductive pattern includes a mesh pattern.

**20.** A photodetector array comprising two or more arrayed pixels each consisting of a photodetector element according to claim **1.**

**21.** The photodetector array according to claim 20, further comprising a wiring section having a second conductive pattern that is provided on the transparent substrate and is electrically connected to the conductive pattern, the wiring section being provided for each pixel,
wherein -10% $\leq (A_{wire} - A_{TCE}) \leq$ 10%,
where $A_{TCE}$ is an aperture rate of the conductive pattern, and $A_{wire}$ is an aperture rate of the second conductive pattern.

**22.** The photodetector array according to claim 21, further comprising a current collecting section having a third conductive pattern that is provided on the transparent substrate and is electrically connected to the second conductive pattern,
wherein $\Gamma_{pad}$ is 50% or more and less than 100%,
where $\Gamma_{pad}$ is an occupation area rate of the third conductive pattern per unit area.

**23.** The photodetector array according to claim 20, further comprising a dummy pattern that is provided on the transparent substrate and is electrically insulated from the conductive pattern.

**24.** The photodetector array according to claim 23, wherein

$$-10\% \leq (A_{dummy} - A_{TCE}) \leq 10\%,$$

where $A_{TCE}$ is an aperture rate of the conductive pattern, and $A_{dummy}$ is an aperture rate of the dummy pattern.

25. The photodetector array according to claim 20, further comprising:

a dummy subpixel array including a plurality of dummy subpixels each consisting of an insulating layer and an organic semiconductor layer, the insulating layer being provided on the metal grid transparent electrode, the organic semiconductor layer being provided on the insulating layer; and
a subpixel array including a plurality of the subpixels,
wherein the dummy subpixel array and the subpixel array, projected from an upper surface, have the same pattern structure.

26. The photodetector array according to claim 20, wherein a pixel size of the photodetector array is 1 mm$^2$ or more and 25 mm$^2$ or less.

27. The photodetector array according to claim 20, wherein a pixel density of the photodetector array is 2 ppi or more and 15 ppi or less.

28. The photodetector array according to claim 20, further comprising a pattern in which the pixels are two-dimensionally arrayed at equal intervals along two orthogonal coordinate axes on a parallel plane to the photodetector array.

29. A touchless user interface device, comprising a photodetector array according to claim 20 for being arranged on a screen of a display or a display body,

the device using the photodetector elements of the photodetector array to convert an optical input signal radiated to the photodetector array into an electrical output signal, thereby performing position detection, the position detection detecting a position irradiated with the optical input signal,
the device being configured to enable input operation to a screen of the display or the display body based on the position detection.

30. The touchless user interface device according to claim 29, wherein the optical input signal includes light having at least some wavelengths in a near-infrared wavelength region of 780 nm to 1200 **nm.**

31. The touchless user interface device according to claim 29, wherein the optical input signal is frequency-modulated, and the modulated frequency is 0.5 kHz or more and 20 kHz or less.

32. The touchless user interface device according to claim 29, wherein the optical input signal is an optical signal emitted from a laser pointer.

33. The touchless user interface device according to claim 29, wherein the optical input signal is a reflected light from pointing device.

34. The touchless user interface device according to claim 33, wherein the optical input signal is a reflected light from the pointing device, the reflected light being generated by the pointing device coming into contact with a planar projection light beam formed in a space.

Fig. 1

# Fig. 2

Pitch

$W_{TCE}$

22

22

$G_{TCE}$

24

24

$S_{TCE\text{-}unit}$

Unit cell(Repeated Unit)

20

## Fig. 3

(A)

(B)

(C)

(D)

(E)

EP 4 518 620 A1

# Fig. 4

# Fig. 5

# Fig. 6

# Fig. 7

(A)   (B)

Fig. 8

(A)

44SD
60
46
80
24
42
22

130

(B)

22
44SD
24
24

130

**Fig. 9**

(A)

200

(B)

200

# Fig. 10

100 ┌─────────────────┐          ┌─────────────────┐  D
     │                 │          │                 │
     │     Organic     │          │                 │
     │  photodetector  │          │     Display     │
     │      array      │          │                 │
     │                 │          │                 │
     └────────┬────────┘          └────────┬────────┘
210 ┌─────────┴─────────┐          ┌────────┴────────────────┐  P
    │ Position detection section ├──┤ Video generation section │
    └──────────────────┘          └─────────────────────────┘

200

# Fig. 11

# Fig. 12

Fig. 13

# Fig. 14

# Fig. 15

# Fig. 16

# Fig. 17

# Fig. 18

Fig. 19

Fig. 20

Fig. 21

## INTERNATIONAL SEARCH REPORT

| | International application No. |
|---|---|
| | **PCT/JP2023/016350** |

| A. | CLASSIFICATION OF SUBJECT MATTER |
|---|---|

*H10K 30/60*(2023.01)i; *G06F 3/041*(2006.01)i; *G06F 3/042*(2006.01)i; *H01L 27/146*(2006.01)i; *H10K 30/30*(2023.01)i;
*H10K 30/83*(2023.01)i; *H10K 39/30*(2023.01)i
FI:   H10K30/60; G06F3/041 412; G06F3/041 580; G06F3/042 471; H01L27/146 C; H10K30/30; H10K30/83; H10K39/30

According to International Patent Classification (IPC) or to both national classification and IPC

| B. | FIELDS SEARCHED |
|---|---|

Minimum documentation searched (classification system followed by classification symbols)

H10K30/00-30/89; H10K39/30-39/38; H01L27/14-27/148; G06F3/042; G06V40/13

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2012-247910 A (SONY CORP.) 13 December 2012 (2012-12-13) paragraphs [0018]-[0030], [0087]-[0091], fig. 1-5, 22, 24 | 1-3, 5, 8-20, 23, 25-34 |
| A | | 4, 6-7, 21-22, 24 |
| Y | JP 2012-142500 A (LINTEC CORP.) 26 July 2012 (2012-07-26) paragraphs [0010]-[0013], [0018], fig. 1, 2 | 1-20, 23, 25-34 |
| Y | JP 2013-524536 A (MERCK PATENT GMBH) 17 June 2013 (2013-06-17) paragraphs [0021]-[0024], [0074], [0090], fig. 1 | 1-20, 23, 25-34 |
| Y | JP 2008-288067 A (FUJIFILM CORP.) 27 November 2008 (2008-11-27) paragraphs [0018]-[0025], [0038]-[0040], [0097], fig. 1 | 1-20, 23, 25-34 |
| Y | JP 2022-35072 A (MITSUBISHI CHEMICAL CORP.) 04 March 2022 (2022-03-04) paragraph [0076] | 9 |
| Y | JP 2007-324248 A (SANYO ELECTRIC CO., LTD.) 13 December 2007 (2007-12-13) paragraphs [0016]-[0023], fig. 1, 2 | 23,25 |

☑ Further documents are listed in the continuation of Box C.   ☑ See patent family annex.

| | |
|---|---|
| \* | Special categories of cited documents: |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 June 2023** | **04 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
|---|
| **PCT/JP2023/016350** |

**C. DOCUMENTS CONSIDERED TO BE RELEVANT**

| Category* | Citation of document, with indication, where appropriate, of the relevant passages | Relevant to claim No. |
|---|---|---|
| Y | JP 2016-503529 A (ISORG) 04 February 2016 (2016-02-04)<br>paragraph [0069], fig. 4-8 | 31 |
| Y | JP 2011-159858 A (SONY CORP.) 18 August 2011 (2011-08-18)<br>paragraphs [0036]-[0132], fig. 2, 3, 14 | 1-20, 23, 25-34 |
| A | | 21-22, 24 |
| Y | JP 2020-150264 A (SAMSUNG ELECTRONICS CO., LTD.) 17 September 2020<br>(2020-09-17)<br>paragraphs [0019], [0020], [0065]-[0067], fig. 1-4, 7 | 9, 15-17 |
| Y | WO 2020/021399 A1 (SEMICONDUCTOR ENERGY LABORATORY CO., LTD.) 30<br>January 2020 (2020-01-30)<br>paragraphs [0024]-[0034], [0039], [0082]-[0099], fig. 1D, 4 | 29-34 |
| A | JP 2012-69803 A (FUJIFILM CORP.) 05 April 2012 (2012-04-05) | 1-34 |
| A | JP 2010-204995 A (EPSON IMAGING DEVICES CORP.) 16 September 2010 (2010-09-16) | 1-34 |

Form PCT/ISA/210 (second sheet) (January 2015)

## INTERNATIONAL SEARCH REPORT
### Information on patent family members

International application No.

**PCT/JP2023/016350**

| Patent document cited in search report | | | Publication date (day/month/year) | Patent family member(s) | | | Publication date (day/month/year) |
|---|---|---|---|---|---|---|---|
| JP | 2012-247910 | A | 13 December 2012 | US | 2012/0313867 | A1 | |
| | | | | paragraphs [0053]-[0067], [0197]-[0201], fig. 1-5, 22, 24A-24B | | | |
| | | | | EP | 2527905 | A1 | |
| | | | | CN | 102929439 | A | |
| JP | 2012-142500 | A | 26 July 2012 | CN | 102593194 | A | |
| | | | | KR | 10-2012-0079803 | A | |
| JP | 2013-524536 | A | 17 June 2013 | US | 2013/0032204 | A1 | |
| | | | | paragraphs [0031]-[0035], [0088], [0106], fig. 1 | | | |
| | | | | WO | 2011/127131 | A1 | |
| | | | | CN | 102986051 | A | |
| JP | 2008-288067 | A | 27 November 2008 | (Family: none) | | | |
| JP | 2022-35072 | A | 04 March 2022 | (Family: none) | | | |
| JP | 2007-324248 | A | 13 December 2007 | US | 2007/0279661 | A1 | |
| | | | | paragraphs [0020]-[0027], fig. 1, 2 | | | |
| JP | 2016-503529 | A | 04 February 2016 | US | 2015/0293661 | A1 | |
| | | | | paragraph [0077], fig. 4-8 | | | |
| | | | | WO | 2014/060693 | A1 | |
| JP | 2011-159858 | A | 18 August 2011 | US | 2011/0186952 | A1 | |
| | | | | paragraphs [0060]-[0156], fig. 2, 3, 14 | | | |
| | | | | CN | 102169884 | A | |
| | | | | KR | 10-2011-0090771 | A | |
| JP | 2020-150264 | A | 17 September 2020 | US | 2020/0296269 | A1 | |
| | | | | paragraphs [0062]-[0067], [0139]-[0144], fig. 1-4, 7 | | | |
| | | | | EP | 3709361 | A1 | |
| | | | | KR | 10-2020-0109551 | A | |
| | | | | CN | 111697013 | A | |
| WO | 2020/021399 | A1 | 30 January 2020 | US | 2021/0296409 | A1 | |
| | | | | paragraphs [0047]-[0057], [0062], [0105]-[0122], fig. 1D, 4 | | | |
| JP | 2012-69803 | A | 05 April 2012 | WO | 2012/039246 | A1 | |
| JP | 2010-204995 | A | 16 September 2010 | US | 2010/0225616 | A1 | |
| | | | | CN | 101825973 | A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **H. AKKERMAN et al.** Integration of large area optical imagers for biometric recognition and touch in displays. *J. Soc. Inf. Display.*, May 2021, 1-13
- **PETER VAN DE WEIJER et al.** High-performance thin-film encapsulation for organic light-emitting diodes. *Org. Electron.*, May 2017, vol. 44, 94-98
- **P. E. MALINOWSKI et al.** Organic photo-lithography for displays with integrated fingerprint scanner. *J. Soc. Inf. Display.*, 2019, vol. 50 (1), https://doi.org/10.1002/sdtp.13097
- **M. J. MENDENHALL** ; **A. S. NUNEZ** ; **R. K. MARTIN**. Human skin detection in the visible and near infrared. *Appl. Opt.*, 2015, vol. 54 (35), 10559-10570
- **J. XUE et al.** A Hybrid Planar-Mixed Molecular Heterojunction Photovoltaic Cell. *Advanced Materials*, January 2005, vol. 17, 66-71
- **BOPING YANG et al.** Inorganic top electron transport layer for high performance inverted perovskite solar cells. *EcoMat*, October 2021, vol. 3, e12127
- **LIANGYOU LIN et al.** Inorganic Electron Transport Materials in Perovskite Solar Cells. *Advanced Functional Materials*, January 2021, vol. 31, 2008300
- **KOBRA VALADI et al.** *Metal oxide electron transport materials for perovskite solar cells: a review*, 2021, vol. 19, 2185-2207
- **DONG MENG et al.** Near-infrared Materials: The Turning Point of Organic Photovoltaics. *Advanced Materials*, 2021
- **HAO-WEN CHENG et al.** Toward High-Performance Semitransparent Organic Photovoltaics with Narrow-Bandgap Donors and Non-Fullerene Acceptors. *Advance Energy Materials*, 2021, 2102908
- **YIWEN WANG et al.** Recent Progress and Challenges toward Highly Stable Nonfullerene Acceptor-Based Organic Solar Cells. *Advance Energy Materials*, 2021, vol. 11, 2003002

- **ANDREW WADSWORTH et al.** Critical review of the molecular design progress in non-fullerene electron acceptors towards commercially viable organic solar cells Alternative p-doped hole transport material for low operating voltage and high efficiency organic light-emitting diodes. *Chemical Society Reviews*, 2019, vol. 48, 1596-1625
- **CENQI YAN et al.** Non-fullerene acceptors for organic solar cells. *Nature Reviews Materials*, 2018, vol. 3, 18003
- **LEIPING DUAN et al.** *Progress in non-fullerene acceptor based organic solar cells, Solar Energy Materials and Solar Cells*, May 2019, vol. 193, 22-65
- **GUANGYE ZHANG et al.** Non-fullerene Acceptor Molecules for Bulk Heterojunction Organic Solar Cells. *Chemical Reviews*, 2018, vol. 118, 3447-3507
- **PEI CHENG et al.** Next-generation organic photovoltaics based on non-fullerene acceptors. *Nature Photonics*, 2018, vol. 12, 131-142
- **LICHUN CHANG et al.** Ternary organic solar cells based on non-fullerene acceptors: A review. *Organic Electronics*, March 2021, vol. 90, 106063
- **HUITING FU et al.** Advances in Non-Fullerene Acceptor Based Ternary Organic Solar Cells. *Solar RRL*, December 2017, vol. 2, 1700158
- **DONG MENG et al.** Near-infrared Materials: The Turning Point of Organic Photovoltaics. *Advanced Materials*, 2021, 2107330
- **J. XUE et al.** A Hybrid Planar-Mixed Molecular Heterojunction Photovoltaic Cell. *Advanced Materials.*, January 2005, vol. 17, 66-71
- **ARUMUGAM, GM et al.** Inorganic hole transport layers in inverted perovskite solar cells: A review. *Nano Select.*, June 2021, vol. 2, 1081-1116